(19) Europäisches Patentamt
European Patent Office
Office européen des brevets

(11) EP 4 372 066 B1

(12) **EUROPEAN PATENT SPECIFICATION**

(45) Date of publication and mention of the grant of the patent:
**29.10.2025 Bulletin 2025/44**

(21) Application number: **23210508.0**

(22) Date of filing: **17.11.2023**

(51) International Patent Classification (IPC):
***C09K 11/02*** *(2006.01)* ***C09K 11/62*** *(2006.01)*
***G02F 1/13357*** *(2006.01)*

(52) Cooperative Patent Classification (CPC):
**C09K 11/621; C09K 11/02; C09K 11/025;**
**G02F 1/133603; G02F 1/133614; G02F 1/133617;**
G02F 2202/36

(54) **INK COMPOSITION, PRODUCTION METHOD THEREOF, COMPOSITE PREPARED THEREFROM, AND ELECTRONIC DEVICE INCLUDING THE SAME**

TINTENZUSAMMENSETZUNG, HERSTELLUNGSVERFAHREN DAFÜR, DARAUS HERGESTELLTER VERBUNDSTOFF UND ELEKTRONISCHE VORRICHTUNG DAMIT

COMPOSITION D'ENCRE, SON PROCÉDÉ DE PRODUCTION, COMPOSITE PRÉPARÉ À PARTIR DE CELLE-CI ET DISPOSITIF ÉLECTRONIQUE COMPRENANT CELLE-CI

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **17.11.2022 KR 20220154923**

(43) Date of publication of application:
**22.05.2024 Bulletin 2024/21**

(73) Proprietor: **Samsung Electronics Co., Ltd.**
**Suwon-si, Gyeonggi-do 16677 (KR)**

(72) Inventors:
- **MOON, Deuk Kyu**
  **16678 Suwon-si (KR)**
- **PARK, Shang Hyeun**
  **16678 Suwon-si (KR)**
- **WON, Jong Hoon**
  **16678 Suwon-si (KR)**
- **KIM, Tae-Gon**
  **16678 Suwon-si (KR)**

(74) Representative: **Elkington and Fife LLP**
**Prospect House**
**8 Pembroke Road**
**Sevenoaks, Kent TN13 1XR (GB)**

(56) References cited:
**US-A1- 2021 403 809**

- **SHIRAISHI MOMO ET AL: "Transparent Nanocomposites Comprising Ligand-Exchanged CuInS 2 /ZnS Quantum Dots and UV-Cured Resin for Wavelength Converters", ACS OMEGA, vol. 7, no. 37, 20 September 2022 (2022-09-20), US, pages 33039 - 33045, XP093140065, ISSN: 2470-1343, DOI: 10.1021/acsomega.2c02922**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 372 066 B1

## Description

### FIELD OF THE INVENTION

An ink composition, a preparation process thereof, and a composite and an electronic device including the same are provided.

M. Shiraishi et al., "Transparent Nanocomposites Comprising Ligand-Exchanged CuInS2/ZnS Quantum Dots and UV-Cured Resin for Wavelength Converters", ACS Omega 2022, 7, 33039-33045, relates to core/shell $CuInS_2$/ZnS quantum dots.

### BACKGROUND OF THE INVENTION

A semiconductor nanoparticle may show, e.g., exhibit, different aspects, than a corresponding bulk material having substantially the same composition, for example, in terms of physical properties (e.g., an energy bandgap, a luminescent property, or the like) that are intrinsic in case of the bulk material. The semiconductor nanoparticle may be configured to emit light upon excitation by an energy such as an incident light or an applied voltage. Such a luminescent nanostructure may find applicability in a variety of devices (e.g., a display panel or an electronic device). From an environmental point of view, it is desirable to develop a luminescent nanoparticle not containing a harmful heavy metal, such as cadmium, and showing an improved luminescent property.

### SUMMARY OF THE INVENTION

An aspect relates to an ink composition including a semiconductor nanoparticle capable of exhibiting an improved property (e.g., an optical property such as an incident light absorption and/or a stability such as a process stability and/or chemical stability).

An aspect relates to a process for preparing the ink composition.

An aspect relates to a composite or a semiconductor nanoparticle-polymer composite (e.g., a solid-state composite, or a composite) prepared from the ink composition.

An aspect relates to a display panel or a color conversion panel including the composite.

An aspect relates to an electronic device (e.g., a display device) including the composite.

An aspect relates to the semiconductor nanoparticle included in the ink composition.

According to the invention, an ink composition is provided in accordance with claim 1.

The semiconductor nanoparticle may be configured to exhibit a quantum yield of greater than or equal to about 65%, greater than or equal to about 67%, or greater than or equal to about 70% to 100%, for example, in the ink composition or a composite prepared therefrom.

The semiconductor nanoparticle may include the first organic ligand linked to a surface of the semiconductor nanoparticle.

The ink composition or the semiconductor nanoparticle may further include a second organic ligand different from the first organic ligand. The second organic ligand may include a compound represented by $R_2S$-A, wherein $R_2$ is a second organic group and A is hydrogen or a portion bound or linked to a surface of the semiconductor nanoparticle.

A surface of the semiconductor nanoparticle may include gallium and zinc.

The semiconductor nanoparticle may have a charge balance value as defined by Equation 1 that is greater than or equal to about 0.8 and less than or equal to about 1.8, or less than or equal to about 1.5:

Equation 1

$$\text{charge balance value} = \{[Ag] + 3x([\text{Group 13 metal}])+2[Zn]\}/(2x[CHA])$$

wherein, in Equation 1,

[Ag], [Group 13 metal], [Zn], and [CHA] are molar amounts of the silver, the Group 13 metal, zinc, and the chalcogen element in the semiconductor nanoparticle, respectively.

The charge balance value may be greater than or equal to about 0.9, or greater than or equal to about 1. The charge balance value may be less than or equal to about 1.3, less than or equal to about 1.2, or less than or equal to about 1.1.

The Group 13 metal may further include aluminum.

The Group 16 element may further include selenium.

In the semiconductor nanoparticle, a mole ratio of zinc to sulfur (Zn:S) may be less than or equal to 0.8:1, less than or equal to about 0.3:1, less than or equal to about 0.25:1, or less than or equal to about 0.19:1. In the semiconductor

nanoparticle, a mole ratio of zinc to sulfur may be greater than or equal to 0.01:1, or greater than or equal to about 0.05:1.

In the semiconductor nanoparticle, a mole ratio of zinc to silver (Zn:Ag) may be greater than or equal to 0.3:1, or greater than or equal to about 0.5:1, and less than or equal to 5:1, less than or equal to about 3.5:1, or less than or equal to about 2:1.

In the semiconductor nanoparticle, a mole ratio of sulfur to a total sum of silver, indium, and gallium [S:(Ag+In+Ga)] may be greater than or equal to 1.3:1, or greater than or equal to 1.35:1 and less than or equal to about 2:1.

In the semiconductor nanoparticle, a mole ratio of a total sum of indium and gallium to silver [(In+Ga):Ag] may be greater than or equal to about 1.5:1, or greater than or equal to about 1.8:1, and less than or equal to about 7:1, or less than or equal to about 3.5:1.

In the semiconductor nanoparticle, a mole ratio of gallium to a sum of indium and gallium [Ga:(In+Ga)] may be less than or equal to about 0.99:1, or less than or equal to about 0.8:1. The mole ratio of gallium to a sum of indium and gallium [Ga:(In+Ga)] may be greater than or equal to about 0.65:1 or greater than or equal to about 0.7:1.

In the semiconductor nanoparticle, a mole ratio of gallium to sulfur may be less than or equal to about 0.5:1, or less than or equal to about 0.41:1. The mole ratio of gallium to sulfur may be greater than or equal to about 0.1:1, greater than or equal to about 0.3:1, or greater than or equal to about 0.35:1.

The semiconductor nanoparticle may not include lithium. The semiconductor nanoparticle may not include sodium. The semiconductor nanoparticle may not include an alkali metal.

The semiconductor nanoparticle may be configured to emit a first light. The semiconductor nanoparticle or the first light may have a full width at half maximum of greater than or equal to about 5 nm and less than or equal to about 70 nm. The semiconductor nanoparticle may exhibit a quantum yield of greater than or equal to about 50%.

The semiconductor nanoparticle or the first light may have a peak emission wavelength of greater than or equal to about 500 nm to less than or equal to about 650 nm. The first light may be a green light. The peak emission wavelength may be greater than or equal to about 505 nm to less than or equal to about 580 nm.

The semiconductor nanoparticle may exhibit a quantum yield (e.g., an absolute quantum yield, hereinafter, "quantum yield") of greater than or equal to about 60%. The quantum yield may be greater than or equal to about 62%, greater than or equal to about 65%, or greater than or equal to about 70%. The quantum yield may be about 80% to about 100%.

The full width at half maximum (FWHM) may be less than or equal to about 45 nm, less than or equal to about 40 nm, or less than or equal to about 35 nm. The full width at half maximum may be greater than or equal to about 5 nm, greater than or equal to about 10 nm, greater than or equal to about 15 nm, or greater than or equal to about 25 nm.

The first organic group may be a substituted or unsubstituted $C_{1-500}$, $C_{2-300}$, $C_{3-100}$, $C_{4-50}$, or $C_{5-10}$ hydrocarbon group and, optionally, for example, in a backbone thereof, at least one methylene may be replaced with -CO-, -O-, - COO-, -S-, -SO-, -NHCO-, or a combination thereof.

The second organic group may be a substituted or unsubstituted $C_{1-500}$, $C_{2-300}$, $C_{3-100}$, $C_{4-50}$, or $C_{5-10}$ hydrocarbon group and, optionally, for example in a backbone thereof, at least one methylene may be replaced with -CO-, -O-, - COO-, -S-, -SO-, -NHCO-, or a combination thereof.

The first organic group may include a carbon-carbon double bond-containing moiety. The carbon-carbon double bond-containing moiety may include a (meth)acrylate group. The second organic group may include an alkoxy carbonyl moiety.

The second organic ligand may not contain a piperidine moiety.

The second organic ligand may include or may not include an amine group.

The semiconductor nanoparticle may not include the second organic ligand. In an embodiment, the semiconductor nanoparticle may include the second organic ligand, and a mole ratio between the second organic ligand and the first organic ligand may be from about 1:1 to about 1:100, from about 1:2 to about 1:50, or a combination thereof.

The first organic ligand may be present in an amount greater than the second organic ligand.

The semiconductor nanoparticle may further include chlorine.

The first organic ligand may include a C3 to C500 (e.g., C4-C100, C4-C50, or C5-C12) carboxy alkyl (meth) acrylate. The first organic ligand may include a small molecular compound (e.g. a non-polymeric compound) that has a molecular weight of greater than or equal to about 10 g/mol, greater than or equal to about 50 g/mol, greater than or equal to about 120 g/mol, and less than or equal to about 800 g/mol, less than or equal to about 500 g/mol, less than or equal to about 400 g/mol, less than or equal to about 300 g/mol, or less than or equal to about 250 g/mol.

The second organic ligand may include a C3 to C500 (e.g., C4-C100, C4-C50, or C5-C12) carboxylic acid alkyl ester including a thiol group.

In the ink composition, an amount of the semiconductor nanoparticle may be greater than or equal to 15 wt%, or greater than or equal to about 20 wt%, based on a total weight of the ink composition. In the ink composition, an amount of the semiconductor nanoparticle may be less than or equal to 50% by weight based on a total weight of the ink composition.

In the ink composition, the monomer may include a compound represented by Chemical Formula 1:

Chemical Formula 1

$$L - \left[ Y-(X)_n \right]_k$$

in Chemical Formula 1, X is a C2 to C30 organic group having a carbon-carbon double bond,

L is a single bond, a carbon atom, a substituted or unsubstituted C1 to C50 alkylene group, a substituted or unsubstituted C2 to C50 alkenylene group, a substituted or unsubstituted C3 to C50 (e.g. C6-C30) cycloalkylene group, a substituted or unsubstituted C3 to C50 (e.g. C6-C30) cycloalkenylene group, a substituted or unsubstituted C6 to C50 arylene group, a substituted or unsubstituted C3 to C30 heteroarylene group, a group having at least one oxyalkylene unit [e.g., (R-O)n where R is a substituted or unsubstituted C1 to C10 alkylene such as methylene, ethylene, isopropylene, butylene, and n is greater than or equal to about 1, greater than or equal to about 3, greater than or equal to about 5, or greater than or equal to about 10 and less than or equal to about 500, less than or equal to about 300, less than or equal to about 100, less than or equal to about 50, less than or equal to about 15 or less], a sulfonyl group ($-S(=O)_2-$), a carbonyl group (-C(=O)-), an ether group (-O-), a sulfide group (-S-), a sulfoxide group (-S(=O)-), an ester group (-C(=O)O-), an amide group (-C(=O)NR-) (where R is hydrogen or a linear or branched alkyl group of C1 to C10), an imine group (-NR-) (where R is hydrogen or a linear or branched alkyl group of C1 to C10) or a combination thereof,

Y is a single bond, a substituted or unsubstituted C1 to C50 alkylene group, a substituted or unsubstituted C2 to C50 alkenylene group, a sulfonyl group ($-S(=O)_2-$), a carbonyl group (-C(=O)-), an ether group (-O-), a sulfide group (-S-), a sulfoxide group (-S(=O)-), an ester group (-C(=O)O-), an amide group (-C(=O)NR-) (where R is hydrogen or a linear or branched alkyl group of C1 to C10), an imine group (-NR-) (where R is hydrogen or a linear or branched alkyl group of C1 to C10) or a combination thereof,

n is an integer greater than 1,

k is an integer of 1 or more,

The sum of n and k is an integer of greater than or equal to about 2 (e.g., greater than or equal to about 3, or greater than or equal to about 4, and less than or equal to about 10, or less than or equal to about 5).

In Chemical Formula 1, n may be determined by a valence of Y, and k may be determined by a valence of L. In Chemical Formula 1, X may include a vinyl group, a (meth)acrylate group, or a combination thereof.

The monomer may include a polyethylene glycol methacrylate, a polypropylene glycol methacrylate, a polyethylene glycol dimethacrylate, a polypropylene glycol dimethacrylate, a substituted or unsubstituted alkyl(meth)acrylate, an ethylene glycol di(meth)acrylate, a triethylene glycol di(meth)acrylate, a diethylene glycol di(meth)acrylate, a dipropylene glycol di(meth)acrylate, a 1,4-butanedialdi(meth)acrylate, a 1,6-hexanedialdi(meth)acrylate, a neopentyl glycol di(meth)acrylate, a pentaerythritol di(meth)acrylate, a pentaerythritol tri(meth)acrylate, a pentaerythritol tetra(meth) acrylate, a dipentaerythritol di(meth)acrylate, a dipentaerythritol(meth)acrylate, a dipentaerythritol penta(meth)acrylate, a dipentaerythritol pentaacrylate, a dipentaerythritol hexa(meth)acrylate, a bisphenol A epoxy acrylate, a bisphenol A di(meth)acrylate, a trimethylolpropane tri(meth)acrylate, a novolacepoxy(meth)acrylate, an ethyl glycol monomethyl ether(meth)acrylate, a tris(meth)acryloyloxyethyl phosphate, a propylene glycol di(meth)acrylate, a diacryloyloxyalkane, or a combination thereof.

In an embodiment, the monomer may include a photopolymerizable monomer. The monomer may include a substituted or unsubstituted di(meth)acrylate compound, a substituted or unsubstituted tri(meth)acrylate compound, a substituted or unsubstituted tetra(meth)acrylate compound, a substituted or unsubstituted penta(meth)acrylate compound, a substituted or unsubstituted hexa(meth)acrylate compound, or a combination thereof.

The ink composition may further include an initiator, a metal oxide (nano)particle, or a combination thereof.

An amount of the initiator may be greater than or equal to about 0.5% by weight and less than or equal to about 10% by weight, based on a total weight of the composition.

An amount of the metal oxide particle may be greater than or equal to about 0.5% by weight and less than or equal to about 30% by weight, based on a total weight of the composition.

The ink composition may be configured to be polymerized into a composite or a pattern thereof in a form of a film, for example, having a thickness of less than or equal to about 15 micrometers or 10 $\mu$m.

The ink composition may be configured to form a semiconductor nanoparticle-polymer composite by polymerization, and in the semiconductor nanoparticle-polymer composite, a quantum yield of the semiconductor nanoparticle may be greater than or equal to about 60%.

The ink composition may be configured to form a composite via a polymerization and may exhibit a quantum efficiency maintenance of greater than or equal to about 50%, wherein the quantum efficiency maintenance is defined by Equation 1:

quantum efficiency maintenance (%) = [quantum efficiency of composite after polymerization /quantum efficiency of semiconductor nanoparticle (for example, in the ink composition)] × 100%. Equation 1

The composite may exhibit a blue light absorbance of greater than or equal to about 85%, greater than or equal to about 88%, or greater than or equal to about 90%, wherein the blue light absorbance is calculated according to Equation 2:

Equation 2

$$\text{blue light absorbance} = [(B-B')/B] \times 100\%$$

wherein, in Equation 2,

B is an amount of blue light provided to the composite, and
B' is an amount of blue light passing through the composite.

The blue light absorbance of the composite may be measured for example in the form of a film having a thickness of about 7 μm.

The blue light absorbance may be less than or equal to about 99.5%, less than or equal to about 99%, less than or equal to about 98%, or less than or equal to about 97%.

In an aspect of the invention, a method of preparing an ink composition is provided in accordance with claim 8.

The semiconductor nanocrystal particle containing the Group 11-13-16 compound may include a zinc salt-treated nanocrystal particle, which may be obtained by contacting a nanocrystal particle containing a Group 11-13-16 compound with a first zinc salt compound (for example, in the absence of the first organic ligand) at a first temperature in a first organic solvent.

The method may further include preparing a dispersion in which the zinc salt-treated nanocrystal particles are dispersed the organic solvent.

In the admixing, a ligand exchange reaction may occur on the surface of the semiconductor nanoparticle.

The method may further include adding the second organic ligand in the admixing (e.g., to the dispersion). The ligand exchange reaction may be carried out in the presence of the second organic ligand.

The first temperature may be greater than or equal to 20°C and less than or equal to 100°C, less than or equal to about 60°C, or less than or equal to about 50°C.

The admixing or the ligand exchange reaction may be conducted for a time of greater than or equal to about 100 minutes and less than or equal to about 5 days.

The admixing or the ligand exchange reaction may be conducted at a temperature of greater than or equal to about 20°C and less than or equal to about 100°C, less than or equal to about 80°C, less than or equal to about 60°C, less than or equal to about 50°C, or less than or equal to about 40°C.

The zinc salt compound may include a zinc fatty acid ester compound, a zinc halide, or a combination thereof.

In an embodiment, a composite (e.g., a semiconductor nanoparticle-polymer composite) is prepared from the ink composition.

In an embodiment, the semiconductor nanoparticle-polymer composite includes a polymerization product of the ink composition

In an embodiment, the composite includes a (polymer) matrix and the semiconductor nanoparticle dispersed in the matrix. The matrix may include a polymerization product of the polymerizable monomer. The matrix or the polymerization product may include a crosslinked polymer. The composite may further include a metal oxide fine particle (e.g., nanoparticle). The composite may be in the form of a patterned film. The composite may be a sheet in which first semiconductor nanoparticles emitting a first light and second semiconductor nanoparticles emitting a second light are mixed, wherein the first light and the second light are different.

An amount of the semiconductor nanoparticle in the composite may be about 1 weight percent (wt%) to about 50 wt%, about 10 wt% to about 30 wt%, or about 15 wt% to about 20 wt%, or a combination thereof, based on a total weight of the composite.

A blue light absorbance of the composite may be greater than or equal to about 70%, greater than or equal to about 80%, greater than or equal to about 85%, or greater than or equal to about 90%. The blue light absorbance of the composite may be about 70% to about 100%, about 80% to about 98%, about 95% to about 99%, about 96% to about 98%, or a combination thereof. The composite may have a blue light absorbance of greater than or equal to about 85%.

The composite or the semiconductor nanocrystal particle may exhibit a light emitting efficiency or a quantum efficiency (QY) of greater than or equal to about 50%, greater than or equal to about 55%, greater than or equal to about 58%, greater than or equal to about 60%, greater than or equal to about 63%, greater than or equal to about 65%, greater than or equal to about 68%, greater than or equal to about 69%, greater than or equal to about 70%, or greater than or equal

to about 75%.

An embodiment provides a device in accordance with claim 13.

In an embodiment, a color conversion panel may include a color conversion layer (e.g., a color conversion structure) including a color conversion region and optionally a partition wall defining each region of the color conversion layer. The color conversion region may include a first region corresponding to the first pixel. The first region includes a first composite and the first composite may include a matrix and a semiconductor nanoparticle dispersed in the matrix, wherein the first region is configured to emit a first light.

In an embodiment, a display panel (or a display device) includes a light source and the composite. In an embodiment, a display panel may include a light emitting panel (or a light source) and the color conversion panel, and optionally a light transmitting layer located between the light emitting panel and the color conversion panel.

The light emitting panel (or light source) may be configured to provide (or provides) an incident light to the color conversion panel. The incident light may include a blue light, and, optionally, a green light. The blue light may have a peak emission wavelength of about 440 nm to about 460 nm, or about 450 nm to about 455 nm.

The light source may include an organic light emitting diode (OLED), a micro LED, a mini LED, an LED including a nanorod, or a combination thereof.

In an embodiment, an electronic device (or a display device) includes the color conversion panel or the display panel.

The display device may comprise a portable terminal device, a monitor, a note PC, a television, an electronic display board, or an electronic part for an automobile or a vehicle.

The ink composition according to an embodiment can provide a nanoparticle-composite or a pattern thereof that exhibits improved physical properties by an inkjet method. According to an embodiment, the ink composition can exhibit improved process stability.

## BRIEF DESCRIPTION OF THE DRAWINGS

The above and other advantages and features of this disclosure will become more apparent by describing in further detail exemplary embodiments thereof with reference to the accompanying drawings.

FIG. 1A is a schematic cross-sectional view of a color conversion panel of one or more embodiments.
FIG. 1B is a cross-sectional view of an electronic device (display device) including a color conversion panel according to one or more embodiments.
FIG. 2 is a flowchart showing a pattern forming process (inkjet method) using the ink composition of an embodiment.
FIG. 3A is a perspective view illustrating an example of a display panel including a color conversion panel according to one or more embodiments.
FIG. 3B is an exploded view of a display device according to one or more embodiments.
FIG. 4 is a cross-sectional view of the display panel of FIG. 3A.
FIG. 5A is a plan view illustrating an example of a pixel arrangement of the display panel of FIG. 3A.
FIGS. 5B, 5C, 5D, and 5E are cross-sectional views showing examples of light emitting devices according to one or more embodiments.
FIG. 6 is a cross-sectional view of the display panel of FIG. 5A taken along line IV-IV.
FIG. 7 is a schematic cross-sectional view of a display device (e.g., a liquid crystal display device) according to one or more embodiments.

## DETAILED DESCRIPTION OF THE EMBODIMENTS

Advantages and features of the techniques described hereinafter, and methods of achieving them, will become apparent with reference to the exemplary embodiments described in further detail below and in conjunction with the accompanying drawings. However, the invention may, be embodied in many different forms, the exemplary embodiments should not be construed as being limited to the exemplary embodiments set forth herein. Rather, these embodiments are provided so that this disclosure will be thorough and complete, and will fully convey the scope of the invention to those skilled in the art. If not defined otherwise, all terms (including technical and scientific terms) in the specification may be defined as commonly understood by one skilled in the art. The terms defined in a generally used dictionary may not be interpreted ideally or exaggeratedly unless clearly defined. In addition, unless explicitly described to the contrary, the word "comprise" and variations such as "comprises" or "comprising," will be understood to imply the inclusion of stated elements but not the exclusion of any other elements. It will be further understood that the terms "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

In the drawings, the thickness of layers, films, panels, regions, etc., are exaggerated for clarity. Like reference numerals designate like elements throughout the specification.

It will be understood that when an element such as a layer, film, region, or substrate is referred to as being "on" another element, it can be directly on the other element or intervening elements may also be present. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first "element," "component," "region," "layer" or "section" discussed below could be termed a second element, component, region, layer or section without departing from the teachings herein.

The terminology used herein is for the purpose of describing particular embodiments only and is not intended to be limiting. As used herein, the singular forms "a," "an," and "the" are intended to include the plural forms, including "at least one," unless the context clearly indicates otherwise. For example, the wording "semiconductor nanoparticle" may refer to a single semiconductor nanoparticle or may refer to a plurality of semiconductor nanoparticles. Thus, reference to "an" element in a claim followed by reference to "the" element is inclusive of one element and a plurality of the elements. "At least one" is not to be construed as being limited to "a" or "an." "Or" means "and/or." As used herein, the term "and/or" includes any and all combinations of one or more of the associated listed items.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 10%, 5% of the stated value. All ranges disclosed herein are inclusive of the endpoints, and the endpoints are independently combinable with each other (e.g., ranges of "up to 25 wt.%, or, more specifically, 5 wt.% to 20 wt.%", is inclusive of the endpoints and all intermediate values of the ranges of "5 wt.% to 25 wt.%," etc.).

As used herein, the expression "not including cadmium (or other harmful heavy metal)" may refer to the case in which a concentration of cadmium (or other harmful heavy metal) may be less than or equal to about 100 parts per million by weight (ppmw), less than or equal to about 50 ppmw, less than or equal to about 10 ppmw, less than or equal to about 1 ppmw, less than or equal to about 0.1 ppmw, less than or equal to about 0.01 ppmw, or zero. In an embodiment, substantially no amount of cadmium (or other harmful heavy metal) may be present or, if present, an amount of cadmium (or other harmful heavy metal) may be less than or equal to a detection limit or as an impurity level of a given analysis tool.

As used herein, if a definition is not otherwise provided, "substituted" refers to replacement of at least one hydrogen of a compound by a substituent selected from a C1 to C30 alkyl group, a C2 to C30 alkenyl group, a C2 to C30 alkynyl group, a C6 to C30 aryl group, a C7 to C30 alkylaryl group, a C7 to C30 arylalkyl group, a C6 to C30 aryloxy group, a C6 to C30 arylthio group, a C1 to C30 alkoxy group, a C1 to C30 alkylthio group, a C1 to C30 heteroalkyl group, a C3 to C30 heteroalkylaryl group, a C2 to C30 alkylheteroaryl group, a C2 to C30 heteroarylalkyl group, a C1 to C30 heteroaryloxy group, a C1 to C30 heteroarylthio group, a C3 to C30 cycloalkyl group, a C3 to C15 cycloalkenyl group, a C6 to C30 cycloalkynyl group, a C2 to C30 heterocycloalkyl group, a halogen (-F, -Cl, -Br, or -I), a hydroxy group (-OH), a nitro group ($-NO_2$), a cyano group (-CN), an amino group or an amine group (-NRR' wherein R and R' are each independently hydrogen or a C1 to C6 alkyl group), an azido group ($-N_3$), an amidino group ($-C(=NH)NH_2$), a hydrazino group ($-NHNH_2$), a hydrazono group ($=N(NH_2)$), an aldehyde group (-C(=O)H), a carbamoyl group ($-C(O)NH_2$), a thiol group (-SH), an ester group (-C(=O)OR, wherein R is a C1 to C6 alkyl group or a C6 to C12 aryl group), a carboxyl group (-COOH) or a salt thereof (-C(=O)OM, wherein M is an organic or inorganic cation), a sulfonic acid group ($-SO_3H$) or a salt thereof ($-SO_3M$, wherein M is an organic or inorganic cation), a phosphoric acid group ($-PO_3H_2$) or a salt thereof ($-PO_3MH$ or $-PO_3M_2$, wherein M is an

organic or inorganic cation), or a combination thereof.

In addition, if a definition is not otherwise provided, "hetero" means the case where 1 to 3 heteroatoms selected from N, O, P, Si, S, Se, Ge, and B is or are included.

In addition, the term "aliphatic hydrocarbon group" as used herein refers to a C1 to C30 linear or branched alkyl group, a C2 to C30 linear or branched alkenyl group, or a C2 to C30 linear or branched alkynyl group, and the term "aromatic organic group" as used herein refers to a C6 to C30 aryl group or a C2 to C30 heteroaryl group.

As used herein, the term "(meth)acrylate" refers to acrylate and/or methacrylate.

As used herein, the term "Group" refers to a Group of the Periodic Table of Elements.

As used herein, a nanoparticle refers to a structure having at least one region or characteristic dimension with a nanoscale dimension. In an embodiment, the dimension of the nanoparticle or the nanostructure may be less than about 500 nanometers (nm), less than about 300 nm, less than about 250 nm, less than about 150 nm, less than about 100 nm, less than about 50 nm, or less than about 30 nm, and may be greater than about 0.1 nm, or about 1 nm. The nanoparticle or nanostructure may have any shape, such as a nanowire, a nanorod, a nanotube, a multi-pod type shape having two or more pods, or a nanodot, but embodiments are not limited thereto. The nanoparticle or nanostructure may be, for example, substantially crystalline, substantially monocrystalline, polycrystalline, amorphous, or a combination thereof.

A quantum dot may be, e.g., a semiconductor-containing nanocrystal particle that can exhibit a quantum confinement effect or an exciton confinement effect, and is a type of a luminescent nanostructure (e.g., capable of emitting light by energy excitation). Herein, a shape of the "quantum dot" or the nanoparticle is not limited unless otherwise defined.

As used herein, the term "dispersion" refers to a dispersion in which a dispersed phase is a solid, and a continuous medium includes a liquid or a solid different from the dispersed phase. In an embodiment, the ink composition may be in a form of a dispersion. Herein, the "dispersion" may be a colloidal dispersion in which the dispersed phase has a dimension of greater than or equal to about 1 nm, for example, greater than or equal to about 2 nm, greater than or equal to about 3 nm, or greater than or equal to about 4 nm to several micrometers (μm) or less, (e.g., less than or equal to about 2 μm, less than or equal to about 1 μm, less than or equal to about 900 nm, less than or equal to about 800 nm, less than or equal to about 700 nm, less than or equal to about 600 nm, or less than or equal to about 500 nm).

As used herein, a dimension (a size, a diameter, a thickness, or the like) may be a value for a single entity or an average value for a plurality of particles. As used herein, the term "average" (e.g., an average size of the quantum dot) may be a mean value or a median value. In an embodiment, the average may be a "mean" value.

As used herein, the term "peak emission wavelength" is the wavelength at which a given emission spectrum of the light reaches its maximum.

In an embodiment, a quantum efficiency may be readily and reproducibly determined using commercially available equipment (e.g., from Hitachi or Hamamatsu, etc.) and referring to manuals provided by, for example, respective equipment manufacturers. The quantum efficiency (which can be interchangeably used with the term "quantum yield" (QY)) may be measured in a solution state or a solid state (in a composite). **In** an embodiment, the quantum efficiency (or the quantum yield) is the ratio of photons emitted to photons absorbed by the nanostructure (or population thereof). In an embodiment, the quantum efficiency may be measured by any suitable method. For example, there may be two methods for measuring the fluorescence quantum yield or efficiency: the absolute method and the relative method. The quantum efficiency measured by the absolute method may be referred to as an absolute quantum efficiency.

In an absolute method, a quantum yield may be obtained by detecting a fluorescence of a semiconductor nanoparticle for example through an integrating sphere. In a relative method, a quantum yield of a semiconductor nanoparticle may be calculated by comparing a fluorescence intensity of a standard dye (a standard sample) with a fluorescence intensity of the semiconductor nanoparticle. Coumarin 153, Coumarin 545, Rhodamine 101 inner salt, Anthracene and Rhodamine 6G may be used as standard dyes according to their PL wavelengths, but embodiments are not limited thereto.

A full width at half maximum and a peak emission wavelength may be measured, for example, from a luminescence spectrum (for example, a photoluminescence (PL) spectrum or an electroluminescent (EL) spectrum) obtained by a spectrophotometer such as a fluorescence spectrophotometer or the like.

As used herein, the term "first absorption peak wavelength" refers to a wavelength at which a main peak first appears in a lowest energy region in the ultraviolet-visible (UV-Vis) absorption spectrum.

A semiconductor nanoparticle may be included in a variety of electronic devices. An electrical and/or an optical property of the semiconductor nanoparticle may be controlled for example, by its elemental composition, its size, its shape, or a combination thereof. In an embodiment, the semiconductor nanoparticle may include a semiconductor nanocrystal. The semiconductor nanoparticle such as a quantum dot may have a relatively large surface area per a unit volume, and thus, may exhibit a quantum confinement effect, exhibiting a physical property and an optical property that are different from a corresponding bulk material having the same composition. Therefore, a semiconductor nanoparticle such as a quantum dot may be supplied with an energy (e.g., an incident light or a voltage) from an excitation source to form an excited state, which upon relaxation is capable of emitting an energy corresponding to its energy bandgap.

The semiconductor nanoparticle may be also used in a color conversion panel (e.g., a photoluminescent color filter or the like). A display device including a quantum dot-containing color conversion panel or a luminescent-type color filter may use a layer including a quantum dot as a luminescent material and includes the same in a relatively front part of a device to convert an incident light (e.g., a blue light) provided from a light source to a light of a different spectrum (for example, a green light or a red light). In an embodiment, the "color conversion panel" is a device (e.g., an electronic device) including a color conversion layer or a color conversion structure.

In the display device including the color conversion panel, a property (e.g., an optical property, stability, or the like) of a semiconductor nanoparticle used as a light emitting material may have a direct effect on a displaying quality of the device. It may be desired for the luminescent material included in the color conversion panel disposed in a relatively front portion of the device to exhibit not only a relatively high luminous efficiency, but also a relatively high absorbance with respect to an incident light. When a patterned film (e.g., for a color filter) is used in the display device, a relatively low absorbance to the incident light may be a direct cause of a blue light leakage, having an adverse effect on color reproducibility (e.g., DCI match rate) of the device. In an embodiment, an adoption of an absorption-type color filter may be considered as a measure for preventing such a blue light leakage problem. However, without wishing to be bound by any theory, it is believed that a relatively low absorbance of the semiconductor nanoparticle may result in a decrease in a luminance of a device including the same.

Some semiconductor nanoparticles may show properties (e.g., optical properties and/or stability) applicable to an actual device, but many of them include a cadmium-containing compounds (e.g., cadmium chalcogenide). As cadmium is one of the most restricted elements, and possibly causes a serious environment/health issue, developing a cadmium-free environmentally friendly semiconductor nanoparticle is still desirable, and an abundance of in-depth research on Group III-V compound-containing nanocrystals has been conducted in this respect. However, it is still desirable to develop a cadmium-free semiconductor nanoparticle that can show a higher incident light absorbance and a narrower full width at half maximum besides a cadmium-free semiconductor nanoparticle including the Group III-V compound (e.g., based on an indium phosphide).

A color conversion panel (e.g., a self-luminous color filter) can be manufactured via a photolithography or inkjet printing process using a composition containing quantum dots. The photolithography process or the inkjet printing process can reproducibly provide a sophisticated color filter. The photolithography process may require a coating, an exposure to light, a development, and a curing for each (sub) pixel, which may cause increases in a manufacturing time and a manufacturing cost. In the inkjet printing process, a liquid ink composition may be discharged through an inkjet head and then be deposited in a predetermined location to produce a nanoparticle-composite in a desired pattern. In the inkjet printing process, pixels each representing different colors such as red, green, and blue can be provided at the same time, which may be desirable in terms of manufacturing process, time, and cost. Accordingly, it is desirable to develop an ink composition capable of manufacturing a composite that has enhanced process stability and can exhibit improved luminescent properties for the above new composition nanoparticles.

According to an embodiment, an ink composition may provide a semiconductor nanoparticle-polymer composite (i.e., composite) or a pattern thereof that can exhibit an improved photo-conversion efficiency with an improved production yield and an increased process stability.

According to he invention, the ink composition includes a semiconductor nanoparticle and a polymerizable monomer. The semiconductor nanoparticle includes zinc, and a Group 11-13-16 compound including silver, a Group 13 metal, and a Group 16 element (i.e., chalcogen element). The ink composition or the semiconductor nanoparticle further includes a first organic ligand including a compound represented by $R_1$-COOA, wherein $R_1$ is a first organic group, and A is hydrogen or a portion linked to a surface of the semiconductor nanoparticle. The ink composition or the semiconductor nanoparticle may further include a second organic ligand different from the first organic ligand. The second organic ligand may include a compound represented by $R_2$-SA, wherein $R_2$ is a second organic group, and A is hydrogen or a portion linked to a surface of the semiconductor nanoparticle.

In an embodiment, a semiconductor nanoparticle may not include cadmium. In an embodiment, the semiconductor nanoparticle may not include mercury, lead, or a combination thereof.

In an embodiment, the semiconductor nanoparticle is configured to emit a first light. In an embodiment, the semiconductor nanoparticle may emit light of a desired wavelength and may achieve an improved optical property (e.g., a narrow full width at half maximum, an increased quantum yield, and/or a relatively high level of a blue light absorbance). The semiconductor nanoparticle of an embodiment may be, for example, utilized as a downconversion material for a color conversion panel or a color conversion sheet, and may exhibit an increased absorption per a weight of the semiconductor nanoparticle, and thus a device (e.g., a panel or a sheet) including the same may be manufactured at a reduced production cost and may provide an improved photoconversion performance.

In the semiconductor nanoparticle, the Group 13 metal includes indium and gallium, and may further include aluminum. The chalcogen element includes sulfur, and may further include selenium. A surface of the semiconductor nanoparticle may include gallium and zinc.

The semiconductor nanoparticle may have a charge balance value defined by Equation 3 that is greater than or

equal to about 0.8 to less than or equal to about 1.5:

Equation 3

charge balance value = {[Ag] + 3x([Group 13 metal])+2x[Zn]}/(2x[CHA])

wherein, in Equation 3, [Ag], [Group 13 metal], [Zn], and [CHA] are molar amounts of the silver, a Group 13 metal (e.g., indium, gallium, or a combination thereof), zinc, and a chalcogen element (e.g., sulfur, selenium, or a combination thereof) in the semiconductor nanoparticle, respectively.

In an embodiment, the charge balance value may be represented by Equation 3A:

Equation 3A

charge balance value = {[Ag] + 3x([In]+[Ga])+2x[Zn]}/(2x[S])

wherein, in Equation 3A, [Ag], [In], [Ga], [Zn], and [S] are molar amounts of silver, indium, gallium, zinc, and sulfur in the semiconductor nanoparticle, respectively.

The semiconductor nanoparticle does not include copper.

In an embodiment, the charge balance value may be less than or equal to about 1.8, less than or equal to 1.5, less than or equal to about 1.45, less than or equal to about 1.4, less than or equal to about 1.35, less than or equal to about 1.33, less than or equal to about 1.31, less than or equal to about 1.3, less than or equal to about 1.29, less than or equal to about 1.28, less than or equal to about 1.27, less than or equal to about 1.26, less than or equal to about 1.25, less than or equal to about 1.24, less than or equal to about 1.23, less than or equal to about 1.22, less than or equal to about 1.21, less than or equal to about 1.2, less than or equal to about 1.15, less than or equal to about 1.1, or less than or equal to about 1.05.

In an embodiment, the charge balance value may be greater than or equal to about 0.81, greater than or equal to about 0.85, greater than or equal to about 0.9, greater than or equal to about 0.95, greater than or equal to about 0.97, greater than or equal to about 0.99, greater than or equal to about 1, greater than or equal to about 1.01, greater than or equal to about 1.02, greater than or equal to about 1.03, greater than or equal to about 1.04, greater than or equal to about 1.05, greater than or equal to about 1.06, greater than or equal to about 1.07, greater than or equal to about 1.08, greater than or equal to about 1.09, greater than or equal to about 1.1, greater than or equal to about 1.11, greater than or equal to about 1.12, greater than or equal to about 1.13, greater than or equal to about 1.14, greater than or equal to about 1.15, greater than or equal to about 1.16, greater than or equal to about 1.17, greater than or equal to about 1.18, greater than or equal to about 1.19, greater than or equal to about 1.2, greater than or equal to about 1.21, greater than or equal to about 1.22, greater than or equal to about 1.23, greater than or equal to about 1.24, or greater than or equal to about 1.25.

In the semiconductor nanoparticle of an embodiment, a mole ratio of sulfur to a sum of silver, indium, and gallium [S:(Ag+In+Ga)] may be greater than or equal to about 0.65:1, greater than or equal to about 0.68:1, greater than or equal to about 0.7:1, greater than or equal to about 0.75:1, greater than or equal to about 0.8:1, greater than or equal to about 0.85:1, greater than or equal to about 0.9:1, greater than or equal to about 0.95:1, greater than or equal to about 1:1, greater than or equal to about 1.1:1, greater than or equal to about 1.2:1, greater than or equal to about 1.3:1, greater than or equal to about 1.35:1, greater than or equal to about 1.36:1, greater than or equal to about 1.38:1, greater than or equal to about 1.4:1, or greater than or equal to about 1.45:1. In the semiconductor nanoparticle of an embodiment, a mole ratio of sulfur to a sum of silver, indium, and gallium [S:(Ag+In+Ga)] may be less than or equal to about 3:1, less than or equal to about 2.5:1, less than or equal to about 2:1, less than or equal to about 1.9:1, less than or equal to about 1.88:1, less than or equal to about 1.6:1, less than or equal to about 1.55:1, less than or equal to about 1.5:1, less than or equal to about 1.45:1, less than or equal to about 1.4:1, less than or equal to about 1.35:1, less than or equal to about 1.33:1, less than or equal to about 1.3:1, less than or equal to about 1.25:1, less than or equal to about 1.2:1, less than or equal to about 1.17:1, less than or equal to about 1.15:1, less than or equal to about 1.09:1, less than or equal to about 1.05:1, or less than or equal to about 1.02:1.

In the semiconductor nanoparticle of an embodiment, a mole ratio of a sum of indium and gallium to silver [(In+Ga):Ag] may be greater than or equal to about 1.3:1, greater than or equal to about 1.4:1, greater than or equal to about 1.5:1, greater than or equal to about 1.65:1, greater than or equal to about 1.7:1, greater than or equal to about 1.75:1, greater than or equal to about 1.8:1, greater than or equal to about 1.85:1, greater than or equal to about 1.9:1, greater than or equal to about 1.95:1, greater than or equal to about 1.99:1, greater than or equal to about 2:1, greater than or equal to about 2.1:1, greater than or equal to about 2.2:1, greater than or equal to about 2.3:1, or greater than or equal to about 2.35:1. The mole ratio of a sum of indium and gallium to silver [(In+Ga):Ag] may be less than or equal to about 7:1, less than or equal to about 6.5:1, less than or equal to about 6.3:1, less than or equal to about 6:1, less than or equal to about 5.9:1, less than or equal to about 5.7:1, less than or equal to about 5.66:1, less than or equal to about 5.5:1, less than or equal to about 5.3:1, less than or equal to about 5.1:1, less than or equal to about 4.5:1, less than or equal to about 4:1, less than or

equal to about 3.5:1, less than or equal to about 3.2:1, less than or equal to about 3:1, less than or equal to about 2.8:1, less than or equal to about 2.6:1, or less than or equal to about 2.4:1.

In the semiconductor nanoparticle of an embodiment, a mole ratio of gallium to a sum of indium and gallium [Ga:(In+Ga)] may be greater than or equal to about 0.5:1, greater than or equal to about 0.55:1, greater than or equal to about 0.6:1, greater than or equal to about 0.65:1, greater than or equal to about 0.7:1, greater than or equal to about 0.75:1, greater than or equal to about 0.8:1, or greater than or equal to about 0.85:1. The mole ratio of gallium to a sum of indium and gallium [Ga:(In+Ga)] may be less than or equal to about 0.99:1, less than or equal to about 0.98:1, less than or equal to about 0.97:1, less than or equal to about 0.96:1, less than or equal to about 0.95:1, less than or equal to about 0.94:1, less than or equal to about 0.93:1, less than or equal to about 0.92:1, less than or equal to about 0.91:1, less than or equal to about 0.9:1, or less than or equal to about 0.83:1.

In the semiconductor nanoparticle of an embodiment, a mole ratio of gallium to sulfur (Ga:S) may be greater than or equal to about 0.1:1, greater than or equal to about 0.15:1, greater than or equal to about 0.2:1, greater than or equal to about 0.25:1, greater than or equal to about 0.3:1, greater than or equal to about 0.31:1, greater than or equal to about 0.32:1, greater than or equal to about 0.33:1, greater than or equal to about 0.34:1, greater than or equal to about 0.35:1, greater than or equal to about 0.38:1, greater than or equal to about 0.4:1, greater than or equal to about 0.47:1, greater than or equal to about 0.5:1, greater than or equal to about 0.53:1, greater than or equal to about 0.55:1, greater than or equal to about 0.56:1, greater than or equal to about 0.58:1, greater than or equal to about 0.6:1, or greater than or equal to about 0.62:1. The mole ratio of gallium to sulfur (Ga:S) may be less than or equal to about 1:1, less than or equal to about 0.9:1, less than or equal to about 0.8:1, less than or equal to about 0.6:1, less than or equal to about 0.55:1, less than or equal to about 0.45:1, less than or equal to about 0.42:1, less than or equal to about 0.41:1, or less than or equal to about 0.4:1.

In the semiconductor nanoparticle of an embodiment, a mole ratio of silver to sulfur (Ag:S) may be greater than or equal to about 0.03:1, greater than or equal to about 0.05:1, greater than or equal to about 0.06:1, greater than or equal to about 0.07:1, greater than or equal to about 0.08:1, greater than or equal to about 0.09:1, greater than or equal to about 0.1:1, greater than or equal to about 0.15:1, greater than or equal to about 0.2:1, greater than or equal to about 0.25:1, greater than or equal to about 0.3:1, greater than or equal to about 0.35:1, greater than or equal to about 0.4:1, or greater than or equal to about 0.45:1. The mole ratio of silver to sulfur (Ag:S) may be less than or equal to about 1:1, less than or equal to about 0.6:1, less than or equal to about 0.5:1, less than or equal to about 0.4:1, less than or equal to about 0.38:1, less than or equal to about 0.36:1, less than or equal to about 0.35:1, less than or equal to about 0.3:1, less than or equal to about 0.25:1, less than or equal to about 0.24:1, or less than or equal to about 0.23:1.

In the semiconductor nanoparticle of an embodiment, a mole ratio of indium to sulfur (In:S) may be greater than or equal to about 0.01:1, greater than or equal to about 0.05:1, greater than or equal to about 0.08:1, greater than or equal to about 0.09:1, or greater than or equal to about 0.1:1. The mole ratio of indium to sulfur (In:S) may be less than or equal to about 0.5:1, less than or equal to about 0.4:1, less than or equal to about 0.3:1, less than or equal to about 0.25:1, less than or equal to about 0.15:1, less than or equal to about 0.14:1, less than or equal to about 0.13:1, or less than or equal to about 0.12:1.

In the semiconductor nanoparticle of an embodiment, a mole ratio of silver to indium (Ag:In) may be greater than or equal to about 1.5:1, greater than or equal to about 1.7:1, greater than or equal to about 1.8:1, greater than or equal to about 1.88:1, or greater than or equal to about 2:1. The mole ratio of silver to indium (Ag:In) may be less than or equal to about 3.5:1, less than or equal to about 3:1, less than or equal to about 2.94:1, less than or equal to about 2:1, less than or equal to about 1.88:1, or less than or equal to about 1.8:1.

In the semiconductor nanoparticle of an embodiment, a mole ratio of zinc to indium (Zn:In) may be greater than or equal to about 0.1:1, greater than or equal to about 0.3:1, greater than or equal to about 0.5:1, greater than or equal to about 0.7:1, greater than or equal to about 0.75:1, greater than or equal to about 0.78:1, greater than or equal to about 0.9:1, greater than or equal to about 1:1, greater than or equal to about 1.2:1, greater than or equal to about 1.4:1, greater than or equal to about 1.6:1, greater than or equal to about 1.7:1, or greater than or equal to about 1.72:1. In the semiconductor nanoparticle of an embodiment, the mole ratio of zinc to indium (Zn:In) may be less than or equal to about 3:1, less than or equal to about 2.5:1, less than or equal to about 2:1, less than or equal to about 1.9:1, less than or equal to about 1.85:1, less than or equal to about 1.7:1, less than or equal to about 1.75:1, or less than or equal to about 1.72:1.

In an embodiment, the semiconductor nanoparticle may not include lithium. In an embodiment, the semiconductor nanoparticle may not include an alkali metal such as sodium, potassium, or the like.

In the semiconductor nanoparticle, an amount of the indium may have a concentration gradient varying (decreasing) in a radial direction (e.g., from its center to its surface). In the semiconductor nanoparticle of one or more embodiments, an indium amount (or concentration) in a portion adjacent (proximate) to a surface (e.g., a shell layer or an outermost layer) of the semiconductor nanoparticle may be less than an indium amount (or concentration) of an inner portion or a core of the semiconductor nanoparticle. In an embodiment, a portion proximate (or adjacent) to a surface (e.g., a shell layer or an outermost layer) of the semiconductor nanoparticle may not include indium.

In an aspect, the semiconductor nanoparticle may comprise

a semiconductor nanocrystal comprising the Group 11-13-16 compound,
wherein the gallium is exposed to (e.g., on) a surface of the semiconductor nanocrystal,
the surface of the semiconductor nanocrystal comprises zinc, and
the first organic ligand linked to the surface of the semiconductor nanocrystal.

In an embodiment, the semiconductor nanoparticle may include a first semiconductor nanocrystal or a core including the first semiconductor nanocrystal; and a second semiconductor nanocrystal (e.g., disposed on the first semiconductor nanocrystal or surrounding the first semiconductor nanocrystal) or a shell including the second semiconductor nanocrystal. The semiconductor nanoparticle may have a core-shell structure. The first semiconductor nanocrystal may have a different composition from the second semiconductor nanocrystal. The semiconductor nanoparticle or the shell may further include an inorganic layer (for example, including a third semiconductor nanocrystal) including a zinc chalcogenide, for example as an outermost layer thereof. The zinc chalcogenide may include zinc; and selenium, sulfur, or a combination thereof. The zinc chalcogenide may include a zinc sulfide, a zinc selenide, a zinc sulfide selenide, or a combination thereof.

A size (or average size, hereinafter, can be simply referred to as "size") of the first semiconductor nanocrystal or the core may be greater than or equal to about 0.5 nm, greater than or equal to about 1 nm, greater than or equal to about 1.5 nm, greater than or equal to about 1.7 nm, greater than or equal to about 1.9 nm, greater than or equal to about 2 nm, greater than or equal to about 2.1 nm, greater than or equal to about 2.3 nm, greater than or equal to about 2.5 nm, greater than or equal to about 2.7 nm, greater than or equal to about 2.9 nm, greater than or equal to about 3 nm, greater than or equal to about 3.1 nm, greater than or equal to about 3.3 nm, greater than or equal to about 3.5 nm, greater than or equal to about 3.7 nm, or greater than or equal to about 3.9 nm. The size of the first semiconductor nanocrystal or the core may be less than or equal to about 5 nm, less than or equal to about 4.5 nm, less than or equal to about 4 nm, less than or equal to about 3.5 nm, less than or equal to about 3 nm, less than or equal to about 2.5 nm, less than or equal to about 2 nm, or less than or equal to about 1.5 nm.

A thickness (or an average thickness, hereinafter, simply referred to as "thickness") of the second semiconductor nanocrystal or the shell may be greater than or equal to about 0.1 nm, greater than or equal to about 0.3 nm, greater than or equal to about 0.5 nm, greater than or equal to about 0.7 nm, greater than or equal to about 1 nm, greater than or equal to about 1.5 nm, greater than or equal to about 1.7 nm, greater than or equal to about 1.9 nm, greater than or equal to about 2 nm, greater than or equal to about 2.1 nm, greater than or equal to about 2.3 nm, greater than or equal to about 2.5 nm, greater than or equal to about 2.7 nm, greater than or equal to about 2.9 nm, greater than or equal to about 3 nm, greater than or equal to about 3.1 nm, greater than or equal to about 3.3 nm, greater than or equal to about 3.5 nm, greater than or equal to about 3.7 nm, or greater than or equal to about 3.9 nm. The thickness of the second semiconductor nanocrystal may be less than or equal to about 5 nm, less than or equal to about 4.5 nm, less than or equal to about 4 nm, less than or equal to about 3.5 nm, less than or equal to about 3 nm, less than or equal to about 2.5 nm, less than or equal to about 2 nm, or less than or equal to about 1.5 nm.

A thickness of the inorganic layer may be appropriately selected. The thickness of the inorganic layer may be less than or equal to about 5 nm, less than or equal to about 4 nm, less than or equal to about 3.5 nm, less than or equal to about 3 nm, less than or equal to about 2.5 nm, less than or equal to about 2 nm, less than or equal to about 1.5 nm, less than or equal to about 1 nm, or less than or equal to about 0.8 nm. The thickness of the inorganic layer may be greater than or equal to about 0.1 nm, greater than or equal to about 0.3 nm, greater than or equal to about 0.5 nm, or greater than or equal to about 0.7 nm. The thickness of the inorganic layer may be about 0.1 nm to about 5 nm, about 0.3 nm to about 4 nm, about 0.5 nm to about 3.5 nm, about 0.7 nm to about 3 nm, about 0.9 nm to about 2.5 nm, about 1 nm to about 2 nm, about 1.5 nm to about 1.7 nm, or a combination thereof.

The first semiconductor nanocrystal may include silver, a Group 13 metal (e.g., indium, gallium, or a combination thereof), and a chalcogen element (e.g., sulfur, and optionally selenium). The first semiconductor nanocrystal may include a quaternary alloy semiconductor material based on a Group 11-13-16 compound including silver (Ag), indium, gallium, and sulfur. The first semiconductor nanocrystal or the semiconductor nanoparticle may include silver indium gallium sulfide, e.g., $Ag(In_xGa_{1-x})S_2$ (x is greater than or equal to 0 and less than or equal to about 1). The mole ratios between the components in the first semiconductor nanocrystal may be adjusted so that the final semiconductor nanoparticle may have a desired composition and an optical property (e.g., a maximum emission wavelength).

The second semiconductor nanocrystal may include a Group 13 metal (indium, gallium, or a combination thereof), and a chalcogen element (sulfur, and optionally selenium). The second semiconductor nanocrystal may further include silver (Ag). The second semiconductor nanocrystal may include silver, gallium, and sulfur. The second semiconductor nanocrystal may include a ternary alloy semiconductor material including silver, gallium, and sulfur. The second semiconductor nanocrystal may have a different composition from that of the first semiconductor nanocrystal. The second semiconductor nanocrystal may include a Group 13-16 compound, a Group 11-13-16 compound, or a combination thereof. The Group 13-16 compound may include gallium sulfide, gallium selenide, indium sulfide, indium selenide, indium gallium sulfide, indium gallium selenide, indium gallium selenide sulfide, or a combination thereof. An energy bandgap of

the second semiconductor nanocrystal may be different from that of the first semiconductor nanocrystal. The second semiconductor nanocrystal may cover at least a portion of the first semiconductor nanocrystal. An energy bandgap of the second semiconductor nanocrystal may be greater than an energy bandgap of the first semiconductor nanocrystal. An energy bandgap of the second semiconductor nanocrystal may be less than an energy bandgap of the first semiconductor nanocrystal. The molar ratios between each component in the second semiconductor nanocrystal may be adjusted so that the final semiconductor nanoparticle exhibits a desired composition and optical properties.

An energy bandgap of the second semiconductor nanocrystal may be less than an energy bandgap of the third semiconductor nanocrystal. The second semiconductor nanocrystal may be disposed between the first semiconductor nanocrystal and the inorganic layer.

The second semiconductor nanocrystal or the first semiconductor nanocrystal may be crystalline when analyzed by, for example, an appropriate analytical means (e.g., an X-ray diffraction analysis, an electron microscope analysis such as high angle annular dark field (HAADF)-scanning transmission electron microscope (STEM) analysis, or the like). In an embodiment, the first semiconductor nanocrystal or the second semiconductor nanocrystal may be, for example, amorphous when analyzed by an appropriate analysis means.

A particle size (or an average particle size, hereinafter, simply referred to as "particle size") of the semiconductor nanoparticle may be greater than or equal to about 1 nm, greater than or equal to about 1.5 nm, greater than or equal to about 2 nm, greater than or equal to about 2.5 nm, greater than or equal to about 3 nm, greater than or equal to about 3.5 nm, greater than or equal to about 4 nm, greater than or equal to about 4.5 nm, greater than or equal to about 5 nm, greater than or equal to about 5.5 nm, greater than or equal to about 6 nm, greater than or equal to about 6.5 nm, greater than or equal to about 7 nm, greater than or equal to about 7.5 nm, greater than or equal to about 8 nm, greater than or equal to about 8.5 nm, greater than or equal to about 9 nm, greater than or equal to about 9.5 nm, greater than or equal to about 10 nm, or greater than or equal to about 10.5 nm. The particle size of the semiconductor nanoparticle may be less than or equal to about 50 nm, less than or equal to about 48 nm, less than or equal to about 46 nm, less than or equal to about 44 nm, less than or equal to about 42 nm, less than or equal to about 40 nm, less than or equal to about 35 nm, less than or equal to about 30 nm, less than or equal to about 25 nm, less than or equal to about 20 nm, less than or equal to about 18 nm, less than or equal to about 16 nm, less than or equal to about 14 nm, less than or equal to about 12 nm, less than or equal to about 11 nm, less than or equal to about 10 nm, less than or equal to about 8 nm, less than or equal to about 6 nm, or less than or equal to about 4 nm. As used herein, the particle size of the semiconductor nanoparticle may be a particle diameter. The particle size of the semiconductor nanoparticle may be an equivalent diameter thereof that is obtained by a calculation involving a conversion of a two-dimensional area of a transmission electron microscopy image of a given particle into a circle. The particle size may be a value (e.g., a nominal particle size) calculated from a composition and a peak emission wavelength of the semiconductor nanoparticle.

The semiconductor nanoparticle of an embodiment may be configured to emit a desired light (e.g., a first light) while exhibiting improved properties.

A peak emission wavelength of the first light or a peak emission wavelength of the semiconductor nanoparticle in a luminescence spectrum may be greater than or equal to about 500 nm, greater than or equal to about 505 nm, greater than or equal to about 510 nm, greater than or equal to about 515 nm, greater than or equal to about 520 nm, greater than or equal to about 525 nm, greater than or equal to about 530 nm, greater than or equal to about 535 nm, greater than or equal to about 540 nm, greater than or equal to about 545 nm, greater than or equal to about 550 nm, greater than or equal to about 555 nm, greater than or equal to about 560 nm, greater than or equal to about 565 nm, greater than or equal to about 570 nm, greater than or equal to about 575 nm, greater than or equal to about 580 nm, greater than or equal to about 585 nm, greater than or equal to about 590 nm, or greater than or equal to about 600 nm. The peak emission wavelength of the first light of the semiconductor nanoparticle may be less than or equal to about 650 nm, less than or equal to about 620 nm, less than or equal to about 600 nm, less than or equal to about 595 nm, less than or equal to about 590 nm, less than or equal to about 580 nm, less than or equal to about 575 nm, less than or equal to about 570 nm, less than or equal to about 565 nm, less than or equal to about 560 nm, less than or equal to about 555 nm, less than or equal to about 550 nm, less than or equal to about 545 nm, less than or equal to about 540 nm, less than or equal to about 535 nm, less than or equal to about 530 nm, less than or equal to about 525 nm, less than or equal to about 520 nm, or less than or equal to about 515 nm.

A full width at half maximum (FWHM) of the peak of the first light or a FWHM of the peak of the semiconductor nanoparticle in the luminescence spectrum may be greater than or equal to about 5 nm, greater than or equal to about 10 nm, greater than or equal to about 15 nm, greater than or equal to about 20 nm, greater than or equal to about 25 nm, or greater than or equal to about 30 nm. The full width at half maximum may be less than or equal to about 70 nm, less than or equal to about 65 nm, less than or equal to about 60 nm, less than or equal to about 55 nm, less than or equal to about 50 nm, less than or equal to about 45 nm, less than or equal to about 40 nm, less than or equal to about 38 nm, less than or equal to about 36 nm, less than or equal to about 35 nm, less than or equal to about 34 nm, less than or equal to about 33 nm, less than or equal to about 32 nm, less than or equal to about 31 nm, less than or equal to about 30 nm, less than or equal to about 29 nm, less than or equal to about 28 nm, less than or equal to about 27 nm, less than or equal to about 26 nm, or less than or equal to about 25 nm.

The semiconductor nanoparticle may exhibit a quantum yield of greater than or equal to about 50%. The quantum yield may be an absolute quantum yield. The quantum yield may be greater than or equal to about 55%, greater than or equal to about 60%, greater than or equal to about 65%, greater than or equal to about 70%, greater than or equal to about 75%, greater than or equal to about 80%, greater than or equal to about 85%, greater than or equal to about 90%, or greater than or equal to about 95%. The quantum yield may be less than or equal to about 100%, less than or equal to about 99.5%, less than or equal to about 99%, less than or equal to about 98%, or less than or equal to about 97%.

The first light may include band-edge emission.

In an embodiment, a method of producing the semiconductor nanoparticle includes

obtaining a semiconductor nanocrystal (e.g., a first semiconductor nanocrystal) including a silver, a Group 13 metal, and a chalcogen element; preparing a reaction medium including a first precursor, an organic ligand, and an organic solvent; and heating the reaction medium to a predetermined temperature;

adding the first semiconductor nanocrystal and a second precursor to the reaction medium to obtain a reaction mixture, wherein one of the first precursor and the second precursor is a gallium precursor and the other is a sulfur precursor; and heating the reaction medium to a reaction temperature and reacting for a first reaction time to form the semiconductor nanoparticle, wherein the predetermined temperature is greater than or equal to about 120°C (e.g., greater than or equal to about 180°C) to less than or equal to about 280°C, and the reaction temperature is greater than or equal to about 180°C (or greater than or equal to about 190°C or greater than or equal to about 240°C) to less than or equal to about 380°C. The first reaction time may be controlled to obtain a charge balance value as described herein for the semiconductor nanoparticle. The predetermined temperature and the reaction temperature may be different. The reaction temperature may be higher than the predetermined temperature. The reaction temperature may be lower than the predetermined temperature.

In an embodiment, the first precursor may be a gallium precursor, and the second precursor may be a sulfur precursor. In an embodiment, the first precursor may be a sulfur precursor, and the second precursor may be a gallium precursor. According to the method of one or more embodiments, oxidation of the gallium precursor may be suppressed efficiently.

In an embodiment, the method may further include preparing an additional reaction medium including an organic ligand and a zinc precursor in an organic solvent; heating the additional reaction medium to a reaction temperature; adding the semiconductor nanoparticle formed above and a chalcogen precursor to conduct a further reaction and to provide an outer layer including zinc chalcogenide on the semiconductor nanoparticle. The chalcogen precursor may include a sulfur precursor, a selenium precursor, or a combination thereof. Details of the temperature for the further reaction are as described herein for the reaction temperature.

The detailed description about the first semiconductor nanocrystal is as described herein. The first semiconductor nanocrystal may include silver (Ag), indium, gallium, and sulfur. A method of producing the first semiconductor nanocrystal is not particularly limited and may be appropriately selected. In an embodiment, the first semiconductor nanocrystal may be obtained by reacting the required precursors depending on the composition, such as a silver precursor, an indium precursor, a gallium precursor, and a sulfur precursor in a solution including an organic ligand and an organic solvent at a predetermined reaction temperature (e.g., about 20°C to about 300°C, about 80°C to about 295°C, about 120°C to about 290°C, or about 200°C to about 280°C) and separating the same. For separation and recovery, a method to be described herein may be referred to.

In the preparation of the first semiconductor nanocrystal, mole ratios among the precursors may be controlled to obtain a desired composition of the first semiconductor nanocrystal. In an embodiment, an amount of the silver (Ag) precursor may be, per one mole of indium, greater than or equal to about 0.1 moles, greater than or equal to about 0.3 moles, greater than or equal to about 0.5 moles, greater than or equal to about 0.7 moles, greater than or equal to about 1 mole, greater than or equal to about 1.5 moles, greater than or equal to about 2 moles, or greater than or equal to about 2.5 moles. In an embodiment, an amount of the silver (Ag) precursor may be, per one mole of indium, less than or equal to about 10 moles, less than or equal to about 8 moles, less than or equal to about 6 moles, less than or equal to about 4 moles, less than or equal to about 2 moles, less than or equal to about 1.2 moles, less than or equal to about 1 mole, or less than or equal to about 0.5 moles.

In an embodiment, an amount of the gallium precursor may be, per one mole of indium, greater than or equal to about 0.5 moles, greater than or equal to about 1 mole, greater than or equal to about 1.5 moles, greater than or equal to about 2 moles, or greater than or equal to about 2.5 moles. In an embodiment, an amount of the gallium precursor may be, per one mole of indium, less than or equal to about 15 moles, less than or equal to about 12 moles, less than or equal to about 10 moles, less than or equal to about 8 moles, less than or equal to about 5 moles, or less than or equal to about 3 moles.

In an embodiment, an amount of the sulfur precursor may be, per one mole of indium, greater than or equal to about 0.5 moles, greater than or equal to about 1 mole, greater than or equal to about 1.5 moles, greater than or equal to

about 2 moles, greater than or equal to about 2.5 moles, greater than or equal to about 3 moles, greater than or equal to about 3.5 moles, greater than or equal to about 4 moles, or greater than or equal to about 4.5 moles. In an embodiment, an amount of the sulfur precursor may be, per one mole of indium, less than or equal to about 20 moles, less than or equal to about 15 moles, less than or equal to about 10 moles, less than or equal to about 8 moles, less than or equal to about 6 moles, less than or equal to about 4 moles, or less than or equal to about 2 moles.

A difference between the predetermined temperature and the reaction temperature may be greater than or equal to about 10°C, greater than or equal to about 20°C, greater than or equal to about 30°C, greater than or equal to about 40°C, greater than or equal to about 50°C, greater than or equal to about 60°C, greater than or equal to about 70°C, greater than or equal to about 80°C, greater than or equal to about 90°C, or greater than or equal to about 100°C. The difference between the predetermined temperature and the reaction temperature may be less than or equal to about 200°C, less than or equal to about 190°C, less than or equal to about 180°C, less than or equal to about 170°C, less than or equal to about 160°C, less than or equal to about 150°C, less than or equal to about 140°C, less than or equal to about 130°C, less than or equal to about 120°C, less than or equal to about 110°C, less than or equal to about 100°C, less than or equal to about 90°C, less than or equal to about 80°C, less than or equal to about 70°C, less than or equal to about 60°C, less than or equal to about 50°C, less than or equal to about 40°C, less than or equal to about 30°C, or less than or equal to about 20°C.

The predetermined temperature may be greater than or equal to about 120°C, greater than or equal to about 200°C, greater than or equal to about 210°C, greater than or equal to about 220°C, greater than or equal to about 230°C, greater than or equal to about 240°C, or greater than or equal to about 250°C. The predetermined temperature may be less than or equal to about 280°C, less than or equal to about 275°C, less than or equal to about 270°C, less than or equal to about 265°C, less than or equal to about 260°C, less than or equal to about 255°C, less than or equal to about 250°C, less than or equal to about 240°C, less than or equal to about 230°C, less than or equal to about 220°C, less than or equal to about 210°C, less than or equal to about 200°C, less than or equal to about 190°C, less than or equal to about 180°C, less than or equal to about 170°C, less than or equal to about 160°C, or less than or equal to about 150°C.

The reaction temperature may be greater than or equal to about 240°C, greater than or equal to about 245°C, greater than or equal to about 250°C, greater than or equal to about 255°C, greater than or equal to about 260°C, greater than or equal to about 265°C, greater than or equal to about 270°C, greater than or equal to about 275°C, greater than or equal to about 280°C, greater than or equal to about 285°C, greater than or equal to about 290°C, greater than or equal to about 295°C, greater than or equal to about 300°C, greater than or equal to about 305°C, greater than or equal to about 310°C, greater than or equal to about 315°C, greater than or equal to about 320°C, greater than or equal to about 330°C, greater than or equal to about 335°C, greater than or equal to about 340°C, or greater than or equal to about 345°C. The reaction temperature may be less than or equal to about 380°C, less than or equal to about 375°C, less than or equal to about 370°C, less than or equal to about 365°C, less than or equal to about 360°C, less than or equal to about 355°C, less than or equal to about 350°C, less than or equal to about 340°C, less than or equal to about 330°C, less than or equal to about 320°C, less than or equal to about 310°C, less than or equal to about 300°C, less than or equal to about 290°C, less than or equal to about 280°C, less than or equal to about 270°C, less than or equal to about 260°C, or less than or equal to about 250°C.

The first reaction time may be controlled to obtain a charge balance value of the semiconductor nanoparticle. The present inventors have found that by controlling the predetermined temperature and the reaction temperature and the first reaction time in the aforementioned reaction, generation of side reaction products (e.g., gallium oxide) may be effectively suppressed during the formation of a semiconductor nanocrystal particle, and whereby the final semiconductor nanoparticle may have the charge balance value described herein (optionally together with the molar ratios between each component described herein), which may contribute to achieving the properties of the semiconductor nanoparticle described herein.

In an embodiment, the first reaction time may be about 1 minute to about 200 minutes, about 10 minutes to about 3 hours, about 20 minutes to about 150 minutes, or about 30 minutes to about 100 minutes. The first reaction time may be selected taking into consideration the types of precursors, the reaction temperature, the desired composition of the final particles, or the like. In an embodiment, the reaction temperature may be within a relatively high temperature range (e.g., greater than or equal to about 280°C, about 285°C to about 340°C, or about 290°C to about 330°C), and the first reaction time may be greater than or equal to about 1 minute, greater than or equal to about 5 minutes, greater than or equal to about 10 minutes, greater than or equal to about 15 minutes, greater than or equal to about 20 minutes, or greater than or equal to about 25 minutes to less than or equal to about 2 hours, less than or equal to about 90 minutes, less than or equal to about 80 minutes, less than or equal to about 70 minutes, less than or equal to about 60 minutes, less than or equal to about 50 minutes, less than or equal to about 45 minutes, less than or equal to about 40 minutes, less than or equal to about 35 minutes, less than or equal to about 25 minutes, less than or equal to about 20 minutes, less than or equal to about 15 minutes, or less than or equal to about 12 minutes. In an embodiment, the reaction temperature may be within a relatively low temperature range (e.g., less than about 290°C, less than or equal to about 280°C, less than or equal to about 270°C, less than or equal to about 260°C, less than or equal to about 250°C, less than or equal to about 240°C, less than or equal to about 230°C, less than or equal to about 220°C, or less than or equal to about 210°C) and the first reaction time may be

greater than or equal to about 30 minutes, greater than or equal to about 35 minutes, greater than or equal to about 40 minutes, greater than or equal to about 45 minutes, greater than or equal to about 50 minutes, greater than or equal to about 55 minutes, greater than or equal to about 60 minutes, greater than or equal to about 65 minutes, greater than or equal to about 70 minutes, greater than or equal to about 75 minutes, or greater than or equal to about 80 minutes.

A type of the silver precursor is not particularly limited and may be selected appropriately. The silver precursor may include a silver powder, an alkylated silver compound, a silver alkoxide, a silver carboxylate, a silver acetylacetonate, a silver nitrate, a silver sulfate, a silver halide, a silver cyanide, a silver hydroxide, a silver oxide, a silver peroxide, a silver carbonate, or a combination thereof. The silver precursor may include a silver nitrate, a silver acetate, a silver acetylacetonate, a silver chloride, a silver bromide, a silver iodide, or a combination thereof.

A type of the indium precursor is not particularly limited and may be selected appropriately. The indium precursor may include an indium powder, an alkylated indium compound, an indium alkoxide, an indium carboxylate, an indium nitrate, an indium perchlorate, an indium sulfate, an indium acetylacetonate, an indium halide, an indium cyanide, an indium hydroxide, an indium oxide, an indium peroxide, an indium carbonate, an indium acetate, or a combination thereof. The indium precursor may include an indium carboxylate such as indium oleate and indium myristate, an indium acetate, an indium hydroxide, an indium chloride, an indium bromide, an indium iodide, or a combination thereof.

A type of the gallium precursor is not particularly limited and may be appropriately selected. The gallium precursor may include a gallium powder, an alkylated gallium compound, a gallium alkoxide, a gallium carboxylate, a gallium nitrate, a gallium perchlorate, a gallium sulfate, a gallium acetylacetonate, a gallium halide, a gallium cyanide, a gallium hydroxide, a gallium oxide, a gallium peroxide, a gallium carbonate, or a combination thereof. The gallium precursor may include a gallium chloride, a gallium iodide, a gallium bromide, a gallium acetate, a gallium acetylacetonate, a gallium oleate, a gallium palmitate, a gallium stearate, a gallium myristate, a gallium hydroxide, or a combination thereof.

A type of the sulfur precursor is not particularly limited and may be appropriately selected. The sulfur precursor may be an organic solvent dispersion or a reaction product of sulfur and an organic solvent, for example, a octadecene sulfide (S-ODE), a trioctylphosphine-sulfide (S-TOP), a tributylphosphine-sulfide (S-TBP), a triphenylphosphine-sulfide (S-TPP), a trioctylamine-sulfide (S-TOA), a bis(trimethylsilylalkyl) sulfide, a bis(trimethylsilyl) sulfide, a mercapto propyl silane, an ammonium sulfide, a sodium sulfide, a C1-C30 thiol compound (e.g., $\alpha$-toluene thiol, octane thiol, dodecanethiol, octadecene thiol, or the like), an isothiocyanate compound (e.g., cyclohexyl isothiocyanate or the like), an alkylenetrithiocarbonate (e.g., ethylene trithiocarbonate or the like), allyl mercaptan, a thiourea compound (e.g., (di) alkylthiourea having a C1 to C40 alkyl group, for example, methylthiourea, dimethylthiourea, ethylthiourea, diethyl thiourea, ethyl methyl thiourea, dipropyl thiourea, or the like; or an arylthiourea such as a phenyl thiourea), or a combination thereof.

The selenium precursor, if present, may include selenium-trioctylphosphine (Se-TOP), selenium-tributylphosphine (Se-TBP), selenium-triphenylphosphine (Se-TPP), or a combination thereof.

A type of the zinc precursor is not particularly limited and may be appropriately selected. In an embodiment, the zinc precursor may include a Zn metal powder, an alkylated Zn compound, a Zn alkoxide, a Zn carboxylate, a Zn nitrate, a Zn perchlorate, a Zn sulfate, a Zn acetylacetonate, a Zn halide, a Zn cyanide, a Zn hydroxide, a Zn oxide, a Zn peroxide, or a combination thereof. The zinc precursor may be dimethyl zinc, diethyl zinc, zinc acetate, zinc acetylacetonate, zinc iodide, zinc bromide, zinc chloride, zinc fluoride, zinc carbonate, zinc cyanide, zinc nitrate, zinc oxide, zinc peroxide, zinc perchlorate, zinc sulfate, or a combination thereof.

The organic ligand may include RCOOH, $RNH_2$, $R_2NH$, $R_3N$, RSH, $RH_2PO$, $R_2HPO$, $R_3PO$, $RH_2P$, $R_2HP$, $R_3P$, ROH, RCOOR', RPO $(OH)_2$, RHPOOH, $R_2POOH$ (wherein, R and R' are each independently substituted or unsubstituted C1 to C40 (or C3 to C24) aliphatic hydrocarbon (e.g., alkyl group, alkenyl group, or alkynyl group), or a substituted or unsubstituted C6 to C40 (or a C6 to C24) aromatic hydrocarbon (e.g., a C6 to C20 aryl group), or a combination thereof. The organic ligand may be bound (e.g., linked) to the surface of the semiconductor nanoparticle. In an aspect, the organic ligand may be in contact with or adjacent to the surface of the semiconductor nanoparticle. Non-limiting examples of the organic ligand may include methane thiol, ethane thiol, propane thiol, butane thiol, pentane thiol, hexane thiol, heptane thiol, octane thiol, nonanethiol, decanethiol, dodecane thiol, hexadecane thiol, octadecane thiol, benzyl thiol; methyl amine, ethyl amine, propyl amine, butyl amine, pentyl amine, hexyl amine, octyl amine, dodecyl amine, hexadecyl amine, octadecyl amine, dimethyl amine, diethyl amine, dipropyl amine; methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, benzoic acid; substituted or unsubstituted methyl phosphine (e.g., trimethyl phosphine, methyldiphenyl phosphine, or the like), substituted or unsubstituted ethyl phosphine (e.g., triethyl phosphine, ethyldiphenyl phosphine, or the like), substituted or unsubstituted propyl phosphine, substituted or unsubstituted butyl phosphine, substituted or unsubstituted pentyl phosphine, substituted or unsubstituted octylphosphine (e.g., trioctylphosphine (TOP)), or the like; a phosphine oxide such as substituted or unsubstituted methyl phosphine oxide (e.g., trimethyl phosphine oxide, methyldiphenylphosphine oxide, or the like), substituted or unsubstituted ethyl phosphine oxide (e.g., triethyl phosphine oxide, ethyldiphenyl phosphine oxide, or the like), substituted or unsubstituted propyl phosphine oxide, substituted or unsubstituted butyl phosphine oxide, substituted or unsubstituted octylphosphine oxide (e.g., trioctylphosphine oxide (TOPO),

or the like); diphenyl phosphine, a triphenyl phosphine compound, or an oxide compound thereof; a C5 to C20 alkylphosphinic acid or a C5 to C20 alkyl phosphonic acid such as phosphonic acid, hexylphosphinic acid, octylphosphinic acid, dodecanephosphinic acid, tetradecanephosphinic acid, hexadecanephosphinic acid, octadecanephosphinic acid, or the like, but embodiments are not limited thereto. The organic ligand may be used alone or as a mixture of two or more.

The organic solvent may include an amine solvent (e.g., an aliphatic amine for example having a C1 to C50 aliphatic amine); a nitrogen-containing heterocyclic compound such as pyridine; a C6 to C40 aliphatic hydrocarbon (e.g., alkane, alkene, alkyne, or the like) such as hexadecane, octadecane, octadecene, or squalene; a C6 to C30 aromatic hydrocarbon such as phenyldodecane, phenyltetradecane, phenyl hexadecane, or the like; a phosphine substituted with a C6 to C22 alkyl group such as trioctylphosphine; a phosphine oxide substituted with a C6 to C22 alkyl group such as trioctylphosphine oxide, or the like; a C12 to C22 aromatic ether such as phenyl ether, or benzyl ether, or the like; or a combination thereof. The amine solvent may be a compound having one or more (e.g., two or three) C1-C50, C2- C45, C3-C40, C4-C35, C5-C30, C6-C25, C7-C20, C8-C15, or C6-C22 aliphatic hydrocarbon groups (alkyl group, alkenyl group, or alkynyl group). In an embodiment, the amine solvent may be a C6-C22 primary amine such as hexadecyl amine and oleylamine; a C6-C22 secondary amine such as dioctyl amine or the like; a C6-C22 tertiary amine such as trioctylamine or the like; or a combination thereof.

Amounts of the organic ligand and the precursors in the reaction medium may be selected appropriately in consideration of the type of solvent, the type of the organic ligand and each precursor, and the size and composition of desired particles. Mole ratios between the precursors may be changed taking into consideration the desired mole ratios in the final semiconductor nanoparticle, the reactivities among the precursors, or the like. In an embodiment, a manner of adding each of the precursors is not particularly limited. In an embodiment, a total amount of a precursor may be added at one time. In an embodiment, a total amount of a precursor may be divided and added into greater than or equal to about 2 aliquots and less than or equal to about 10 aliquots. The precursors may be added simultaneously or sequentially in a predetermined order. The reaction may be carried out in an inert gas atmosphere, in air, or in a vacuum state, but embodiments are not limited thereto.

In an embodiment, after the completion of the reaction, a nonsolvent may be added to a final reaction solution to facilitate separation (e.g., precipitation) of the semiconductor nanoparticle as synthesized (for example, with a coordinating organic ligand). The nonsolvent may be a polar solvent that is miscible with the solvent used in the reaction, but cannot disperse the semiconductor nanoparticle. The nonsolvent may be selected depending on the solvent used in the reaction and may be for example, acetone, ethanol, butanol, isopropanol, ethanediol, water, tetrahydrofuran (THF), dimethylsulfoxide (DMSO), diethylether, formaldehyde, acetaldehyde, a solvent having a similar solubility parameter to the foregoing solvents, or a combination thereof. The separation may be performed by centrifugation, precipitation, chromatography, or distillation. Separated semiconductor nanoparticle may be washed by adding to a washing solvent as needed. The washing solvent is not particularly limited, and a solvent having a solubility parameter similar to that of the organic solvent or ligand may be used. The nonsolvent or washing solvent may be an alcohol; an alkane solvent such as hexane, heptane, octane, or the like; an aromatic solvent such as chloroform; toluene, benzene, or the like; or a combination thereof, but embodiments are not limited thereto.

The semiconductor nanoparticle thus prepared may be dispersed in a dispersion solvent. The semiconductor nanoparticle thus prepared may form an organic solvent dispersion. The organic solvent dispersion may not include water and/or an organic solvent miscible with water. The dispersion solvent may be appropriately selected. The dispersion solvent may include the aforementioned organic solvent. The dispersion solvent may include a substituted or unsubstituted C1 to C40 aliphatic hydrocarbon, a substituted or unsubstituted C6 to C40 aromatic hydrocarbon, or a combination thereof.

A shape of the semiconductor nanoparticle thus prepared is not particularly limited, and may include, for example, spherical, polyhedral, pyramidal, multipod, cubic, nanotubes, nanowires, nanofibers, nanosheets, or a combination thereof, but embodiments are not limited thereto.

The semiconductor nanoparticle of an embodiment may include an organic ligand and/or an organic solvent on a surface of the semiconductor nanoparticle. The organic ligand and/or the organic solvent may be bound to a surface of the semiconductor nanoparticle of one or more embodiments.

In an embodiment, the ink composition or the semiconductor nanoparticle includes a first organic ligand and, and optionally a second organic ligand. The first organic ligand and the second organic ligand may be bonded (e.g., linked) to a surface of the semiconductor nanoparticle. In an aspect, the first organic ligand and/or the second organic ligand may be in contact with, or adjacent to the surface of semiconductor nanoparticle.

The semiconductor nanoparticle of an embodiment may exhibit luminescent properties as described herein. However, the present inventors have found that luminescent properties may be significantly deteriorated when the semiconductor nanoparticle of the embodiment being mixed with a component (e.g., a polymerizable monomer) to form an ink composition for an inkjet printing or when being made into a composite. An increased photoconversion efficiency (or a light emitting efficiency) may be desired in a display device (e.g., a TV set, a Watch device, a VR/AR device) for example including a light source such as a micro LED. Surprisingly, the present inventors have found that the luminescent

properties of the aforementioned semiconductor nanoparticle in the composite may be improved by adopting the ligand together with the semiconductor nanoparticle as described herein.

In an embodiment, the ink composition may include the semiconductor nanoparticles described herein together with a ligand described herein or a combination of them (e.g., the first organic ligand and the second organic ligand depending on selection). The ligand may be adjacent to or in contact with (e.g., bound to, or linked to) a surface of the semiconductor nanoparticle. The ink composition of an embodiment may manufacture a pattern with an improved stability, and the composite thus manufactured may exhibit a desired luminescent property.

The first organic ligand includes a compound represented by $R_1$-COO-A, wherein $R_1$ is the first organic group, and A is hydrogen or a portion bound to a surface of the semiconductor nanoparticle. The first organic ligand may include at least one compound or at least two compounds. The first organic group may include a substituted or unsubstituted $C_{1-500}$, $C_{2-300}$, $C_{3-100}$, $C_{4-50}$, or $C_{5-10}$ hydrocarbon group. In the hydrocarbon group, at least one methylene in a backbone or a main chain may be replaced with -CO-, -O-, -COO-, -S-, -SO-, - NHCO-, or a combination thereof.

The first organic ligand may include a carboxylic acid compound represented by $R_1$-COOH or a moiety derived therefrom (e.g., a carboxylate group). The first organic group may include a carbon-carbon double bond-containing moiety. The carbon-carbon double bond-containing moiety may include a (meth)acrylate group. The first organic group or the first organic ligand may include or may not include a piperidine moiety, an amine moiety (e.g., -NR-, R is hydrogen or a C1-C10 hydrocarbon group), an amide moiety, or a combination thereof.

The first organic group or $R_1$ may include a moiety represented by E1-L-*, wherein E1 may be hydrogen, a substituted or unsubstituted C1 to C10 alkyl group, a substituted or unsubstituted C2 to C10 alkenyl group, a (meth) acrylate group, or a combination thereof, and L may be a direct (e.g., single) bond, a substituted or unsubstituted C1 to C50 hydrocarbon group (e.g., an alkylene group, an alkenylene group, or an alkynylene group), $[R^3\text{-O}]n$ ($R^3$ is ethylene, propylene, isopropylene, or a combination thereof, n is 1 to 140, 2-10, 3-7, or 4-6), -CO-, -O-, -SO-, -COO-, -S-, -NHCO-, or a combination thereof, and * is a portion linked to an adjacent atom (e.g., a carbonyl carbon). The L may be a moiety formed by combining at least two of a substituted or unsubstituted C1 to C50 alkylene group, $[R^3\text{-O}]n$ ($R^3$ is ethylene, propylene, isopropylene, or a combination thereof, n is 1 to 140, 2-10, 3-7, or 4-6), -CO-, -O-, -SO-, -COO-, - S-, and -NHCO-.

The first organic ligand may include a carboxylic acid compound represented by Chemical Formula 2-1 or Chemical Formula 2-2; or a group or moiety derived from the carboxylic acid compound (e.g., represented by Chemical Formula 2-3 or represented by chemical formula 2-4) :

Chemical Formula 2-1

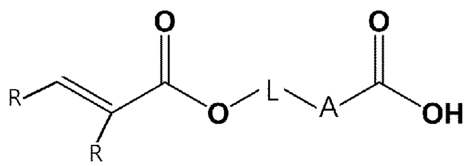

Chemical Formula 2-2

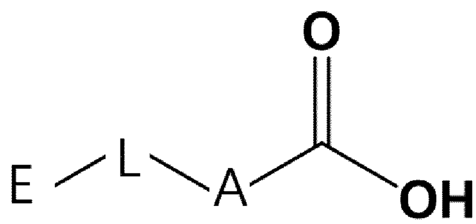

Chemical Formula 2-3

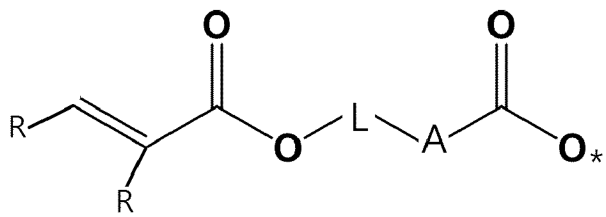

Chemical Formula 2-4

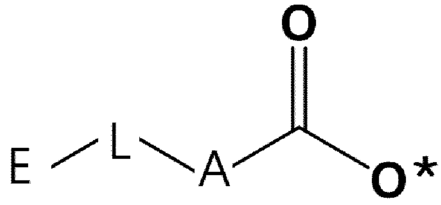

wherein, in each Chemical Formula 2-1, Chemical Formula 2-2, Chemical Formula 2-3, Chemical Formula 2-4, independently,

R is the same or different and is independently hydrogen or C1 to C10 alkyl (e.g., methyl),

E is hydrogen or a substituted or unsubstituted C1 to C10 or C6 to C8 (e.g., aliphatic or aromatic) hydrocarbon group (e.g., an alkyl such as methyl, an alkenyl, or an alkynyl group),

L is a direct bond, a substituted or unsubstituted C1 to C50 hydrocarbon group (e.g., an alkylene group, an alkenylene group, or an alkynylene group), $[R^3\text{-}O]n$ ($R^3$ is ethylene, propylene, isopropylene, or a combination thereof, n is 1 to 140, 2-10, 3-7, or 4-6), -CO-, -O-, -SO-, -COO-, -S-, -NHCO-, or a combination thereof (e.g., a moiety formed by combining at least two of the foregoing groups),

A is a direct bond, a substituted or unsubstituted C1 to C50 hydrocarbon group (e.g., an alkylene group, an alkenylene group, or an alkynylene group), $[R^3\text{-}O]n$ ($R^3$ is ethylene, propylene, isopropylene, or a combination thereof, n is 1 to 140, 2-10, 3-7, or 4-6), -CO-, -O-, -SO-, -COO-, -S-, -NHCO-, or a combination thereof (e.g., a moiety formed by combining at least two of the foregoing groups), and

* is a portion linked to the semiconductor nanoparticle.

In the compound, the COOH group may be converted into $COO^-$ (e.g., carboxylate) for the ligand to be bonded to the surface of the semiconductor nanoparticle.

In the definition of L or A, at least one methylene in the hydrocarbon group can be replaced by CO, O, SO, COO, S, NHCO, or a combination thereof (e.g., a moiety formed by combining at least two of the foregoing groups).

The first organic ligand may include a compound represented by any of the following formulas or a moiety (e.g., a carboxylate moiety) derived therefrom:

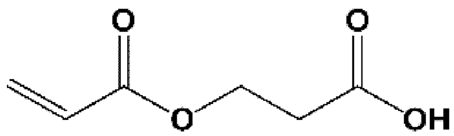

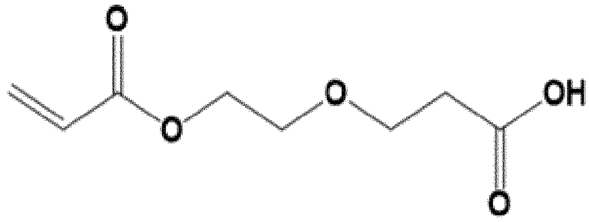

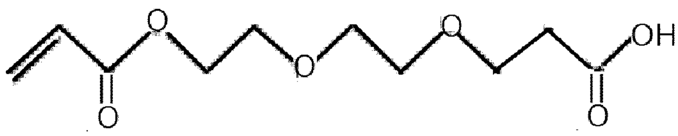

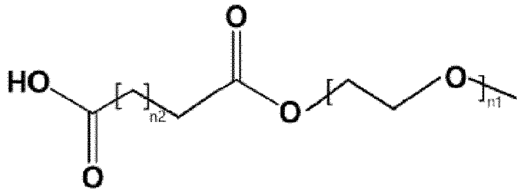

wherein n1 is an integer from 1 to 100, 3-80, 5-70, 7-60, 9-50, 10-45, or 15-35, and n2 is an integer from 1 to 20, 2-15, or 3-10.

The ink composition or the semiconductor nanoparticle may further include a second organic ligand different from the first organic ligand. The second organic ligand may bound to a surface of the semiconductor nanoparticle. The second organic ligand may include a compound represented by $R_2$-SA, wherein $R_2$ is a second organic group and A is hydrogen or a portion linked to a surface of the semiconductor nanoparticle.

Surprisingly, the present inventors have found that by including the first organic ligand and optionally the second organic ligand in the ink composition (e.g., and being bound to the surface of the semiconductor nanoparticle) as described herein, deterioration of a property (e.g., a light emitting efficiency) of the semiconductor nanoparticle that may otherwise occur during a process forming a composite can be significantly suppressed.

In an embodiment, the organic ligand may be bound to a surface of the semiconductor nanoparticle, whereby after stirring the semiconductor nanoparticle including the bound organic ligand for a predetermined time (e.g., 30 minutes to 3 hours, 1 hour to 2 hours, or a combination of them) in a nonsolvent or solvent, the organic ligand may not be separated from the semiconductor nanoparticle.

Without wishing to be bound by any theory, it is believed that by being combined with a metal (e.g., gallium, zinc, or a combination thereof) present on the surface of semiconductor nanoparticle, the carboxyl group of the first organic ligand (or the thiol group of the second organic ligand, if present) can passivation the surface of the semiconductor nanoparticle in the form of carboxylate or thiolate.

The second organic group may be a substituted or unsubstituted $C_{1-500}$, $C_{2-300}$, $C_{3-100}$, $C_{4-50}$, or $C_{5-10}$ hydrocarbon group and, optionally, for example in a backbone thereof, at least one methylene may be replaced with -CO-, -O-, - COO-, -S-, -SO-, -NHCO-, or a combination thereof.

The second organic ligand may include a thiol compound represented by $R_1$-SH or a moiety derived therefrom (e.g., a thiolate group). The second organic group may further include an alkoxy carbonyl moiety. The second organic group or the second organic ligand may include or may not include a piperidine moiety, an amine moiety (e.g., -NR-, R is hydrogen or a C1-C10 hydrocarbon group such as an alkyl group), an amide moiety, or a combination thereof.

The second organic group or R2 may include a moiety represented by E2-L-*, wherein E2 may be hydrogen, a substituted or unsubstituted C1 to C10 alkyl group, a substituted or unsubstituted C1 to C10 alkoxy group, or a combination thereof, and L may be a direct bond, a substituted or unsubstituted C1 to C50 hydrocarbon group (e.g., an alkylene group, an alkenylene group, or an alkynylene group), $[R^3\text{-O}]n$ ($R^3$ is ethylene, propylene, isopropylene, or a combination thereof, n is 1 to 140), -CO-, -O-, -SO-, -COO-, -S-, -NHCO-, or a combination thereof, and * is a portion linked to an adjacent atom (e.g., sulfur). The L may be a moiety formed by combining at least two of a substituted or unsubstituted C1 to C50 alkylene group, $[R^3\text{-O}]n$ ($R^3$ is ethylene, propylene, isopropylene, or a combination thereof, n is 1 to 140), -CO-, -O-, -SO-, -COO-, -S-, and -NHCO-.

The second organic ligand may include a compound represented by Chemical Formula 3:

Chemical Formula 3 E2-M-A-SH

wherein E2 is hydrogen, a substituted or unsubstituted C1 to C10 alkyl (e.g., methyl) group, or a substituted or unsubstituted C1 to C10 alkoxy (e.g., methoxy) group,

M is a direct bond, a substituted or unsubstituted C1 to C50 hydrocarbon group (e.g., an alkylene group, an alkenylene group, or an alkynylene group), $[R^3\text{-O}]n$ ($R^3$ is ethylene, propylene, isopropylene, or a combination thereof, n is 1 to 140), -CO-, -O-, -SO-, -COO-, -S-, -NHCO-, or a combination thereof (e.g., a moiety formed by combining at least two of the foregoing groups), and

A is a direct bond, a substituted or unsubstituted C1 to C50 hydrocarbon group (e.g., an alkylene group, an alkenylene group, or an alkynylene group), $[R^3\text{-O}]n$ ($R^3$ is ethylene, propylene, isopropylene, or a combination thereof, n is 1 to 140), -CO-, -O-, -SO-, -COO-, -S-, -NHCO-, or a combination thereof (e.g., a moiety formed by combining at least two of the foregoing groups).

In the compound of the embodiment, the SH group may be converted into $S^-$ (e.g., thiolate) for the ligand to be bonded to the surface of the semiconductor nanoparticle.

In the definition of M or A, at least one methylene in the hydrocarbon group can be replaced by CO, O, SO, COO,

S, NHCO, or a combination thereof (e.g., a moiety formed by combining at least two of the foregoing groups).

The second organic ligand may include a compound represented by Chemical Formula 3-1 or a moiety derived therefrom:

Formula 3-1

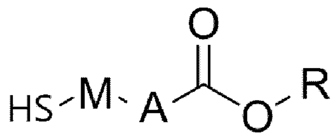

wherein, R is a substituted or unsubstituted C1 to C10 alkyl (e.g., methyl) group, and

M and A are the same as defined above.

The first organic ligand and the second organic ligand may be readily prepared or synthesized by any known method or may be commercially available.

In an embodiment, the semiconductor nanoparticle may further include a native ligand derived from an organic ligand compound used in its synthesis process, such as an amine compound (e.g., a primary amine having one aliphatic alkyl group such as an oleyl amine). Examples of the organic ligand compound for the native ligands are the same as described herein.

The present inventors have found that it may be difficult to ensure a dispersibility of the semiconductor nanoparticle desired for the formation of the ink composition in case where the semiconductor nanoparticle to be included in the composition has only the native ligand. Without wishing to be bound by any theory, it is believed that a monomer (as described herein) to be included in the composition for inkjet ink process may not be sufficiently compatible with the native ligand of the semiconductor nanoparticle, making it difficult to provide sufficient dispersibility. In the ink composition of an embodiment, the semiconductor nanoparticle together with the first organic ligand and optionally the second organic ligand (for example, bound to a surface thereof) may be relatively readily dispersed in a liquid vehicle (e.g., including a monomer or a solvent if present) for an inkjet ink composition.

The second organic ligand may exist or may not exist in the composition. A mole ratio between the first organic ligand and the second organic ligand may be 1: from about 0 to about 100, 1: from about 0.05 to about 80, 1: from about 0.1 to about 50, 1: from about 0.15 to about 40, 1: from about 0.2 to about 30, 1: from about 0.3 to about 25, 1: from about 0.5 to about 20, 1: from about 0.7 to about 15, 1: from about 0.8 to about 10, 1: from about 0.9 to about 8, or 1: from about 1 to about 5.

In an embodiment, the composition may further include the second organic ligand and a mole ratio between the second organic ligand (e.g., a thiol based ligand) and the first organic ligand (e.g., a carboxylic acid based ligand) (the second organic ligand: the first organic ligand) may be 1: from about 0.5 to about 100, 1: from about 0.7 to about 50, 1: from about 0.8 to about 40, 1: from about 1 to about 30, 1: from about 2 to about 20, 1: from about 2.5 to about 10, 1: from about 3 to about 8, or 1: from about 4 to about 6. The mole ratio between the second organic ligand and the first organic ligand (the second organic ligand: the first organic ligand) may be 1: greater than or equal to about 0.6, 1: greater than or equal to about 1.1, 1: greater than or equal to about 1.2, 1: greater than or equal to about 1.5, 1: greater than or equal to about 1.8, or 1: greater than or equal to about 2 and 1: less than or equal to about 10, 1: less than or equal to about 9, 1: less than or equal to about 8, 1: less than or equal to about 7, 1: less than or equal to about 6, 1: less than or equal to about 5, 1: less than or equal to about 4, 1: less than or equal to about 3, 1: less than or equal to about 2, or 1: less than or equal to about 1.

The semiconductor nanoparticle containing the first organic ligand and optionally the second organic ligand (e.g., bound to a surface thereof) can be obtained according to the method described herein. The method may involve a ligand exchange reaction. The ligand may be bound or linked to the surface of the semiconductor nanoparticle. Therefore, the method of manufacturing an ink composition in an embodiment includes mixing a monomer and the semiconductor nanoparticle together with (e.g., containing) the first organic ligand and, optionally, the second organic ligand, which may be obtained by:

admixing a semiconductor nanocrystal particle containing a Group 11-13-16 compound with the first organic ligand (and optionally the second organic ligand) and a zinc salt compound (e.g., a second zinc salt compound such as a zinc halide compound) in an organic solvent to obtain a semiconductor nanoparticle containing (e.g., in contact with) the first organic ligand (and optionally the second organic ligand). The first organic ligand (and optionally the second organic ligand) may be bound to a surface of the semiconductor nanoparticle.

The semiconductor nanocrystal particle containing the Group 11-13-16 compound may include a zinc salt-treated nanocrystal particle, which may be obtained by contacting a nanocrystal particle containing the Group 11-13-16 compound with a first zinc salt compound (for example, in the absence of the first organic ligand) at a first temperature in a first organic solvent.

The method may further include preparing a dispersion in which the zinc salt-treated nanocrystal particle is dispersed the organic solvent.

In the admixing, a ligand exchange reaction (with the first organic ligand and optionally the second organic ligand) may occur on the surface of the semiconductor nanoparticle.

The method may further include adding the second organic ligand in the admixing (e.g., to the dispersion). The ligand exchange reaction may be carried out in the presence of the second organic ligand. The semiconductor nanoparticle may include the first organic ligand and optionally the second organic ligand that are bound to a surface thereof.

The nanocrystal particle may include a first semiconductor nanocrystal, and may further include a second semiconductor nanocrystal, an inorganic layer including a zinc chalcogenide, or a combination thereof. Details of the first semiconductor nanocrystal, the second semiconductor nanocrystal, the inorganic layer, and the production of the nanocrystal particle are the same as described herein. In an aspect, the method for producing an ink composition comprises:

admixing

a semiconductor nanocrystal particle comprising a Group 11-13-16 compound,
a first organic ligand,
a zinc salt compound, and
a organic solvent to obtain the semiconductor nanoparticle in contact with the first organic ligand; and

mixing a polymerizable monomer and the semiconductor nanoparticle in contact with the first organic ligand to produce the ink composition,
wherein the ink composition comprises
the semiconductor nanoparticle and the polymerizable monomer, wherein the semiconductor nanoparticle comprises

zinc, and
the Group 11-13-16 compound; and

the first organic ligand comprising a compound or a moiety represented by $R_1$-COO-A,
wherein $R_1$ is a first organic group, and A is hydrogen or a portion linked to a surface of the semiconductor nanoparticle.

The present inventors have found that in case of the nanocrystal particle having a native ligand, it may be difficult to conduct a ligand exchange reaction with the first organic ligand and/or the second organic ligand. In the method of an embodiment, a ligand exchange reaction may involve a use of a zinc salt compound. In an embodiment, a ligand exchange reaction may be conducted in the presence of a zinc salt compound. .to provide a semiconductor nanoparticle including the first organic ligand and optionally the second organic ligand, for example, at a desired ratio. In an embodiment, the nanocrystal particle having the native ligand may be treated with a zinc salt compound as described herein and then a ligand exchange reaction may be carried out (for example, in the presence of an additional zinc salt compound).

Details of the first organic ligand and the second organic ligand are the same as described herein.

The first organic solvent may be selected appropriately taking into consideration the type of the organic ligand, the native ligand, and the zinc salt compound. The first organic solvent may include a C6 to C40 aliphatic hydrocarbon solvent (e.g., alkane, alkene, alkyne) solvent, such as octane, hexane, heptane, or the like; a C6 to C30 aromatic hydrocarbon solvent such as toluene, xylene, or the like; or a combination thereof.

The (first or second) zinc salt compound may include a C8 to C50 zinc fatty acid ester compound (e.g., a zinc oleate, a zinc stearate, a zinc myristate, etc.), a zinc halide (e.g., a zinc chloride, a zinc bromide, a zinc iodide, a zinc fluoride, etc.), or a combination thereof. The first zinc salt compound and the second zinc salt compound may be the same or may be different from each other. In an embodiment, the first zinc salt compound may include a C8 to C50 zinc fatty acid ester compound and the second zinc salt compound may include zinc halide; or vice versa.

The first temperature may be greater than or equal to about 20°C, greater than or equal to about 30°C, greater than or equal to about 40°C, greater than or equal to about 45°C, or greater than or equal to about or 50°C. The first temperature may be less than or equal to about 150°C, less than or equal to about 100°C, less than or equal to about 80°C, less than or equal to about 60°C, less than or equal to about 55°C, or less than or equal to about 45°C.

The admixing (e.g., a ligand exchange reaction, such as contacting the nanocrystal particle with the first organic ligand and/or the second organic ligand to obtain the semiconductor nanoparticle with the first organic ligand and/or the second organic ligand) temperature may be greater than or equal to about 20°C, greater than or equal to about 30°C, greater than or equal to about 40°C, greater than or equal to about 45°C, greater than or equal to about 50°C or more. The admixing (e.g., ligand exchange reaction) temperature may be less than or equal to about 150°C, less than or equal to

about 100°C, less than or equal to about 80°C, less than or equal to about 60°C, less than or equal to about 55°C, or less than or equal to about 45°C.

The admixing (e.g., ligand exchange reaction) may be conducted for greater than or equal to about 50 minutes, greater than or equal to about 1 hour, greater than or equal to about 90 minutes, greater than or equal to about 100 minutes, greater than or equal to about 2 hours, or greater than or equal to about 3 hours, and less than or equal to about 5 days, less than or equal to about 3 days, less than or equal to about 2 days, less than or equal to about 1 day, or less than or equal to about or 12 hours.

An amount of the first zinc salt compound or the second zinc salt compound may be appropriately selected taking into consideration the type of the compound, the type of the ligand compound, the desired exchange degree, or the like.

In an embodiment, the amount of the first zinc salt compound may be, per one mole of the nanocrystal particle, greater than or equal to about 10 moles, greater than or equal to about 100 moles, greater than or equal to about 500 moles, greater than or equal to about 1000 moles, greater than or equal to about 5000 moles, greater than or equal to about 10000 moles, greater than or equal to about 15000 moles, or greater than or equal to about 20000 moles, and less than or equal to about 200000 moles, less than or equal to about 150000 moles, less than or equal to about 100000 moles, less than or equal to about 50000 moles, less than or equal to about 30000 moles, less than or equal to about 20000 moles, less than or equal to about 10000 moles, less than or equal to about 5000 moles, less than or equal to about 1000 moles, less than or equal to about 500 moles, or less than or equal to about 100 moles. In an embodiment, the amount of the second zinc salt compound may be, per one mole of the organic ligand (e.g., a sum of the first organic ligand and the second organic ligand), greater than or equal to about 0.01 moles, greater than or equal to about 0.05 moles, greater than or equal to about 0.1 moles, or greater than or equal to about 0.3 moles, and less than or equal to about 1 moles, less than or equal to about 0.5 moles, or less than or equal to about 0.1 moles.

The ligand-exchanged semiconductor nanoparticle may be well dispersed in a liquid vehicle (e.g., monomers described herein) for an ink composition.

In the method of an embodiment, the used amount of the first organic ligand may be, per one mole of the nanocrystal particle, greater than or equal to about 10 moles, greater than or equal to about 50 moles, greater than or equal to about 100 moles, greater than or equal to about 300 moles, greater than or equal to about 500 moles, greater than or equal to about 600 moles, greater than or equal to about 700 moles, greater than or equal to about 1000 moles, greater than or equal to about 1500 moles, greater than or equal to about 2000 moles, greater than or equal to about 2500 moles, greater than or equal to about 3000 moles, greater than or equal to about 3500 moles, greater than or equal to about 4000 moles, greater than or equal to about 4500 moles, greater than or equal to about 5000 moles, greater than or equal to about 5500 moles, greater than or equal to about 6000 moles, greater than or equal to about 6500 moles, greater than or equal to about 7000 moles, greater than or equal to about 7500 moles, greater than or equal to about 8000 moles, greater than or equal to about 8500 moles, greater than or equal to about 9000 moles, greater than or equal to about 10000 moles, greater than or equal to about 12000 moles, greater than or equal to about 15000 moles, greater than or equal to about 17000 moles, greater than or equal to about 19000 moles, or greater than or equal to about 19500 moles and less than or equal to about 20000 moles, less than or equal to about 30000 moles, or less than or equal to about 40000 moles.

In the method of an embodiment, the used amount of the second organic ligand may be, per one mole of the nanocrystal particle, greater than or equal to about 0 moles, greater than or equal to about 10 moles, greater than or equal to about 50 moles, greater than or equal to about 100 moles, greater than or equal to about 300 moles, greater than or equal to about 500 moles, greater than or equal to about 600 moles, greater than or equal to about 700 moles, greater than or equal to about 1000 moles, greater than or equal to about 1500 moles, greater than or equal to about 2000 moles, greater than or equal to about 2500 moles, greater than or equal to about 3000 moles, greater than or equal to about 3500 moles, greater than or equal to about 4000 moles, greater than or equal to about 4500 moles, greater than or equal to about 5000 moles, greater than or equal to about 5500 moles, greater than or equal to about 6000 moles, greater than or equal to about 6500 moles, greater than or equal to about 7000 moles, greater than or equal to about 7500 moles, greater than or equal to about 8000 moles, greater than or equal to about 8500 moles, greater than or equal to about 9000 moles, greater than or equal to about 10000 moles, greater than or equal to about 12000 moles, greater than or equal to about 15000 moles, greater than or equal to about 17000 moles, greater than or equal to about 19000 moles, greater than or equal to about 19500 moles and less than or equal to about 20000 moles, less than or equal to about 30000 moles, or less than or equal to about 40000 moles.

In an embodiment, the ligand-exchanged semiconductor nanoparticles may exhibit an increased organic content compared to the crude semiconductor nanoparticles. An organic amount of the semiconductor nanoparticle may be, based on a total weight of the semiconductor nanoparticle, greater than or equal to about 15 wt%, greater than or equal to about 20 wt%, greater than or equal to about 25 wt%, greater than or equal to about 29 wt%, greater than or equal to about 30 wt%, greater than or equal to about 33 wt%, or greater than or equal to about 35 wt% and less than or equal to about 60 wt%, less than or equal to about 55 wt%, less than or equal to about 45 wt%, less than or equal to about 40 wt%, less than or equal to about 38 wt%, or less than or equal to about 36 wt%.

In the semiconductor nanoparticle included in the ink composition, a mole ratio of zinc with respect to a chalcogen

element (e.g., sulfur) may be less than or equal to about 0.8:1, less than or equal to about 0.3:1, or less than or equal to about 0.25:1. In the semiconductor nanoparticle included in the ink composition, a mole ratio of zinc with respect to a chalcogen element (e.g., sulfur) may be greater than or equal to about 0.01:1, greater than or equal to about 0.05:1, or greater than or equal to about 0.1:1.

In the ink composition of an embodiment, the semiconductor nanoparticle may include zinc and silver, and a mole ratio of zinc to silver (Zn:Ag) may be greater than or equal to about 0.3:1, greater than or equal to about 0.35:1, greater than or equal to about 0.4:1, greater than or equal to about 0.45:1, greater than or equal to about 0.5:1, greater than or equal to about 0.55:1, greater than or equal to about 0.6:1, greater than or equal to about 0.65:1, greater than or equal to about 0.7:1, greater than or equal to about 0.75:1, greater than or equal to about 0.8:1, greater than or equal to about 0.85:1, greater than or equal to about 0.9:1, greater than or equal to about 0.95:1, greater than or equal to about 1:1, greater than or equal to about 1.2:1, greater than or equal to about 1.4:1, greater than or equal to about 1.6:1, greater than or equal to about 1.7:1, greater than or equal to about 1.9:1, greater than or equal to about 2:1, greater than or equal to about 2.5:1, greater than or equal to about 3:1, greater than or equal to about 3.5:1, or greater than or equal to about 4:1. In the ink composition, the mole ratio of zinc to silver (Zn:Ag) may be 5:1, less than or equal to about 4.7:1, less than or equal to about 4.4:1, less than or equal to about 4.1:1, less than or equal to about 3.9:1, less than or equal to about 3.7:1, less than or equal to about 3.5:1, less than or equal to about 3:1, less than or equal to about 2.7:1, less than or equal to about 2.6:1, or less than or equal to about 2.3:1.

In the ink composition of an embodiment, the semiconductor nanoparticle may include a mole ratio of zinc to indium (Zn:In) that may be greater than or equal to about 0.1:1, greater than or equal to about 0.3:1, greater than or equal to about 0.5:1, greater than or equal to about 0.7:1, greater than or equal to about 0.9:1, greater than or equal to about 1.1:1, greater than or equal to about 1.3:1, greater than or equal to about 1.5:1, greater than or equal to about 1.7:1, greater than or equal to about 1.9:1, greater than or equal to about 2.1:1, greater than or equal to about 2.3:1, greater than or equal to about 2.5:1, greater than or equal to about 2.7:1, greater than or equal to about 2.9:1, or greater than or equal to about 3:1. In the semiconductor nanoparticle, the mole ratio of zinc to indium (Zn:In) may be less than or equal to about 10:1, less than or equal to about 8:1, less than or equal to about 6:1, less than or equal to about 5:1, less than or equal to about 4.5:1, less than or equal to about 4:1, less than or equal to about 3.5:1, less than or equal to about 2:1, or less than or equal to about 1.6:1.

In the ink composition of an embodiment, the semiconductor nanoparticle may include a mole ratio of zinc to gallium (Zn:Ga) that may be greater than or equal to about 0.1:1, greater than or equal to about 0.2:1, greater than or equal to about 0.3:1, greater than or equal to about 0.35:1, greater than or equal to about 0.4:1, greater than or equal to about 0.45:1, or greater than or equal to about 0.5:1. In the semiconductor nanoparticle, a mole ratio of zinc to gallium (Zn:Ga) may be less than or equal to about 3:1, less than or equal to about 2.5:1, less than or equal to about 2:1, less than or equal to about 1.9:1, less than or equal to about 1.7:1, less than or equal to about 1.5:1, less than or equal to about 1.4:1, less than or equal to about 1.2:1, less than or equal to about 1.1:1, less than or equal to about 0.9:1, less than or equal to about 0.8:1, less than or equal to about 0.7:1, less than or equal to about 0.6:1, or less than or equal to about 0.49:1.

In the ink composition of an embodiment, the semiconductor nanoparticle may include a mole ratio of zinc to a sum of gallium, indium, and silver [Zn:(Ga+In+Ag)] that may be greater than or equal to about 0.05:1, greater than or equal to about 0.1:1, greater than or equal to about 0.2:1, greater than or equal to about 0.25:1, greater than or equal to about 0.3:1, greater than or equal to about 0.35:1, or greater than or equal to about 0.4:1. In the semiconductor nanoparticle, a mole ratio of zinc to a sum of gallium, indium, and silver [Zn:(Ga+In+Ag)] may be less than or equal to about 2:1, less than or equal to about 1.7:1, less than or equal to about 1.4:1, less than or equal to about 1.1:1, less than or equal to about 0.9:1, less than or equal to about 0.7:1, less than or equal to about 0.5:1, or less than or equal to about 0.45:1.

In the ink composition of an embodiment, the semiconductor nanoparticle may include a mole ratio of zinc to a sum of gallium and indium [Zn:(Ga+In)] that may be greater than or equal to about 0.05:1, greater than or equal to about 0.1:1, greater than or equal to about 0.2:1, greater than or equal to about 0.25:1, greater than or equal to about 0.3:1, greater than or equal to about 0.35:1, or greater than or equal to about 0.4:1. In the semiconductor nanoparticle, a mole ratio of zinc to a sum of gallium and indium [Zn:(Ga+In)] may be less than or equal to about 2:1, less than or equal to about 1.7:1, less than or equal to about 1.4:1, less than or equal to about 1.1:1, less than or equal to about 0.9:1, less than or equal to about 0.7:1, less than or equal to about 0.5:1, or less than or equal to about 0.45:1.

An amount of the semiconductor nanoparticle in the ink composition or in the composite may be appropriately adjusted taking into consideration a desired end use (for example, a use as a luminescent type color filter). In an embodiment, an amount of the semiconductor nanoparticle in the ink composition (or composite) may be greater than or equal to about 1 wt%, for example, greater than or equal to about 2 wt%, greater than or equal to about 3 wt%, greater than or equal to about 4 wt%, greater than or equal to about 5 wt%, greater than or equal to about 6 wt%, greater than or equal to about 7 wt%, greater than or equal to about 8 wt%, greater than or equal to about 9 wt%, greater than or equal to about 10 wt%, greater than or equal to about 15 wt%, greater than or equal to about 20 wt%, greater than or equal to about 25 wt%, greater than or equal to about 30 wt%, greater than or equal to about 35 wt%, or greater than or equal to about 40 wt%, based on the solid content of the composition or composite (hereinafter, the solid content may be a solid content of the

composition or a solid content of the composite). The amount of the semiconductor nanoparticle may be less than or equal to about 70 wt%, for example, less than or equal to about 65 wt%, less than or equal to about 60 wt%, less than or equal to about 55 wt%, or less than or equal to about 50 wt%, based on the solid content. A weight percentage of a given component with respect to a total solid content in a composition may represent an amount of the given component in the composite as described herein. In an embodiment of the ink composition, a polymerizable monomer (e.g., monomer) may include a compound containing one or more carbon-carbon double bonds (e.g., greater than or equal to 2, or greater than or equal to three, and less than or equal to ten carbon-carbon double bonds). The monomer may be a precursor for an insulating polymer. The monomer may be polymerized by using light or heat.

In the ink composition, the monomer may include a compound represented by Chemical Formula 1:

Chemical Formula 1

$$L - [Y-(X)_n]_k$$

in Chemical Formula 1, X is a C2 to C30 organic group having a carbon-carbon double bond,

L is a single bond, a carbon atom, a substituted or unsubstituted C1 to C50 alkylene group, a substituted or unsubstituted C2 to C50 alkenylene group, a substituted or unsubstituted C3 to C50 (e.g. C6-C30) cycloalkylene group, a substituted or unsubstituted C3 to C50 (e.g. C6-C30) cycloalkenylene group, a substituted or unsubstituted C6 to C50 arylene group, a substituted or unsubstituted C3 to C30 heteroarylene group, a group having at least one oxyalkylene unit [e.g., (R-O)n where R is a substituted or unsubstituted C1 to C10 alkylene such as methylene, ethylene, isopropylene, butylene, and n is greater than or equal to about 1, greater than or equal to about 3, greater than or equal to about 5, or greater than or equal to about 10 and less than or equal to about 500, less than or equal to about 300, less than or equal to about 100, less than or equal to about 50, less than or equal to about or 15 or less], a sulfonyl group ($-S(=O)_2-$), a carbonyl group (-C(=O)-), an ether group (-O-), a sulfide group (-S-), a sulfoxide group (-S(=O)-), an ester group (-C(=O)O-), an amide group (-C(=O)NR-) (where R is hydrogen or a linear or branched alkyl group of C1 to C10), an imine group (-NR-) (where R is hydrogen or a linear or branched alkyl group of C1 to C10) or a combination thereof,

Y is a single bond, a substituted or unsubstituted C1 to C50 alkylene group, a substituted or unsubstituted C2 to C50 alkenylene group, a sulfonyl group ($-S(=O)_2-$), a carbonyl group (-C(=O)-), an ether group (-O-), a sulfide group (-S-), a sulfoxide group (-S(=O)-), an ester group (-C(=O)O-), an amide group (-C(=O)NR-) (where R is hydrogen or a linear or branched alkyl group of C1 to C10), an imine group (-NR-) (where R is hydrogen or a linear or branched alkyl group of C1 to C10) or a combination thereof,

n is an integer greater than 1,

k is an integer of 1 or more,

The sum of n and k is an integer of 2 or more (e.g., 3 or more, or 4 or more and 10 or less, or 5 or less).

In Chemical Formula 1, n may be determined by a valence of Y, and k may be determined by a valence of L.

In Chemical Formula 1, X may include a vinyl group, a (meth)acrylate group, or a combination thereof.

The monomer may include a polyethylene glycol methacrylate, a polypropylene glycol methacrylate, a polyethylene glycol dimethacrylate, a polypropylene glycol dimethacrylate, a substituted or unsubstituted alkyl(meth)acrylate, an ethylene glycol di(meth)acrylate, a triethylene glycol di(meth)acrylate, a diethylene glycol di(meth)acrylate, a dipropylene glycol di(meth)acrylate, a 1,4-butanedialdi(meth)acrylate, a 1,6-hexanedialdi(meth)acrylate, a neopentyl glycol di(meth)acrylate, a pentaerythritol di(meth)acrylate, a pentaerythritol tri(meth)acrylate, a pentaerythritol tetra(meth)acrylate, a dipentaerythritol di(meth)acrylate, a dipentaerythritol(meth)acrylate, a dipentaerythritol penta(meth)acrylate, a dipentaerythritol pentaacrylate, a dipentaerythritol hexa(meth)acrylate, a bisphenol A epoxy acrylate, a bisphenol A di(meth)acrylate, a trimethylolpropane tri(meth)acrylate, a novolacepoxy(meth)acrylate, an ethyl glycol monomethyl ether(meth)acrylate, a tris(meth)acryloyloxyethyl phosphate, a propylene glycol di(meth)acrylate, a diacryloyloxyalkane, or a combination thereof.

In an embodiment, the monomer may include a photopolymerizable monomer. The monomer may include a substituted or unsubstituted di(meth)acrylate compound, a substituted or unsubstituted tri(meth)acrylate compound, a substituted or unsubstituted tetra(meth)acrylate compound, a substituted or unsubstituted penta(meth)acrylate compound, a substituted or unsubstituted hexa(meth)acrylate compound, or a combination thereof.

An amount of the polymerizable monomer, based on a total weight of the ink composition, may be greater than or equal to about 0.5 wt%, for example, greater than or equal to about 1 wt%, greater than or equal to about 2 wt%, greater than or equal to about 3 wt%, greater than or equal to about 5 wt%, greater than or equal to about 10 wt%, greater than or equal to about 20 wt%, greater than or equal to about 30 wt%, or greater than or equal to about 40 wt%. An amount of the polymerizable monomer, based on the total weight of the ink composition, may be less than or equal to about 99 wt%, less

than or equal to about 90 wt%, less than or equal to about 80 wt%, less than or equal to about 70 wt%, less than or equal to about 60 wt%, less than or equal to about 50 wt%, less than or equal to about 45 wt%, less than or equal to about 28 wt%, less than or equal to about 25 wt%, less than or equal to about 23 wt%, less than or equal to about 20 wt%, less than or equal to about 18 wt%, less than or equal to about 17 wt%, less than or equal to about 16 wt%, or less than or equal to about 15 wt%.

The ink composition may further include an initiator, a metal oxide (nano)particle, or a combination thereof.

The (photo)initiator included in the ink composition may be used for (photo)polymerization of the aforementioned monomer. The initiator is a compound accelerating a radical reaction (e.g., radical polymerization of monomer) by producing radical chemical species under a mild condition (e.g., by heat or light). The initiator may be a thermal initiator or a photoinitiator. The initiator is not particularly limited and may be appropriately selected.

In the ink composition, an amount of the initiator may be appropriately adjusted considering types and contents of the polymerizable monomers. In an embodiment, The amount of the initiator may be greater than or equal to about 0.01 wt%, for example, greater than or equal to about 1 wt%, and/or less than or equal to about 10 wt%, for example, less than or equal to about 9 wt%, less than or equal to about 8 wt%, less than or equal to about 7 wt%, less than or equal to about 6 wt%, or less than or equal to about 5 wt%, based on the total weight of the ink composition (or the total weight of the solid content), but embodiments are not limited thereto.

The thermal initiator may include azobisisobutyronitrile, benzoyl peroxide, or the like, but is not limited thereto. The photoinitiator may include, but is not limited to, a triazine-based compound, an acetophenone compound, a benzophenone compound, a thioxanthone compound, an oxime ester compound, an amino ketone compound, a phosphine or a phosphine oxide compound, a carbazole-based compound, a diketone-based compound, a sulfonium borate-based compound, a diazo-based compound, a biimidazole-based compound, or a combination thereof. The initiator may include Igacure 754, hydroxycyclohexyl phenyl ketone (Irgacure 184, CAS 947-19-3), 2,4,6-Trimethylbenzoyl diphenylphosphine oxide (Irgacure TPO, CAS 75980-60-8), oxyphenyl-acetic acid 2[2-oxo-2-phenyl-acetoxy-ethoxy]-ethyl ester, or a combination thereof.

In the ink composition, an amount of the initiator may be appropriately adjusted considering types and contents of the polymerizable monomers. In an embodiment, the amount of the initiator may be greater than or equal to about 0.01 wt%, for example, greater than or equal to about 1 wt%, and/or less than or equal to about 10 wt%, for example, less than or equal to about 9 wt%, less than or equal to about 8 wt%, less than or equal to about 7 wt%, less than or equal to about 6 wt%, or less than or equal to about 5 wt%, based on the total weight of the ink composition (or the total weight of the solid content), but embodiments are not limited thereto.

The metal oxide particle may include $TiO_2$, $SiO_2$, $BaTiO_3$, $Ba_2TiO_4$, ZnO, or a combination thereof. In the ink composition (or composite), an amount of the metal oxide may be greater than or equal to about 1 wt%, greater than or equal to about 2 wt%, greater than or equal to about 3 wt%, greater than or equal to about 5 wt%, or greater than or equal to about 10 wt% to less than or equal to about 50 wt%, less than or equal to about 40 wt%, less than or equal to about 30 wt%, less than or equal to about 25 wt%, less than or equal to about 20 wt%, less than or equal to about 15 wt%, less than or equal to about 10 wt%, less than or equal to about 7 wt%, less than or equal to about 5 wt%, or less than or equal to about 3 wt%, based on the total solid content.

A diameter of the metal oxide fine particle is not particularly limited, and may be appropriately selected. The diameter of the metal oxide fine particle may be greater than or equal to about 100 nm, for example greater than or equal to about 150 nm, or greater than or equal to about 200 nm and less than or equal to about 1000 nm, or less than or equal to about 800 nm.

The ink composition according to an embodiment may provide a semiconductor nanoparticle-polymer composite (e.g., composite) or pattern thereof via polymerization (e.g., photopolymerization). In an embodiment, the composite that includes a matrix and the aforementioned semiconductor nanoparticle (e.g., nanoparticle) dispersed in the matrix is provided. An embodiment containing the nanoparticle(s) or the composite can emit light of a desired wavelength (e.g., a first light) with an improved optical property (e.g., an increased light emitting efficiency and a narrower full width at half maximum) along with an increased level of blue light absorption (e.g., improved incident light absorption). The composite may be in a form of a sheet. The composite may be in a form of a patterned film.

In an aspect, the semiconductor nanoparticle-polymer composite comprises a polymerization product of a polymerizable monomer and a semiconductor nanoparticle,

wherein the semiconductor nanoparticle comprises

zinc, and
a Group 11-13-16 compound comprising silver, a Group 13 metal, and a Group 16 element,
wherein the Group 13 metal comprises indium and gallium,
wherein the Group 16 element comprises sulfur, and

a first organic ligand comprising a compound or a moiety represented by $R_1$-COO-A,
wherein $R_1$ is a first organic group, and A is hydrogen or a portion linked to a surface of the semiconductor nanoparticle.
In the semiconductor nanoparticle-polymer composite, the semiconductor nanoparticle may be for example colloidally dispersed in the polymerization product.

The (polymer) matrix may include a polymerization product of the polymerizable monomer. The matrix may include a linear polymer, a crosslinked polymer, or a combination thereof. The crosslinked polymer may include a thiolene resin, a crosslinked poly(meth)acrylate, a crosslinked polyurethane, a crosslinked epoxy resin, a crosslinked vinyl polymer, a crosslinked silicone resin, or a combination thereof. In an embodiment, the crosslinked polymer may include a polymerization product of the polymerizable monomer and optionally a multiple thiol compound.

The linear polymer may include a repeating unit derived from a carbon - carbon unsaturated bond (e.g., a carbon-carbon double bond). The repeating unit may include a carboxylic acid group. The linear polymer may include an ethylene repeating unit. The carboxylic acid group-containing repeating unit may include a unit derived from a monomer including a carboxylic acid group and a carbon-carbon double bond, a unit derived from a monomer having a dianhydride moiety, or a combination thereof. The linear polymer may be an alkali-soluble polymeric binder or resin. The ink composition of an embodiment may not include an alkali-soluble polymeric binder or resin.

In the semiconductor nanoparticle-polymer composite (e.g., a first composite) of one or more embodiments, the (polymer) matrix may include the components described herein with respect to the composition. In the composite, an amount of the matrix, based on a total weight of the composite, may be greater than or equal to about 10 wt%, greater than or equal to about 20 wt%, greater than or equal to about 30 wt%, greater than or equal to about 40 wt%, greater than or equal to about 50 wt%, or greater than or equal to about 60 wt%. The amount of the matrix may be, based on a total weight of the composite, less than or equal to about 95 wt%, less than or equal to about 90 wt%, less than or equal to about 80 wt%, less than or equal to about 70 wt%, less than or equal to about 60 wt%, or less than or equal to about 50 wt%.

The composite may have, for example, a predetermined thickness and include a predetermined amount of the semiconductor nanoparticle. The ink composition or the composite prepared therefrom may include a film form having a thickness of less than or equal to about 10 micrometers. The composite may be in the form of a film or pattern, and the thickness of the composite may be, for example, less than or equal to about 30 μm, less than or equal to about 25 μm, less than or equal to about 20 μm, less than or equal to about 15 μm, less than or equal to about 10 μm, less than or equal to about 8 μm, or less than or equal to about 7 μm and greater than about 2 μm, for example, greater than or equal to about 3 μm, greater than or equal to about 3.5 μm, greater than or equal to about 4 μm, greater than or equal to about 5 μm, greater than or equal to about 6 μm, greater than or equal to about 7 μm, greater than or equal to about 8 μm, greater than or equal to about 9 μm, or greater than or equal to about 10 μm.

The ink composition or the composite prepared therefrom may exhibit an increased incident light (e.g., blue light) absorbance. An incident light absorbance of the composite may be greater than or equal to about 70%, greater than or equal to about 73%, greater than or equal to about 75%, greater than or equal to about 77%, greater than or equal to about 78%, greater than or equal to about 80%, greater than or equal to about 83%, greater than or equal to about 85%, greater than or equal to about 87%, greater than or equal to about 90%, greater than or equal to about 93%, greater than or equal to about 94%, greater than or equal to about 95%, greater than or equal to about 96%, greater than or equal to about 97%, greater than or equal to about 98%, or greater than or equal to about 99%. The blue light absorbance of the composite may be about 70% to about 100%, about 80% to about 98%, about 95% to about 99%, about 96% to about 98%, or a combination thereof. The incident light absorbance may be determined using Equation 2:

Equation 2

$$\text{incident light absorbance} = [(B-B')/B] \times 100\ (\%)$$

wherein, in Equation 2,

B is an amount of incident light provided to the composite, and
B' is an amount of incident light passing through the composite.

The ink composition may be configured to form a composite via a polymerization and may exhibit a quantum efficiency maintenance of greater than or equal to about 50%, greater than or equal to about 51%, greater than or equal to about 55%, greater than or equal to about 57%, greater than or equal to about 60%, greater than or equal to about 65%, greater than or equal to about 70%, greater than or equal to about 75%, greater than or equal to about 80%, greater than or equal to about 85%, greater than or equal to about 88%, or greater than or equal to about 90%, wherein the quantum efficiency maintenance is defined by Equation 1-1:

Equation 1-1

$$\text{quantum efficiency maintenance (\%)} = [D/C] \times 100\%$$

wherein, C: a quantum efficiency of a semiconductor nanoparticle (for example, in an ink composition)
D: a quantum efficiency of a composite including the semiconductor nanoparticle.

The quantum efficiency maintenance may be from about 88% to about100%, from about 90% to about 99%, from about 93% to about 97%, or a combination thereof.

The ink composition may be configured to form a composite via a polymerization and may exhibit a process maintenance of greater than or equal to about 50%, greater than or equal to about 51%, greater than or equal to about 55%, greater than or equal to about 57%, greater than or equal to about 60%, greater than or equal to about 65%, greater than or equal to about 70%, greater than or equal to about 75%, greater than or equal to about 80%, greater than or equal to about 85%, greater than or equal to about 88%, or greater than or equal to about 90%, wherein the process maintenance is defined by Equation 1-2:

Equation 1-2

$$\text{process maintenance (\%)} = [F/E] \times 100\%$$

wherein, E: a quantum efficiency of a semiconductor nanoparticle polymer composite after a (photo)polymerization
F: a quantum efficiency of a semiconductor nanoparticle polymer composite after a heat treatment at 180 °C for 30 minutes.

The process maintenance may be from about 88% to about 100%, from about 90% to about 99%, from about 93% to about 97%, or a combination thereof.

In an embodiment, the composite or the semiconductor nanoparticle included therein may exhibit a quantum efficiency or a photoconversion efficiency defined by the following equation of greater than or equal to about 50%, greater than or equal to about 55%, greater than or equal to about 60%, greater than or equal to about 63%, greater than or equal to about 69%, or greater than or equal to about 75%:

$$\text{Quantum efficiency or photoconversion efficiency} = [A/(B-B')] \times 100\%$$

wherein, A is an amount of a first light emitted from the composite,
B is an amount of incident light provided to the composite, and
B' is an amount of incident light passing through the composite.

In an embodiment, the composite may be used for a sheet containing light-emitting particles disposed on a light source or a color conversion panel (e.g., a light-emitting color filter).

Accordingly, an embodiment provides a color conversion layer (e.g., a color conversion structure) or a color conversion panel including the same. The color conversion layer or the color conversion structure may include the composite of an embodiment or a patterned film of the composite. The color conversion layer may include a color conversion region.

The color conversion region may include a first region configured to emit a first light (or a green light) (e.g., by irradiation with an incident light). In an embodiment, the first region may correspond to a green pixel. The first region includes a first composite (e.g., the luminescence type composite described herein). The first light may have a peak emission wavelength within a wavelength range to be described herein. The first light may be a green light. The peak emission wavelength of the green light may be greater than or equal to about 500 nm, greater than or equal to about 501 nm, greater than or equal to about 504 nm, greater than or equal to about 505 nm, or greater than or equal to about 520 nm. The peak emission wavelength of the green light may be less than or equal to about 580 nm, less than or equal to about 560 nm, less than or equal to about 550 nm, less than or equal to about 530 nm, less than or equal to about 525 nm, less than or equal to about 520 nm, less than or equal to about 515 nm, or less than or equal to about 510 nm.

The color conversion region may further include a second region that is configured to emit a second light (e.g., a red light) different from the first light (e.g., by irradiation with an incident light). The second region may include a second composite. The semiconductor nanoparticle composite in the second region may include a semiconductor nanoparticle (e.g., a quantum dot) being configured to emit a light of a different wavelength (e.g., a different color) from the

semiconductor nanoparticle composite disposed in the first region.

The second light may be a red light having a peak emission wavelength of about 600 nm to about 650 nm (e.g., about 620 nm to about 650 nm).

The color conversion panel may further include one or more third regions that emit or pass a third light (e.g., a blue light) different from the first light and the second light. An incident light may include the third light (e.g., a blue light and optionally a green light). The third light may include a blue light having a peak emission wavelength of greater than or equal to about 380 nm (e.g., greater than or equal to about 440 nm, greater than or equal to about 445 nm, greater than or equal to about 450 nm, or greater than or equal to about 455 nm) to less than or equal to about 480 nm (e.g., less than or equal to about 475 nm, less than or equal to about 470 nm, less than or equal to about 465 nm, or less than or equal to about 460 nm).

FIG. 1A is a schematic cross-sectional view of a color conversion panel according to one or more embodiments. Referring to FIG. 1A, the color conversion panel may optionally further include a partition wall (e.g., a black matrix (BM), a bank, or a combination thereof) that defines each region of the color conversion layer (e.g., a color conversion structure). FIG. 1B illustrates an electronic device (a display device) including a color conversion panel and a light source according to another embodiment. In the electronic device of one or more embodiments, a color conversion panel including a color conversion layer or a color conversion structure may be disposed on an light emitting diode (LED) on chip (e.g., a micro LED on chip). Referring to FIG. 1B, a circuit (Si driver IC) configured to drive the light source may be disposed under a light source (e.g., a blue LED) configured to emit an incident light (e.g., a blue light). The color conversion layer may include a first composite including a plurality of semiconductor nanoparticles emitting a first light (e.g., a green light), and a second composite including a plurality of semiconductor nanoparticles emitting a second light (e.g., a red light), or a third composite that emits or passes a third light (e.g., incident light or a blue light). A partition wall PW (e.g., including an inorganic material such as silicon or silicon oxide, or based on an organic material) may be disposed between respective composites. The partition wall may include a trench hole, a via hole, or a combination thereof. A first optical element (e.g., an absorption type color filter) may be disposed on a light extraction surface of a color conversion layer. An additional optical element such as a micro lens may be further disposed on the first optical element.

In an embodiment, the color conversion layer or a patterned film of the semiconductor nanoparticle composite may be prepared using the ink composition, for example, in an inkjet printing manner. Referring to FIG. 2, such a method may include preparing an ink composition according to one or more embodiments, providing a substrate (e.g., with pixel areas patterned by electrodes and optionally banks or trench type partition walls, or the like), and depositing an ink composition on the substrate (or the pixel area) to form, for example, a first composite layer (or a first region). The method may further include depositing an ink composition on the substrate (or the pixel area) to form, for example, a second composite layer (or second region). The forming of the first composite layer and forming of the second composite layer may be simultaneously or sequentially carried out.

The depositing of the ink composition may be performed using an appropriate liquid crystal discharger, for example, an inkjet or nozzle printing system (having an ink storage and at least one print head). The deposited ink composition may provide a (first or second) composite layer through the solvent removal and polymerization by the heating. The method may provide a highly precise nanoparticle-polymer composite film or patterned film for a short time by the simple method.

The semiconductor nanoparticle, the composite (or the pattern thereof) including the semiconductor nanoparticle, or the color conversion panel including the same may be included in an electronic device. Such an electronic device or apparatus may include a display device, a light emitting diode (LED), an organic light emitting diode (OLED), a quantum dot LED, a sensor, a solar cell, an imaging sensor, a photodetector, or a liquid crystal display device, but is not limited thereto. The aforementioned quantum dot may be included in an electronic device or apparatus. Such an electronic device or apparatus may include, but is not limited to, a portable terminal device, a monitor, a notebook personal computer (PC), a television, an electric sign board, a camera, a car, or the like, but embodiments are not limited thereto. The electronic apparatus may be a portable terminal device, a monitor, a note PC, or a television, including a display device (or a light emitting device) including quantum dots. The electronic device or apparatus may be a camera or a mobile terminal device including an image sensor including quantum dots. The electronic device or apparatus may be a camera or a vehicle including a photodetector including quantum dots.

In an embodiment, the electronic device or the display device (e.g., display panel) may further include a color conversion layer (or a color conversion panel) and optionally, a light source. The light source may be configured to provide incident light to the color conversion layer or the color conversion panel. In an embodiment, the display panel may include a light emitting panel (or a light source), the aforementioned color conversion panel, a light transmitting layer located between the aforementioned light emitting panel and the aforementioned color conversion panel. The color conversion panel includes a substrate, and the color conversion layer may be disposed on the substrate. (see FIGS. 3A and 4)

In an embodiment, the light source or the light emitting panel may be configured to provide an incident light to the color conversion layer or the color conversion panel. The incident light may have a peak emission wavelength of greater than or equal to about 440 nm, for example, greater than or equal to about 450 nm to less than or equal to about 580 nm, for

example, less than or equal to about 480 nm, less than or equal to about 470 nm, or less than or equal to about 460 nm.

In an embodiment, the electronic device (e.g., a photoluminescent device) may further include a sheet of the nanoparticle composite. Referring to FIG. 3B, the device 400 may include a backlight unit 410 and a liquid crystal panel 420, wherein the backlight unit 410 may include a quantum dot polymer composite sheet (QD sheet). Specifically, the backlight unit 410 may have a structure that a reflector, a light guide plate (LGP), a light source (a blue LED or the like), the quantum dot polymer composite sheet (QD sheet), and an optical film (a prism, a double brightness enhance film (DBEF, or the like) are stacked. The liquid crystal panel 420 may be disposed on the backlight unit 410 and have a structure where a thin film transistor (TFT), liquid crystals (LC), and a color filter are included between two polarizers (Pol). The quantum dot polymer composite sheet (QD sheet) may include semiconductor nanoparticles (e.g., quantum dots) emitting a red light and a green light after absorbing light from the light source. Blue light provided from the light source may be combined with the red light and the green light emitted from the semiconductor nanoparticles, while passing the quantum dot polymer composite sheet, and converted into a white light. This white light may be separated into a blue light, a green light, and a red light by a color filter in the liquid crystal panel, and then emitted to the outside for each pixel.

The color conversion panel may include a substrate, and the color conversion layer may be disposed on the substrate. The color conversion layer or the color conversion panel may include a patterned film of the nanoparticle composite. The patterned film may include a repeating section that is configured to emit a light of a desired wavelength. The repeating section may include a second region. The second region may be a red light-emitting section. The repeating section may include a first region. The first region may be a green light-emitting section. The repeating section may include a third region. The third region may include a section that emits or transmits a blue light. Details of the first, second, and third regions are as described herein.

The light emitting panel or the light source may be an element emitting an incident light (e.g., an excitation light). The incident light may include a blue light and optionally, a green light. The light source may include an LED. The light source may include an organic LED (OLED). The light source may include a micro LED. On the front surface (light emitting surface) of the first region and the second region, an optical element to block (e.g., reflect or absorb) a blue light (and optionally a green light) for example, a blue light (and optionally a green light) blocking layer or a first optical filter that will be described herein may be disposed. In an embodiment, the light source may include an organic light emitting diode to emit a blue light and an organic light emitting diode to emit a green light, a green light removing filter may be further disposed on a third region through which the blue light is transmitted.

The light emitting panel or the light source may include a plurality of light emitting units respectively corresponding to the first region and the second region, and the light emitting units may include a first electrode and a second electrode facing each other and an (organic) electroluminescent layer located between the first electrode and the second electrode. The electroluminescent layer may include an organic light emitting material. For example, each light emitting unit of the light source may include an electroluminescent device (e.g., an organic light emitting diode (OLED)) structured to emit a light of a predetermined wavelength (e.g., a blue light, a green light, or a combination thereof). Structures and materials of the electroluminescent device and the organic light emitting diode (OLED) are not particularly limited.

Hereinafter, the display panel and the color conversion panel will be described in further detail with reference to the drawings.

FIG. 3A is a perspective view of an embodiment of a display panel constructed as described herein. FIG. 4 is a cross-sectional view of the display panel of FIG. 3A. Referring to FIGS. 3A and 4, the display panel 1000 according to an embodiment includes a light emitting panel 40 and a color conversion panel 50. The display panel or the electronic device may further include a light transmitting layer 60 disposed between the light emitting panel 40 and the color conversion panel 50, and a binding material 70 binding the light emitting panel 40 and the color conversion panel 50. The light transmitting layer may include a passivation layer, a filling material, an encapsulation layer, or a combination thereof (not shown). A material for the light transmitting layer may be appropriately selected without particular limitation. The material for the light transmitting layer may be an inorganic material, an organic material, an organic/inorganic hybrid material, or a combination thereof.

The light emitting panel 40 and the color conversion panel 50 each have a surface opposite the other, i.e., the two respective panels face each other, with the light transmitting layer (or the light transmitting panel) 60 disposed between the two panels. The color conversion panel 50 is disposed in a direction such that for example, light emitting from the light emitting panel 40 irradiates the light transmitting layer 60. The binding material 70 may be disposed along edges of the light emitting panel 40 and the color conversion panel 50, and may be, for example, a sealing material.

FIG. 5A is a plan view of an embodiment of a pixel arrangement of a display panel of one or more embodiments. Referring to FIG. 5A, the display panel 1000 includes a display area 1000D displaying an image and a non-display area 1000P positioned in a peripheral area of the display area 1000D and disposed with a binding material.

The display area 1000D includes a plurality of pixels PX arranged along with a row (e.g., an x direction), column (e.g., a y direction), and each representative pixel PX may include a plurality of sub-pixels $PX_1$, $PX_2$, and $PX_3$ expressing (e.g., displaying) different colors from each other. An embodiment is exemplified with a structure in which three sub-pixels $PX_1$, $PX_2$, and $PX_3$ are configured to provide a pixel. An embodiment may further include an additional sub-pixel such as a

white sub-pixel and may further include at least one sub-pixel expressing (e.g., displaying) the same color. The plurality of pixels PX may be aligned, for example, in a Bayer matrix, a matrix sold under the trade designation PenTile, a diamond matrix, or the like, or a combination thereof.

The sub-pixels $PX_1$, $PX_2$, and $PX_3$ may express, e.g., display, three primary colors or a color of a combination of three primary colors, for example, may express, e.g., display, a color of red, green, blue, or a combination thereof. For example, the first sub-pixel $PX_1$ may express, e.g., display, a red color, and the second sub-pixel $PX_2$ may express, e.g., display, a green color, and the third sub-pixel $PX_3$ may express, e.g., display, a blue color.

In the drawing, all sub-pixels are exemplified to have the same size, but embodiments are not limited thereto, and at least one of the sub-pixels may be larger or smaller than other sub-pixels. In the drawings, all sub-pixels are exemplified to have the same shape, but it is not limited thereto and at least one of the sub-pixels may have different shape from other sub-pixels.

In the display panel or electronic device according to the embodiment, the light emitting panel may include a substrate and a TFT (e.g., oxide-containing) disposed on the substrate. A light emitting device (e.g., having a tandem structure) may be disposed on the TFT.

The light emitting device may include a light emitting layer (e.g., a blue light emitting layer, a green light emitting layer, or a combination thereof) located between the first electrode and the second electrode facing each other. A charge generation layer may be disposed between each of the light emitting layers. Each of the first electrode and the second electrode may be patterned with a plurality of electrode elements to correspond to the pixel. The first electrode may be an anode or a cathode. The second electrode may be a cathode or an anode.

The light emitting device may include an organic LED, a nanorod LED, a mini LED, a micro LED, or a combination thereof. In an embodiment, "a mini LED" may have a size of greater than or equal to about 100 micrometers, greater than or equal to about 150 micrometers, greater than or equal to about 200 micrometers and less than or equal to about 1 millimeter, less than or equal to about 0.5 millimeters, less than or equal to about 0.15 millimeters, or less than or equal to about 0.12 millimeters, but is not limited thereto. In an embodiment, "a micro LED" may have a size of less than about 100 micrometers, less than or equal to about 50 micrometers, or less than or equal to about 10 micrometers. The size of the micro LED may be greater than or equal to about 0.1 micrometers, greater than or equal to about 0.5 micrometers, greater than or equal to about 1 micrometer, or greater than or equal to about 5 micrometers, but is not limited thereto.

FIGS. 5B to 5E are cross-sectional views showing examples of light emitting devices, respectively.

Referring to FIG. 5B, the light emitting device 180 may include a first electrode 181 and a second electrode 182 facing each other; a light emitting layer 183 located between the first electrode 181 and the second electrode 182; and optionally auxiliary layers 184 and 185 located between the first electrode 181 and the light emitting layer 183, and between the second electrode 182 and the light emitting layer 183, respectively.

The first electrode 181 and the second electrode 182 may be disposed to face each other along a thickness direction (for example, a z direction), and any one of the first electrode 181 and the second electrode 182 may be an anode and the other may be a cathode. The first electrode 181 may be a light transmitting electrode, a semi-transparent electrode, or a reflective electrode, and the second electrode 182 may be a light transmitting electrode or a semi-transparent electrode. The light transmitting electrode or semi-transparent electrode may be, for example, made of a thin single layer or multiple layers of metal thin film including conductive oxides such as indium tin oxide (ITO), indium zinc oxide (IZO), zinc oxide (ZnO), tin oxide (SnO), aluminum tin oxide (AlTO), fluorine-doped tin oxide (FTO), or the like; or silver (Ag), copper (Cu), aluminum (Al), magnesium (Mg), magnesium-silver (Mg-Ag), magnesium-aluminum (Mg-Al), or a combination thereof. The reflective electrode may include a metal, a metal nitride, or a combination thereof, for example, silver (Ag), copper (Cu), aluminum (Al), gold (Au), titanium (Ti), chromium (Cr), nickel (Ni), an alloy thereof, a nitride thereof (e.g., TiN), or a combination thereof, but embodiments are not limited thereto.

The light emitting layer(s) 183 may include a first light emitting body emitting light with a blue emission spectrum, a second light emitting body emitting light with a green emission spectrum, or a combination thereof.

The blue emission spectrum may have a peak emission wavelength in a wavelength region of greater than or equal to about 400 nm to less than about 500 nm, and, within the range, in a wavelength region of about 410 nm to about 490 nm, about 420 nm to about 480 nm, about 430 nm to about 470 nm, about 440 nm to about 465 nm, about 445 nm to about 460 nm, or about 450 nm to about 458 nm.

The green emission spectrum may have a peak emission wavelength in a wavelength region of greater than or equal to about 500 nm to less than about 590 nm, and, within the range, in a wavelength region of about 510 nm to about 580 nm, about 515 nm to about 570 nm, about 520 nm to about 560 nm, about 525 nm to about 555 nm, about 530 nm to about 550 nm, about 535 nm to about 545 nm, or a combination thereof.

In an embodiment, the light emitting layer 183 or the light emitting body included therein may include a phosphorescent material, a fluorescent material, or a combination thereof. In an embodiment, the light emitting body may include an organic light emitting body, wherein the organic light emitting body may be a low molecular compound, a polymer compound, or a combination thereof. Specific types of the phosphorescent material and the fluorescent material are not particularly limited, but may be appropriately selected from known materials. In an embodiment, the light emitting

body may include an inorganic light emitting body, and the inorganic light emitting body may be an inorganic semiconductor, a quantum dot, a perovskite, or a combination thereof. The inorganic semiconductor may include a metal nitride, a metal oxide, or a combination thereof. The metal nitride, the metal oxide, or the combination thereof may include a Group III metal such as aluminum, gallium, indium, thallium, a Group IV metal such as silicon, germanium, tin, or a combination thereof. In an embodiment, the light emitting body may include an inorganic light emitting body, and the light emitting device 180 may be a quantum dot light emitting diode, a perovskite light emitting diode, or a micro light emitting diode (μLED). Materials usable as the inorganic light emitting body may be selected appropriately.

In an embodiment, the light emitting device 180 may further include auxiliary layers 184 and 185. The auxiliary layers 184 and 185 may be disposed between a first electrode 181 and a light emitting layer 183, and/or between a second electrode 182 and a light emitting layer 183, respectively. The auxiliary layers 184 and 185 may be charge auxiliary layers for controlling injection and/or mobility of charges. The auxiliary layers 184 and 185 may include at least one layer or two layers, respectively, and for example, may include a hole injection layer, a hole transport layer, an electron blocking layer, an electron injection layer, an electron transport layer, a hole blocking layer, or a combination thereof. At least one of the auxiliary layers 184 and 185 may be omitted, if desired. The auxiliary layers 184 and 185 may be formed of a material appropriately selected from materials known for an organic electroluminescent device or the like.

The light emitting devices 180 disposed in each of the subpixels $PX_1$, $PX_2$, and $PX_3$ may be the same or different from each other. The light emitting devices 180 in each of the subpixels $PX_1$, $PX_2$, and $PX_3$ may emit a light having the same or different emission spectra. The light emitting devices 180 in each of the subpixels $PX_1$, $PX_2$, and $PX_3$ may emit, for example, light having a blue emission spectrum, light having a green emission spectrum, or a combination thereof. The light emitting devices 180 in each of the subpixels $PX_1$, $PX_2$, and $PX_3$ may be separated by a pixel defining layer (not shown).

Referring to FIG. 5C, the light emitting device 180 may be a light emitting device having a tandem structure, and includes a first electrode 181 and a second electrode 182 facing each other; a first light emitting layer 183a and a second light emitting layer 183b located between the first electrode 181 and the second electrode 182; a charge generation layer 186 located between the first light emitting layer 183a and the second light emitting layer 183b, and optionally auxiliary layers 184 and 185 located between the first electrode 181 and the first light emitting layer 183a, and/or between the second electrode 182 and the second light emitting layer 183b, respectively.

Details of the first electrode 181, the second electrode 182, and the auxiliary layers 184 and 185 are as described herein.

The first light emitting layer 183a and the second light emitting layer 183b may emit a light having the same or different emission spectra. In an embodiment, the first light emitting layer 183a or the second light emitting layer 183b may emit light having a blue emission spectrum or light having a green emission spectrum, respectively. The charge generation layer 186 may inject an electric charge into the first light emitting layer 183a and/or the second light emitting layer 183b, and may control a charge balance between the first light emitting layer 183a and the second light emitting layer 183b. The charge generation layer 186 may include, for example, an n-type layer and a p-type layer, and may include, for example, an electron transport material and/or a hole transport material including an n-type dopant and/or a p-type dopant. The charge generation layer 186 may include one layer or two or more layers.

Referring to FIG. 5D, a light emitting device (having a tandem structure) may include a first electrode 181 and a second electrode 182 facing each other; a first light emitting layer 183a, a second light emitting layer 183b, and a third light emitting layer 183c located between the first electrode 181 and the second electrode 182; a first charge generation layer 186a located between the first light emitting layer 183a and the second light emitting layer 183b; a second charge generation layer 186b located between the second light emitting layer 183b and the third light emitting layer 183c; and optionally, auxiliary layers 184 and 185 located between the first electrode 181 and the first light emitting layer 183a, and/or located between the second electrode 182 and the third light emitting layer 183c, respectively.

Details of the first electrode 181, the second electrode 182, and the auxiliary layers 184 and 185 are as described herein.

The first light emitting layer 183a, the second light emitting layer 183b, and the third light emitting layer 183c may emit a light having the same or different emission spectra. The first light emitting layer 183a, the second light emitting layer 183b, and the third light emitting layer 183c may emit a blue light. In an embodiment, the first light emitting layer 183a and the third light emitting layer 183c may emit light of a blue emission spectrum, and the second light emitting layer 183b may emit light of a green emission spectrum. In another embodiment, the first light emitting layer 183a and the third light emitting layer 183c may emit light of a green emission spectrum, and the second light emitting layer 183b may emit light of a blue emission spectrum.

The first charge generation layer 186a may inject an electric charge into the first light emitting layer 183a and/or the second light emitting layer 183b, and may control charge balances between the first light emitting layer 183a and the second light emitting layer 183b. The second charge generation layer 186b may inject an electric charge into the second light emitting layer 183b and/or the third light emitting layer 183c, and may control charge balances between the second light emitting layer 183b and the third light emitting layer 183c. Each of the first and second charge generation layers 186a

and 186b may include one layer or two or more layers, respectively.

Referring to FIG. 5E, in an embodiment, the light emitting device 180 includes a light emitting layer 183, a first electrode 181, a second electrode 182, and a plurality of nanostructures 187 arranged in the light emitting layer 183.

One of the first electrode 181 and the second electrode 182 may be an anode and the other may be a cathode. The first electrode 181 and the second electrode 182 may be an electrode patterned according to a direction of an arrangement of the plurality of nanostructures 187, and may include, for example, a conductive oxide such as indium tin oxide (ITO), indium zinc oxide (IZO), zinc oxide (ZnO), tin oxide (SnO), aluminum tin oxide (AlTO), a fluorine-doped tin oxide (FTO), or the like; silver (Ag), copper (Cu), aluminum (Al), gold (Au), titanium (Ti), chromium (Cr), nickel (Ni), an alloy thereof, a nitride thereof (e.g., TiN); or a combination thereof, but embodiments are not limited thereto.

The light emitting layer 183 may include a plurality of nanostructures 187, and each of the subpixels $PX_1$, $PX_2$, and $PX_3$ may include a plurality of nanostructures 187. In an embodiment, the plurality of nanostructures 187 may be arranged in one direction, but the present disclosure is not limited thereto. The nanostructures 187 may be a compound-containing semiconductor that is configured to emit light of a predetermined wavelength for example with an application of an electric current, and may be, for example, a linear nanostructure such as a nanorod or a nanoneedle.

A diameter or a long diameter of the nanostructures 187 may be, for example, several to several hundreds of nanometers, and aspect ratios of the nanostructures 187 may be greater than about 1, greater than or equal to about 1.5, greater than or equal to about 2.0, greater than or equal to about 3.0, greater than or equal to about 4.0, greater than or equal to about 4.5, or greater than or equal to about 5.0, to less than or equal to about 20, about 1.5 to about 20, about 2.0 to about 20, about 3.0 to about 20, about 4.0 to about 20, about 4.5 to about 20, or about 5.0 to about 20.

Each of the nanostructures 187 may include a p-type region 187p, an n-type region 187n, and a multiple quantum well region 187i, and may be configured to emit light from the multiple quantum well region 187i. The nanostructure 187 may include, for example, gallium nitride (GaN), indium gallium nitride (InGaN), aluminum gallium nitride (AlGaN), or a combination thereof, and may have, for example, a core-shell structure.

The plurality of nanostructures 187 may each emit a light having the same or different emission spectra. In an embodiment, the nanostructure may emit light of a blue emission spectrum, for example, light of a blue emission spectrum having a peak emission wavelength in a wavelength region of greater than or equal to about 400 nm to less than 500 nm, about 410 nm to about 490 nm, or about 420 nm to about 480 nm.

FIG. 6 is a schematic cross-sectional view of a device (or a display panel) according to embodiments. Referring to FIG. 6, the light source (or the light emitting panel) may include an organic light emitting diode that emits a blue light (B) (and, optionally a green light(G)). The organic light emitting diode (OLED) may include at least two pixel electrodes 90a, 90b, 90c formed on the substrate 100, a pixel defines layer 150a, 150b formed between the adjacent pixel electrodes 90a, 90b, 90c, an organic light emitting layer 140a, 140b, 140c formed on each pixel electrode 90a, 90b, 90c, and a common electrode layer 130 formed on the organic light emitting layer 140a, 140b, 140c. A thin film transistor (TFT) and a substrate may be disposed under the organic light emitting diode (OLED), which are not shown. Pixel areas of the OLED may be disposed corresponding to the first, second, and third regions as described herein. In an embodiment, the color conversion panel and the light emitting panel may be separated as shown in FIG. 6. In an embodiment, the color conversion panel may be stacked directly on the light emitting panel.

A laminated structure including the luminescent nanostructure composite pattern 170 (e.g., a first region 11 or R including red light emitting luminescent nanostructures, a second region 21 or G including green light emitting luminescent nanostructures, and a third region 31 or B including or not including a luminescent nanostructure, e.g., a blue light emitting luminescent nanostructure) and substrate 240 may be disposed on the light source. The blue light emitted from the light source enters the first region and second region and may emit a red light and a green light, respectively. The blue light emitted from the light source may pass through the third region. An element (first optical filter 160 or excitation light blocking layer) configured to block the excitation light may be disposed between the luminescent nanostructure composite layers R and G and the substrate, if desired. In an embodiment, the excitation light includes a blue light and a green light, and a green light blocking filter (not shown) may be added to the third region. The first optical filter or the excitation light blocking layer will be described in more detail herein.

Such a (display) device may be produced by separately producing the aforementioned laminated structure and LED or OLED (e.g., emitting a blue light) and then combining the laminated structure and LED or OLED. The (display) device may be produced by directly forming the luminescent nanostructure composite pattern on the LED or OLED.

In the color conversion panel or a display device, a substrate may be a substrate including an insulation material. The substrate may include glass; a polymer such as a polyester of poly(ethylene terephthalate) (PET), poly(ethylene naphthalate) (PEN), or the like, a polycarbonate, or a poly(meth)acrylate; a polysiloxane (e.g., PDMS); an inorganic material such as $Al_2O_3$, ZnO, or the like; or a combination thereof, but embodiments are not limited thereto. A thickness of the substrate may be appropriately selected taking into consideration a substrate material, but is not particularly limited. The substrate may have flexibility. The substrate may have a transmittance of greater than or equal to about 50%, greater than or equal to about 60%, greater than or equal to about 70%, greater than or equal to about 80%, or greater than or equal to about 90% for light emitted from the semiconductor nanoparticle.

A wire layer including a thin film transistor or the like may be formed on the substrate. The wire layer may further include a gate line, a sustain voltage line, a gate insulating film, a data line, a source electrode, a drain electrode, a semiconductor layer, a protective layer, or the like, or a combination thereof. The detailed structure of the wire layer may vary depending on one or more embodiments. The gate line and the sustain voltage line may be electrically separated from each other, and the data line is insulated and crossing the gate line and the sustain voltage line. The gate electrode, the source electrode, and the drain electrode may form a control terminal, an input terminal, and an output terminal of the thin film transistor, respectively. The drain electrode may be electrically connected to the pixel electrode that will be described later.

The pixel electrode may function as an electrode (e.g., anode) of the display device. The pixel electrode may be formed of a transparent conductive material such as indium tin oxide (ITO) or indium zinc oxide (IZO). The pixel electrode may be formed of a material having a light blocking property such as gold (Au), platinum (Pt), nickel (Ni), tungsten (W), chromium (Cr), molybdenum (Mo), iron (Fe), cobalt (Co), copper (Cu), palladium (Pd), or titanium (Ti). The pixel electrode may have a two-layered structure where the transparent conductive material and the material having light blocking properties are stacked sequentially.

Between two adjacent pixel electrodes, a pixel define layer (PDL) may overlap with a terminal end of the pixel electrode to divide the pixel electrode into a pixel unit. The pixel define layer is an insulating layer which may electrically block the at least two pixel electrodes.

The pixel define layer may cover a portion of the upper surface of the pixel electrode, and the remaining region of the pixel electrode where it is not covered by the pixel define layer may provide an opening. An organic light emitting layer that will be described herein may be formed on the region defined by the opening.

The organic light emitting layer may define each pixel area by the aforementioned pixel electrode and the pixel define layer. In other words, one pixel area may be defined as an area where it is formed with one organic light emitting unit layer which is contacted with one pixel electrode divided by the pixel define layer. In the display device according to one or more embodiments, the organic light emitting layer may be defined as a first pixel area, a second pixel area, and a third pixel area, and each pixel area may be spaced apart from each other leaving a predetermined interval by the pixel define layer.

In an embodiment, the organic light emitting layer may emit a third light belonging to a visible light region or belonging to an ultraviolet (UV) region. Each of the first to the third pixel areas of the organic light emitting layer may emit a third light. In an embodiment, the third light may be a light having a higher energy in a visible light region, and for example, may be a blue light (and, optionally a green light). In an embodiment, all pixel areas of the organic light emitting layer are designed to emit the same light, and each pixel area of the organic light emitting layer may be formed of the same or similar materials, or may show the same or similar properties. Thus, a process of forming the organic light emitting layer may be simplified, and the display device may be readily applied for, e.g., made by, a large scale/large area process. However, the organic light emitting layer according to an embodiment is not necessarily limited thereto, but the organic light emitting layer may be designed to emit at least two different lights, e.g., at least two different colored lights.

The organic light emitting layer includes an organic light emitting unit layer in each pixel area, and each organic light emitting unit layer may further include an auxiliary layer (e.g., a hole injection layer, a hole transport layer, an electron transport layer, or the like, or a combination thereof) besides the light emitting layer.

The common electrode may function as a cathode of the display device. The common electrode may be formed of a transparent conductive material such as indium tin oxide (ITO) or indium zinc oxide (IZO). The common electrode may be formed on the organic light emitting layer and may be integrated therewith.

A planarization layer or a passivation layer (not shown) may be formed on the common electrode. The planarization layer may include an (e.g., transparent) insulating material for ensuring electrical insulation with the common electrode.

In an embodiment, the display device may further include a lower substrate, a polarizing plate disposed under the lower substrate, and a liquid crystal layer disposed between the laminated structure and the lower substrate, and in the laminated structure, the photoluminescence layer (i.e., light emitting layer) may be disposed to face the liquid crystal layer. The display device may further include a polarizing plate located between the liquid crystal layer and the light emitting layer. The light source may further include LED and if desired, a light guide plate.

In an embodiment, the display device (e.g., a liquid crystal display device) are illustrated with a reference to a drawing. FIG. 7 is a schematic cross-sectional view showing a liquid crystal display device according to one or more embodiments. Referring to FIG. 7, the display device of an embodiment includes a liquid crystal panel 200, a polarizing plate 300 disposed under the liquid crystal panel 200, and a backlight unit disposed under the polarizing plate 300.

The liquid crystal panel 200 may include a lower substrate 210, a stacked structure, and a liquid crystal layer 220 disposed between the stack structure and the lower substrate. The stack structure may include a transparent substrate 240, a first optical filter layer 310, a photoluminescent layer 230 including a pattern of a semiconductor nanoparticle polymer composite, and a second optical filter layer 311.

The lower substrate 210, also referred to as an array substrate, may be a transparent insulating material

substrate. The substrate may be as described herein. A wire plate 211 may be provided on an upper surface of the lower substrate 210. The wire plate 211 may include a plurality of gate lines (not shown) and data lines (not shown) that define a pixel area, a thin film transistor disposed adjacent to a crossing region of gate lines and data lines, and a pixel electrode for each pixel area, but embodiments are not limited thereto. Details of such a wire plate are not particularly limited.

A liquid crystal layer 220 may be provided on the wire plate 211. The liquid crystal panel 200 may include an alignment layer 221 on and under the liquid crystal layer 220 to initially align the liquid crystal material included therein. Details (e.g., a liquid crystal material, an alignment layer material, a method of forming liquid crystal layer, a thickness of liquid crystal layer, or the like) of the liquid crystal layer and the alignment layer are not particularly limited.

A lower polarizing plate 300 may be provided under the lower substrate. Materials and structures of the polarizing plate 300 are not particularly limited. A backlight unit (e.g., emitting a blue light) may be disposed under the polarizing plate 300. An upper optical element or the polarizing plate 300 may be provided between the liquid crystal layer 220 and the transparent substrate 240, but embodiments are not limited thereto. For example, the upper polarizing plate may be disposed between the liquid crystal layer 220 and the photoluminescent layer 230. The polarizing plate may be any suitable polarizer that can be used in a liquid crystal display device. The polarizing plate may be triacetyl cellulose (TAC) having a thickness of less than or equal to about 200 μm, but embodiments are not limited thereto. In another embodiment, the upper optical element may be a coating that controls a refractive index without a polarization function.

The backlight unit includes a light source 110. The light source may emit a blue light or a white light. The light source may include, but is not limited to, a blue LED, a white LED, a white OLED, or a combination thereof.

The backlight unit may further include a light guide plate 120. In an embodiment, the backlight unit may be of an edge type. For example, the backlight unit may include a reflector (not shown), a light guide plate (not shown) provided on the reflector and providing a planar light source to the liquid crystal panel 200, and/or at least one optical sheet (not shown) on the light guide plate, for example, a diffusion plate, a prism sheet, or the like, but embodiments are not limited thereto. The backlight unit may not include a light guide plate. In an embodiment, the backlight unit may be a direct lighting. For example, the backlight unit may have a reflector (not shown) and a plurality of fluorescent lamps on the reflector at regular intervals, or may have an LED operating substrate on which a plurality of light emitting diodes, a diffusion plate thereon, and optionally at least one optical sheet may be disposed. Details (e.g., each component of a light emitting diode, a fluorescent lamp, a light guide plate, various optical sheets, and a reflector) of such a backlight unit are known and are not particularly limited.

A black matrix 241 may be provided under the transparent substrate 240 and has openings and hides a gate line, a data line, and a thin film transistor of the wire plate on the lower substrate. For example, the black matrix 241 may have a grid shape. The photoluminescent layer 230 may be provided in the opening of the black matrix 241 and may include a nanoparticle-polymer composite pattern including a first region R configured to emit a first light (e.g., a red light), a second region G configured to emit a second light (e.g., a green light), and a third region B configured to emit/transmit a third light, for example a blue light. If desired, the photoluminescent layer may further include at least one fourth region. The fourth region may include a quantum dot that emits light of a different color from the light emitted from the first to third regions (e.g., cyan, magenta, and yellow light).

In the photoluminescent layer 230, sections forming the pattern may be repeated corresponding to pixel areas formed on the lower substrate. A transparent common electrode 231 may be provided on the photoluminescent layer 230.

The third region B configured to emit/transmit a blue light may be a transparent color filter that does not change the emission spectrum of the light source. In this case, the blue light emitted from the backlight unit may enter in a polarized state and may be emitted through the polarizing plate and the liquid crystal layer as is. If needed, the third region may include a quantum dot emitting a blue light.

As described herein, if desired, the display device or light emitting device according to an embodiment may further include an excitation light blocking layer or a first optical filter layer (hereinafter, referred to as a first optical filter layer). The first optical filter layer may be disposed between the bottom surface of the first region R and the second region G and the substrate (e.g., the upper substrate 240), or on the upper surface of the substrate. The first optical filter layer may be a sheet having an opening in a portion corresponding to a pixel area (third region) displaying blue, and thus may be formed in portions corresponding to the first and second regions. That is, the first optical filter layer may be integrally formed at positions other than the position overlapped with the third region as shown in FIGS. 1A, 1B, and 6 and/or 7, but embodiments are not limited thereto. Two or more first optical filter layers may be spaced apart from each other at positions overlapped with the first and second regions, and optionally, the third region. When the light source includes a green light emitting device, a green light blocking layer may be disposed on the third region.

The first optical filter layer may block light, for example, in a predetermined wavelength region in the visible light region and may transmit light in the other wavelength regions, and for example, it may block blue light (or green light) and may transmit light except the blue light (or green light). The first optical filter layer may transmit, for example, a green light, a red light, and/or a yellow light that is a mixed color thereof. The first optical filter layer may transmit a blue light and block a green light, and may be disposed on the blue light emitting pixel.

The first optical filter layer may substantially block excitation light and transmit light in a desired wavelength

region. The transmittance of the first optical filter layer for the light in a desired wavelength range may be greater than or equal to about 70%, greater than or equal to about 80%, greater than or equal to about 90%, or about 100%.

The first optical filter layer configured to selectively transmit a red light may be disposed at a position overlapped with the red light emitting section, and the first optical filter layer configured to selectively transmit a green light may be disposed at a position overlapped with the green light emitting section. The first optical filter layer may include a first filter region that blocks (e.g., absorbs) a blue light and a red light and selectively transmits the light of a predetermined range (e.g., greater than or equal to about 500 nm, greater than or equal to about 510 nm, or greater than or equal to about 515 nm to less than or equal to about 550 nm, less than or equal to about 545 nm, less than or equal to about 540 nm, less than or equal to about 535 nm, less than or equal to about 530 nm, less than or equal to about 525 nm, or less than or equal to about 520 nm); a second filter region that blocks (e.g., absorbs) a blue light and a green light and selectively transmits light of a predetermined range (e.g., greater than or equal to about 600 nm, greater than or equal to about 610 nm, or greater than or equal to about 615 nm to less than or equal to about 650 nm, less than or equal to about 645 nm, less than or equal to about 640 nm, less than or equal to about 635 nm, less than or equal to about 630 nm, less than or equal to about 625 nm, or less than or equal to about 620 nm); or the first filter region and the second filter region. In an embodiment, the light source may emit a blue and a green mixed light, and the first optical filter layer may further include a third filter region that selectively transmits a blue light and blocks a green light.

The first filter region may be disposed at a position overlapped with the green light emitting section. The second filter region may be disposed at a position overlapped with the red light emitting section. The third filter region may be disposed at a position overlapped with the blue light emitting section.

The first filter region, the second filter region, and, optionally, the third filter region may be optically isolated. Such a first optical filter layer may contribute to improvement of color purity of the display device.

The display device may further include a second optical filter layer (e.g., a recycling layer of red/green light or yellow light) that is disposed between the photoluminescent layer and the liquid crystal layer (e.g., between the photoluminescent layer and the upper polarizer), transmits at least a portion of the third light (excitation light), and reflects at least a portion of the first light and/or the second light. One of the first light and the second light may be a red light and the other may be a green light, and the third light may be a blue light. The second optical filter layer may transmit only the third light (B) in a blue light wavelength region of less than or equal to about 500 nm, and light in a wavelength region of greater than about 500 nm, which is green light (G), yellow light, red light (R), or the like, may be not passed through the second optical filter layer and reflected. The reflected green light and red light may pass through the first and second regions and to be emitted to the outside of the display device.

The second optical filter layer or the first optical filter layer may be formed as an integrated layer having a relatively planar surface.

The first optical filter layer may include a polymer thin film including a dye and/or a pigment absorbing light in a wavelength that is to be blocked. The second optical filter layer or the first optical filter layer may include a single layer having a low refractive index, and may be, for example, a transparent thin film having a refractive index of less than or equal to about 1.4, less than or equal to about 1.3, or less than or equal to about 1.2. The second optical filter layer or the first optical filter layer having a low refractive index may include, for example, a porous silicon oxide, a porous organic material, a porous organic-inorganic composite, or the like, or a combination thereof.

The first optical filter layer or the second optical filter layer may include a plurality of layers having different refractive indexes. The first optical filter layer or the second optical filter layer may be formed by laminating two layers having different refractive indexes. For example, the first/second optical filter layer may be formed by alternately laminating a material having a high refractive index and a material having a low refractive index.

Hereinafter, the exemplary embodiments are illustrated in further detail with reference to examples. However, embodiments of the present disclosure are not limited to the examples.

## EXAMPLES

### Analysis Methods

#### [1] Photoluminescence Analysis

A photoluminescence (PL) spectrum of the semiconductor nanoparticle and a composite including the same was obtained using a Hitachi F-7000 spectrophotometer with an excitation light of a wavelength of 450 nm.

#### [2] ICP Analysis

Inductively coupled plasma atomic emission spectroscopy (ICP-AES) was performed using a Shimadzu ICPS-8100.

[3] Blue Light Absorbance, Quantum efficiency, and Light Conversion Efficiency (CE) of the composite

An amount of incident light of a wavelength of 450 nm (B) was measured by using an integrating sphere or an integrating hemisphere of an absolute quantum efficiency-measuring device (e.g., QE-2100, Otsuka Electronics Co., Ltd.). Subsequently, a semiconductor (quantum dot, QD) polymer composite was placed in the integrating hemisphere, and then, the incident light was irradiated to measure an amount of first light from the composite (A), and an amount of the incident light passing the composite (B'), respectively.

Using the measured amounts, an incident light absorbance and the light conversion efficiency were calculated according to Equations 2, 3, and 4:

Equation 2

$$\text{incident light absorbance (\%)} = [(B-B')/B] \times 100\%$$

Equation 3

$$\text{Quantum efficiency (\%)} = [A/B] \times 100\%$$

Equation 4

$$\text{Photoconversion Efficiency (\%)} = [A/(B-B')] \times 100\%$$

wherein, in Equations 2, 3, and 4, each independently,

A is an amount of a first light emitted from the first composite,
B is an amount of incident light provided to the first composite, and
B' is an amount of incident light passing through the first composite.

Reference Example 1: Preparation of a semiconductor nanocrystal particle

Silver acetate was dissolved in oleylamine, preparing a 0.06 molar (M) silver precursor containing solution (hereinafter, abbreviated as "silver precursor"). Sulfur was dissolved in oleylamine, preparing a 1 M sulfur precursor containing solution (hereinafter, abbreviated as "sulfur precursor"). Indium chloride was dissolved in ethanol, preparing a 0.2 M indium precursor containing solution (hereinafter, abbreviated as an indium precursor).

Gallium acetylacetonate, octadecene (ODE), and dodecanethiol were placed in a 100 milliliter (mL) reaction flask and heated at 120°C for 10 minutes under vacuum. After cooling the flask to room temperature and replacing a gas inside the flask with nitrogen, the silver precursor, the sulfur precursor, and the indium precursor were added to the flask. The flask was heated at a reaction temperature of 210°C, and a reaction proceeded for 60 minutes. After decreasing the temperature of the flask to 180°C, trioctylphosphine (TOP) was added thereto, hexane and ethanol were added to the obtained mixture to promote precipitation, from which first semiconductor nanocrystal was separated via centrifugation and dispersed again in toluene.

A mole ratio among the indium precursor, the gallium precursor, and the sulfur precursor as used was 1:2.3:4.8.

Gallium chloride was dissolved in toluene to prepare a 4.5 M gallium precursor containing solution (hereinafter, abbreviated as a "gallium precursor").

Dimethylthiourea (DMTU), oleyl amine, and dodecanethiol were placed in a reaction flask, and then vacuum-treated at 120°C for 10 minutes. After substituting a gas in the reaction flask with $N_2$ and heating it at 240°C (a predetermined temperature), the semiconductor nanocrystal particle obtained above (having a peak emission wavelength of about 524 nm and a full width at half maximum of about 44 nm) and the gallium precursor were added thereto. Then, the reaction flask was heated to 320°C (a reaction temperature) to perform a reaction for about 10 minutes (a first reaction time). The reaction solution was then cooled to 180°C, and trioctylphosphine was added thereto. The reaction solution was then cooled to room temperature. Hexane and ethanol were added thereto to facilitate precipitation of a semiconductor nanoparticle, which was recovered via centrifugation and redispersed in toluene. The quantum efficiency of the semiconductor nanoparticle thus prepared was measured.

A mole ratio among the gallium precursor, the silver precursor, and the sulfur precursor as used was 1:0.5:1. An ICP-AES analysis was performed with respect to the obtained semiconductor nanoparticle, and the results are shown in Table 1.

Example 1: Production of a ligand-exchanged semiconductor nanoparticle and production of an ink composition and composite therefrom

[1] Ligand Exchange

A zinc oleate was added to the toluene dispersion of the semiconductor nanocrystal particle obtained in Reference Example 1 at room temperature and stirred for 3 hours. Ethanol is added to the resulting dispersion to facilitate precipitation of particles, and a zinc salt-treated semiconductor nanocrystal particle was recovered by centrifugation. An inductively coupled plasma-atomic emission spectroscopy (ICP-AES) analysis was performed on the obtained nanoparticles and the results are summarized in Table 1.
A zinc chloride solution was prepared. A first ligand compound solution was prepared by dissolving 2-carboxyethyl acrylate (CAS no: 24615-84-7, purchased from Sigma Aldrich Co., Ltd.) having the following formula in toluene:

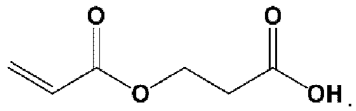

The zinc salt-treated semiconductor nanocrystal particle was dispersed in toluene to prepare a dispersion. The first ligand compound solution and the zinc chloride solution were mixed with the dispersion and stirred at room temperature for about 3 hours to conduct a ligand exchange reaction.
Hexane was then added to the reaction solution to induce precipitation of the ligand exchanged particle, which was recovered by centrifugation and dried.
A used amount of the first organic ligand was 4000 moles per one mole of the semiconductor nanocrystal particles. An amount of the zinc chloride was 5 mole%, based on an amount of the organic ligand.
An ICP-AES analysis was performed on the obtained (ligand exchanged) semiconductor nanoparticle and the results are summarized in Table 1.

[2] Preparation of ink composition and semiconductor nanoparticle-polymer composite

An ink composition was produced by adding the obtained semiconductor nanoparticle, a titanium oxide nanoparticle, and an initiator to hexanediol diacrylate (monomer).
In the ink composition, an amount of the semiconductor nanoparticle, an amount of the titanium oxide nanoparticle, and an amount of the initiator were 20% by weight, 5% by weight, and 1% by weight, respectively, and the balance amount of the composition was the monomer.
The quantum efficiency of the semiconductor nanoparticle in the ink composition was measured and the results are summarized in Table 2.
The prepared composition was deposited on a substrate and exposed (exposure amount 12 Joule) to perform a photopolymerization to obtain a film with a thickness of 7 μm. The photoconversion efficiency of the composite was measured for the prepared film, and the results are summarized in Table 2.
The obtained film was heat-treated at a temperature of 180°C for 30 minutes, and the photoconversion efficiency (CE) of the heat-treated film was measured, as well. The results are summarized in Table 2.

Example 2

[1] As the second organic ligand compound, 3-Mercapopropionate Acid Methyl Ester (CAS Number: 2935-90-2, Purchase Place: Sigma Aldrich) of the following formula was dissolved in toluene to prepare a second ligand compound solution:

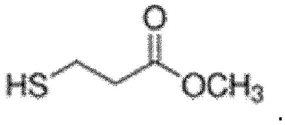

The ligand-exchanged semiconductor nanoparticle was prepared in the same manner as in Example 1, except

that the first ligand compound solution, the second ligand compound solution, and the zinc chloride solution were added with the dispersion and stirred at room temperature for about 3 hours. An ICP-AES analysis was performed on the obtained nanoparticles and the results are summarized in Table 1.

The mole ratio between the first organic ligand compound and the second organic ligand compound used in the ligand exchange reaction was 2:1.

[2] An ink composition and a composite film were obtained in the same manner as in Example 1, except for using the ligand exchange semiconductor nanoparticles prepared above. The quantum efficiency of the semiconductor nanoparticles in the ink composition was measured and the results are summarized in Table 2. The photoconversion efficiency of the composite was measured for the prepared film, and the results are summarized in Table 2.

The obtained film was heat-treated at a temperature of 180°C for 30 minutes, and the photoconversion efficiency of the heat-treated film was measured, as well. The results are summarized in Table 2.

Table 1

| | A mole ratio with respect to sulfur (:S) | | | | Charge balance value |
|---|---|---|---|---|---|
| | Ag | In | Ga | Zn | |
| Reference Example 1 | 0.36:1 | 0.12:1 | 0.53:1 | 0.00 | 1.17 |
| The zinc salt treated semiconductor nanoparticle | 0.37:1 | 0.12:1 | 0.41:1 | 0.09:1 | 1.08 |
| The LE semiconductor nanoparticle (Example 2) | 0.21:1 | 0.10:1 | 0.37:1 | 0.22:1 | 1.06 |
| The LE semiconductor nanoparticle (Example 1) | 0.20:1 | 0.11:1 | 0.37:1 | 0.23:1 | 1.05 |

LE: ligand exchanged

$$\text{Charge balance value} = \{[Ag] + 3x([In] + [Ga]) + 2x[Zn]\}/2x[S]$$

Comparative Example 1

[1] The ligand-exchanged semiconductor nanoparticle was prepared in the same manner as in Example 1, except for using the semiconductor nanocrystal particle obtained in Reference Example 1 instead of the zinc salt-treated nanocrystal particle and not using the zinc chloride solution 1.

[2] An ink composition and a composite film were obtained in the same manner as in Example 1, except for using the ligand exchange semiconductor nanoparticles prepared above. The quantum efficiency of the semiconductor nanoparticles in the ink composition was measured and the results are summarized in Table 2. The photoconversion efficiency of the composite was measured for the prepared film, and the results are summarized in Table 2.

The obtained film was heat-treated at a temperature of 180°C for 30 minutes, and the photoconversion efficiency of the heat-treated film was measured, as well. The results are summarized in Table 2.

Comparative Example 2

[1] The ligand-exchanged semiconductor nanoparticle was prepared in the same manner as in Example 1, except for using the compound represented by Chemical Formula 4 as the first organic ligand:

Chemical Formula 4

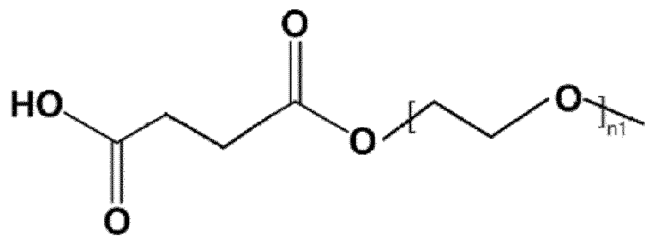

n1 = 7.

[2] An ink composition and a composite film were obtained in the same manner as in Example 1, except for using the ligand exchange semiconductor nanoparticles prepared above. The quantum efficiency of the semiconductor nanoparticles in the ink composition was measured and the results are summarized in Table 2. The photoconversion efficiency of the composite was measured for the prepared film, and the results are summarized in Table 2.

The obtained film was heat-treated at a temperature of 180°C for 30 minutes, and the photoconversion efficiency of the heat-treated film was measured, as well. The results are summarized in Table 2.

Comparative Example 3

[1] The ligand-exchanged semiconductor nanoparticle was prepared in the same manner as in Example 1, except for not using the first organic ligand.

[2] An ink composition and a composite film were obtained in the same manner as in Example 1, except for using the ligand exchange semiconductor nanoparticles prepared above. The quantum efficiency of the semiconductor nanoparticles in the ink composition was measured and the results are summarized in Table 2. The photoconversion efficiency of the composite was measured for the prepared film, and the results are summarized in Table 2.

The obtained film was heat-treated at a temperature of 180°C for 30 minutes, and the photoconversion efficiency of the heat-treated film was measured, as well. The results are summarized in Table 2.

Comparative Example 4

[1] The ligand-exchanged semiconductor nanoparticle was prepared in the same manner as in Example 2, except for using the amine compound represented by Chemical Formula 5, instead of the 3-Mercaptopropionic Acid Methyl Ester:

Chemical Formula 5

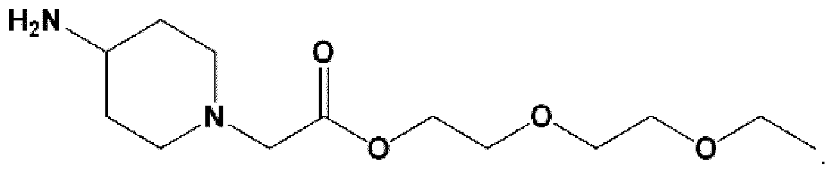

[2] An ink composition and a composite film were obtained in the same manner as in Example 1, except for using the ligand exchange semiconductor nanoparticles prepared above. The quantum efficiency of the semiconductor nanoparticles in the ink composition was measured and the results are summarized in Table 2. The photoconversion efficiency of the composite was measured for the prepared film, and the results are summarized in Table 2.

The obtained film was heat-treated at a temperature of 180°C for 30 minutes, and the photoconversion efficiency of the heat-treated film was measured, as well. The results are summarized in Table 2.

Comparative Example 5

[1] The ligand-exchanged semiconductor nanoparticle was prepared in the same manner as in Example 1, except for using the amine compound represented by Chemical Formula 5, instead of the first organic ligand, and not using the zinc chloride solution.

[2] An ink composition and a composite film were obtained in the same manner as in Example 1, except for using the ligand exchange semiconductor nanoparticles prepared above. The quantum efficiency of the semiconductor nanoparticles in the ink composition was measured and the results are summarized in Table 2. The photoconversion efficiency of the composite was measured for the prepared film, and the results are summarized in Table 2.

The obtained film was heat-treated at a temperature of 180°C for 30 minutes, and the photoconversion efficiency of the heat-treated film was measured, as well. The results are summarized in Table 2.

Comparative Example 6

An ink composition was prepared in the same manner as in Example 1, except that the semiconductor nanoparticles prepared in Reference Example 1 are used instead of the ligand-exchanged semiconductor nanoparticle. The semiconductor nanoparticle in the ink composition was remarkably aggregated in the composition and failed to form a coating solution (or ink) exhibiting a dispersibility necessary to manufacture a nanoparticle polymer composite.

Table 2

| | QY of Ref. Example 1 (%) | QY of the QD in the ink(%) | PCE of the composite after Exp (%) | PCE of the composite after POB (%) |
|---|---|---|---|---|
| Ex. 1 | 65.5 | 89.7 | 81.6 | 79.6 |
| Ex. 2 | 65.5 | 72.2 | 69.6 | 60.8 |
| Comp. Ex. 1 | 65.5 | 46.5 | 32.6 | 11.4 |
| Comp. Ex. 2 | 65.5 | 49.4 | 40.1 | 34.1 |
| Comp. Ex. 3 | 65.5 | 57.9 | 45.7 | 34 |

(continued)

| | QY of Ref. Example 1 (%) | QY of the QD in the ink(%) | PCE of the composite after Exp (%) | PCE of the composite after POB (%) |
|---|---|---|---|---|
| Comp. Ex. 4 | 65.5 | 65.5 | 49.9 | 42.3 |
| Comp. Ex. 5 | 65.5 | 45.8 | 27.9 | 32.3 |
| QY of Ref. Example: Quantum efficiency of the semiconductor nanoparticle prepared in Reference Example 1, QY of the QD in the ink: Quantum efficiency of the ligand exchanged semiconductor nanoparticle in the ink composition, PCE of the composite after Exp: photoconversion efficiency of the semiconductor nanoparticle polymer composite prepared after the exposure to light, and PCE of the composite after POB: photoconversion efficiency of the semiconductor nanoparticle polymer composite after the heat-treatment at 180 °C for 30 minutes. | | | | |

Table 3

| | Organic Ligand | | Mole ratio between the ligands | used amount (mole%) of the $ZnCl_2$ based on the organic ligand |
|---|---|---|---|---|
| | Ligand I | Ligand II | I:II | 5% |
| Ex. 1 | 2-Carboxyethyl acrylate | | 1:0 | 5% |
| Ex. 2 | 2-Carboxyethyl acrylate | 3-Mercaptopropio nic Acid Methyl Ester | 2:1 | |
| Comp. Ex. 1 | 2-Carboxyethyl acrylate | | 1:0 | Not used |
| Comp. Ex. 2 | Chemical Formula 4 | 3-Mercaptopropio nic Acid Methyl Ester | 2:1 | 5% |
| Comp. Ex. 3 | | 3-Mercaptopropio nic Acid Methyl Ester | 0:1 | 5% |
| Comp. Ex. 4 | 2-Carboxyethyl acrylate | Chemical Formula 5 | 2:1 | 5% |
| Comp. Ex. 5 | | Chemical Formula 5 | 0:1 | Not used |

From Table 2, it is confirmed that the ink composition of the Examples may exhibit remarkably improved QY and process stability compared to the composition described in Comparative Examples.

Example 3

[1] The ligand-exchanged semiconductor nanoparticle was prepared in the same manner as in Example 1, except that a compound having the following chemical formula (MW: 188.2 g/mol) was used as the first organic ligand instead of the 2-carboxy ethyl acrylate:

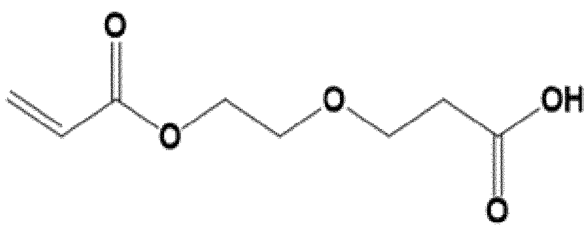

[2] An ink composition and a composite film were obtained in the same manner as in Example 1, except for using the ligand exchange semiconductor nanoparticles prepared above.

Example 4

[1] The ligand-exchanged semiconductor nanoparticle was prepared in the same manner as in Example 1, except that a compound having the following chemical formula (MW: 232.2 g/mol) was used as the first organic ligand instead of the 2-carboxy ethyl acrylate:

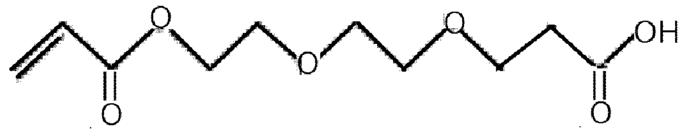

[2] An ink composition and a composite film were obtained in the same manner as in Example 1, except for using the ligand exchange semiconductor nanoparticles prepared above.

While this disclosure has been described in connection with what is presently considered to be practical embodiments, it is to be understood that the present subject matter is not limited to the disclosed exemplary embodiments. On the contrary, it is intended to cover various modifications and equivalent arrangements included within the scope of the appended claims.

## Claims

**1.** An ink composition comprising:

a polymerizable monomer;
a semiconductor nanoparticle, wherein the semiconductor nanoparticle comprises

zinc, and
a Group 11-13-16 compound comprising silver, a Group 13 metal, and a Group 16 element,
wherein the Group 13 metal comprises indium and gallium,
wherein the Group 16 element comprises sulfur;

a first organic ligand comprising a compound or a moiety represented by $R_1$-COO-A, wherein $R_1$ is a first organic group, and A is hydrogen or a portion linked to a surface of the semiconductor nanoparticle; and
wherein the semiconductor nanoparticle does not comprise copper.

**2.** The ink composition of claim 1, wherein

the ink composition further comprises a second organic ligand comprising a compound or a moiety represented by $R_2$-SA,
wherein $R_2$ is a second organic group, and A is hydrogen or a portion linked to the surface of the semiconductor nanoparticle.

**3.** The ink composition of claims 1 or 2,

wherein the semiconductor nanoparticle comprises,
a semiconductor nanocrystal comprising the Group 11-13-16 compound,
wherein the gallium is exposed to a surface of the semiconductor nanocrystal,
the surface of the semiconductor nanocrystal comprises zinc, and
the first organic ligand linked to the surface of the semiconductor nanocrystal.

**4.** The ink composition of any of claims 1-3, wherein a mole ratio of the zinc to the sulfur is greater than or equal to 0.01:1 and less than or equal to 0.8:1, in the semiconductor nanoparticle, and

wherein the semiconductor nanoparticle has a charge balance value represented by Equation 3A that is greater than or equal to 0.8 and less than or equal to 1.5:

Equation 3A

$$\text{charge balance value} = \{[Ag] + 3x([In]+[Ga]) + 2x[Zn]\} / (2x[S])$$

wherein, in Equation 3A, [Ag], [In], [Ga], [Zn], and [S] are molar amounts of silver, indium, gallium, zinc, and sulfur in the semiconductor nanoparticle, respectively.

**5.** The ink composition of any of claims 1-4, wherein

a mole ratio of zinc to silver is greater than or equal to 0.3:1 and less than equal to 5:1, in the semiconductor nanoparticle; or
a mole ratio of zinc to gallium is greater than or equal to 0.4:1 and less than equal to 1.5:1, in the semiconductor nanoparticle; or
a mole ratio of zinc to a sum of gallium, indium, and silver is greater than or equal to 0.05:1 and less than or equal to 2:1, in the semiconductor nanoparticle.

**6.** The ink composition of any of claims 1-5, wherein the first organic group comprises a substituted or unsubstituted $C_{3-15}$ hydrocarbon group, and optionally wherein the $C_{3-15}$ hydrocarbon group comprises -CO-, -O-, -COO-, -S-, -SO-, -NHCO-, or a combination thereof, in a backbone thereof; and/or
wherein the first organic group comprises a (meth)acrylate moiety.

**7.** The ink composition of any of claims 1-6, wherein in the ink composition, an amount of the semiconductor nanoparticle is greater than or equal to 15% by weight and less than or equal to 50% by weight, based on a total weight of the ink composition; and/or

wherein the first organic ligand comprises a carboxylic acid compound represented by Chemical Formula 2-1, a carboxylate moiety represented by Chemical Formula 2-3, or a combination thereof:

Chemical Formula 2-1

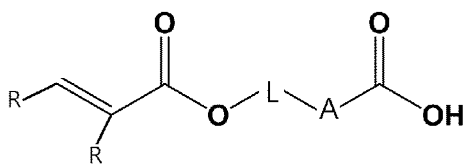

Chemical Formula 2-3

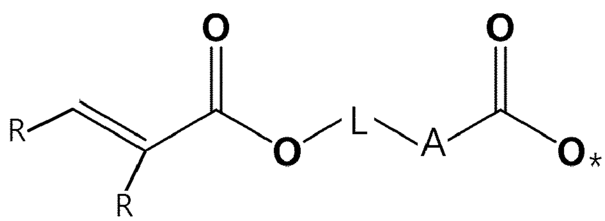

wherein, in each Chemical Formula 2-1 and Chemical Formula 2-3 independently,
R is the same or different and is independently hydrogen or C1 to C10 alkyl,
L is a single bond, a substituted or unsubstituted C1 to C50 hydrocarbon group, -CO-, -O-, -SO-, -COO-, -S-, -NHCO-, or a combination thereof,
A is a single bond, a substituted or unsubstituted C1 to C50 hydrocarbon group, -CO-, -O-, -SO-, -COO-, -S-, -NHCO-, or a combination thereof, and
* is a portion linked to the semiconductor nanoparticle.

**8.** A method for producing an ink composition, the method comprising:

admixing

a semiconductor nanocrystal particle comprising a Group 11-13-16 compound,
a first organic ligand,
a zinc salt compound, and
a first organic solvent to obtain a semiconductor nanoparticle in contact with the first organic ligand; and

mixing a polymerizable monomer and the semiconductor nanoparticle in contact with the first organic ligand to produce the ink composition,
wherein the ink composition comprises

the semiconductor nanoparticle and the polymerizable monomer, wherein the semiconductor nanoparticle comprises

zinc, and
the Group 11-13-16 compound;

the first organic ligand comprising a compound or a moiety represented by $R_1$-COO-A,
wherein $R_1$ is a first organic group, and A is hydrogen or a portion linked to a surface of the semiconductor nanoparticle; and
wherein the semiconductor nanoparticle does not comprise copper.

**9.** The method of claim 8, wherein the semiconductor nanocrystal particle comprising the Group 11-13-16 compound comprises a zinc salt-treated nanocrystal particle,

wherein the zinc salt-treated nanocrystal particle is obtained by contacting a nanocrystal particle comprising the Group 11-13-16 compound with a first zinc salt compound in the absence of the first organic ligand in an organic solvent;
preferably wherein
the first zinc salt compound comprises a C8 to C50 zinc fatty acid ester compound, and wherein
the contacting the nanocrystal particle with the first zinc salt compound comprises
contacting at a first temperature, wherein the first temperature is greater than or equal to 20°C and less than or equal to 100°C.

**10.** The method of claims 8 or 9, wherein the first organic ligand comprises a carboxylic acid compound represented by Chemical Formula 2-1 or a moiety represented by Chemical Formula 2-3:

Chemical Formula 2-1

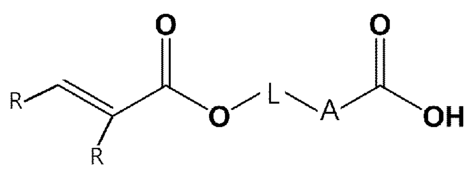

Chemical Formula 2-3

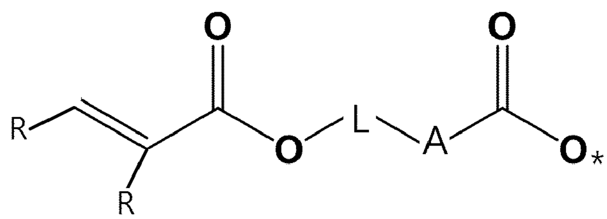

wherein, in Chemical Formula 2-1 and Chemical Formula 2-3,
R is the same or different and is independently hydrogen or C1 to C10 alkyl,
L is a single bond, a substituted or unsubstituted C1 to C50 hydrocarbon group, -CO-, -O-, -SO-, -COO-, -S-, -NHCO-, or a combination thereof,
A is a single bond, a substituted or unsubstituted C1 to C50 hydrocarbon group, -CO-, -O-, -SO-, -COO-, -S-, -NHCO-, or a combination thereof, and
* is a portion linked to the semiconductor nanoparticle.

**11.** The method of any of claims 8-10, wherein the zinc salt compound comprises a zinc halide; and/or

wherein the Group 11-13-16 compound comprises a Group 11 element, a Group 13 element, and a Group 16 element, wherein
the Group 11 element comprises silver,
the Group 13 element comprises indium and gallium, and
the Group 16 element comprises sulfur.

**12.** A semiconductor nanoparticle-polymer composite comprising a polymerization product of the ink composition of any of claims 1-7.

**13.** A device, comprising:

a color conversion layer comprising a color conversion region and optionally a partition wall defining each color conversion region of the color conversion layer,
wherein the color conversion region comprises a first region corresponding to a first pixel, and
wherein the first region comprises the semiconductor nanoparticle-polymer composite of claim 12.

**14.** A display device comprising:

a light source; and
the semiconductor nanoparticle-polymer composite of claims 12 or 13,
wherein the light source is configured to provide a color conversion panel with an incident light.

**15.** The display device of claim 14, wherein the light source comprises an organic light emitting diode, a micro light emitting diode, a mini light emitting diode, a light emitting diode comprising a nanorod, or a combination thereof; and/or wherein the display device is a portable terminal device, a monitor, a personal computer, a television, an electronic display board, or an electronic part for an automobile or a vehicle.

## Patentansprüche

**1.** Tintenzusammensetzung, umfassend:

ein polymerisierbares Monomer;
ein Halbleiter-Nanopartikel, wobei das Halbleiter-Nanopartikel umfasst
Zink und
eine Verbindung der Gruppe 11-13-16, umfassend Silber, ein Metall der Gruppe 13 und ein Element der Gruppe 16,
wobei das Metall der Gruppe 13 Indium und Gallium umfasst,wobei das Element der Gruppe 16 Schwefel umfasst;
einen ersten organischen Liganden, umfassend eine Verbindung oder eine Moietät, die von $R_1$-COO-A dargestellt ist, wobei $R_1$ eine erste organische Gruppe ist und A Wasserstoff oder ein Teil ist, der an eine Oberfläche des Halbleiter-Nanopartikels gebunden ist; und
wobei das Halbleiter-Nanopartikel nicht Kupfer umfasst.

**2.** Tintenzusammensetzung nach Anspruch 1, wobei

die Tintenzusammensetzung ferner einen zweiten organischen Liganden, umfassend eine Verbindung oder eine Moietät, die von $R_2$-SA dargestellt ist, umfasst,

wobei $R_2$ eine zweite organische Gruppe ist und A Wasserstoff oder ein Teil ist, der an die Oberfläche des Halbleiter-Nanopartikels gebunden ist.

**3.** Tintenzusammensetzung nach Anspruch 1 oder 2,wobei das Halbleiter-Nanopartikel umfasst, einen Halbleiter-Nanokristall, umfassend die Verbindung der Gruppe 11-13-16,wobei das Gallium einer Oberfläche des Halbleiter-Nanokristalls ausgesetzt ist,

die Oberfläche des Halbleiter-Nanokristalls Zink umfasst und
den ersten organische Liganden, der an die Oberfläche des Halbleiter-Nanokristalls gebunden ist.

**4.** Tintenzusammensetzung nach einem der Ansprüche 1-3, wobei ein Molverhältnis des Zinks zu dem Schwefel größer als oder gleich 0,01:1 und weniger als oder gleich 0,8:1 in dem Halbleiter-Nanopartikel ist, und

wobei das Halbleiter-Nanopartikel einen von Gleichung 3A dargestellten Ladungsbilanzwert aufweist, der größer als oder gleich 0,8 und weniger als oder gleich 1,5 ist:

Gleichung 3A

$$\text{Ladungsbilanzwert} = \{[Ag] + 3x([In]+[Ga]) + 2x[Zn]\} / (2x[S])$$

wobei, in Gleichung 3A, [Ag], [In], [Ga], [Zn] und [S] jeweils molare Mengen von Silber, Indium, Gallium, Zink und Schwefel in dem Halbleiter-Nanopartikel sind.

**5.** Tintenzusammensetzung nach einem der Ansprüche 1-4, wobei

ein Molverhältnis von Zink zu Silber größer als oder gleich 0,3:1 und weniger als oder gleich 5:1 in dem Halbleiter-Nanopartikel ist; oder
ein Molverhältnis von Zink zu Gallium größer als oder gleich 0,4:1 und weniger als oder gleich 1,5:1 in dem Halbleiter-Nanopartikel ist; oder
ein Molverhältnis von Zink zu einer Summe von Gallium, Indium und Silber größer als oder gleich 0,05:1 und weniger als oder gleich 2:1 in dem Halbleiter-Nanopartikel ist.

**6.** Tintenzusammensetzung nach einem der Ansprüche 1-5, wobei die erste organische Gruppe eine substituierte oder unsubstituierte $C_{3-15}$-Kohlenwasserstoffgruppe umfasst und optional, wobei die $C_{3-15}$-Kohlenwasserstoffgruppe -CO-, -O-, -COO-, -S-, -SO-, -NHCO- oder

eine Kombination davon in einem Rückgrat davon umfasst; und/oder
wobei die erste organische Gruppe eine (Meth)acrylat-Moietät umfasst.

**7.** Tintenzusammensetzung nach einem der Ansprüche 1-6, wobei, in der Tintenzusammensetzung, eine Menge des Halbleiter-Nanopartikels größer als oder gleich 15 Gew.-% und weniger als oder gleich 50 Gew.-%, basierend auf einem Gesamtgewicht der Tintenzusammensetzung, ist; und/oder

wobei der erste organische Ligand eine Carboxylsäureverbindung, die von der chemischen Formel 2-1 dargestellt ist, eine Carboxylat-Moietät, die von der chemischen Formel 2-3 dargestellt ist, oder eine Kombination davon umfasst:

Chemische Formel 2-1

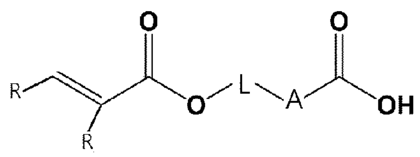

Chemische Formel 2-3

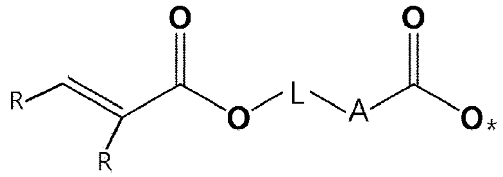

wobei, in jeder chemischen Formel 2-1 und chemischen Formel 2-3 unabhängig,
R gleich oder unterschiedlich ist und unabhängig Wasserstoff oder C1- bis C10-Alkyl ist,
L eine Einfachbindung, eine substituierte oder unsubstituierte C1- bis C50-Kohlenwasserstoffgruppe, -CO-, -O-, -SO-, -COO-, -S-, -NHCO- oder eine Kombination davon ist,
A eine Einfachbindung, eine substituierte oder unsubstituierte C1- bis C50-Kohlenwasserstoffgruppe, -CO-, -O-, -SO-, -COO-, -S-, -NHCO- oder eine Kombination davon ist und
* ein Teil ist, der an das Halbleiter-Nanopartikel gebunden ist.

**8.** Verfahren zur Herstellung einer Tintenzusammensetzung, wobei das Verfahren umfasst:

Beimischen
eines Halbleiter-Nanokristallpartikels, umfassend eine Verbindung der Gruppe 11-13-16,
eines ersten organischen Liganden,
einer Zinksalzverbindung und
eines ersten organischen Lösungsmittels, um ein Halbleiter-Nanopartikel in Kontakt mit dem ersten organischen Liganden zu erhalten; und
Mischen eines polymerisierbaren Monomers und des Halbleiter-Nanopartikels in Kontakt mit dem ersten organischen Liganden, um die Tintenzusammensetzung herzustellen,
wobei die Tintenzusammensetzung umfasst
das Halbleiter-Nanopartikel und das polymerisierbare Monomer, wobei das Halbleiter-Nanopartikel umfasst
Zink und
die Verbindung der Gruppe 11-13-16;
wobei der erste organische Ligand eine Verbindung oder eine Moietät umfasst, die von $R_1$-COO-A dargestellt ist, wobei $R_1$ eine erste organische Gruppe ist und A Wasserstoff oder ein Teil ist, der an eine Oberfläche des Halbleiter-Nanopartikels gebunden ist; und
wobei das Halbleiter-Nanopartikel nicht Kupfer umfasst.

**9.** Verfahren nach Anspruch 8, wobei das Halbleiter-Nanokristallpartikel, das die Verbindung der Gruppe 11-13-16 umfasst, ein mit Zinksalz behandeltes Nanokristallpartikel umfasst,

wobei das mit Zinksalz behandelte Nanokristallpartikel durch Inkontaktbringen eines Nanokristallpartikels, das die Verbindung der Gruppe 11-13-16 umfasst, mit einer ersten Zinksalzverbindung in der Abwesenheit des ersten organischen Liganden in einem organischen Lösungsmittel erhalten wird;
bevorzugt, wobei
die erste Zinksalzverbindung eine C8- bis C50-Zinkfettsäureesterverbindung umfasst und wobei das Inkontaktbringen des Nanokristallpartikels mit der ersten Zinksalzverbindung umfasst Inkontaktbringen bei einer ersten Temperatur, wobei die erste Temperatur größer als oder gleich 20 °C und weniger als oder gleich 100 °C ist.

**10.** Verfahren nach Anspruch 8 oder 9, wobei der erste organische Ligand eine Carboxylsäureverbindung, die von der chemischen Formel 2-1 dargestellt ist, oder eine Moietät, die von der chemischen Formel 2-3 dargestellt ist, umfasst:

Chemische Formel 2-1

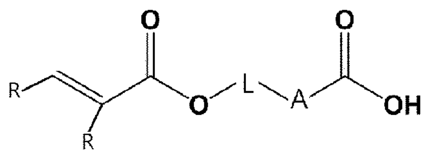

Chemische Formel 2-3

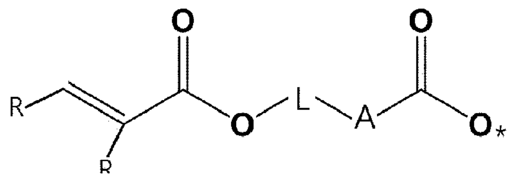

wobei, in der chemischen Formel 2-1 und der chemischen Formel 2-3,
R gleich oder unterschiedlich ist und unabhängig Wasserstoff oder C1- bis C10-Alkyl ist,
L eine Einfachbindung, eine substituierte oder unsubstituierte C1- bis C50-Kohlenwasserstoffgruppe, -CO-, -O-, -SO-, -COO-, -S-, -NHCO- oder eine Kombination davon ist,
A eine Einfachbindung, eine substituierte oder unsubstituierte C1- bis C50-Kohlenwasserstoffgruppe, -CO-, -O-, -SO-, -COO-, -S-, -NHCO- oder eine Kombination davon ist und
* ein Teil ist, der an das Halbleiter-Nanopartikel gebunden ist.

**11.** Verfahren nach einem der Ansprüche 8-10, wobei die Zinksalzverbindung ein Zinkhalogenid umfasst; und/oder

wobei die Verbindung der Gruppe 11-13-16 ein Element der Gruppe 11, ein Element der Gruppe 13 und ein Element der Gruppe 16 umfasst, wobei
das Element der Gruppe 11 Silber umfasst,
das Element der Gruppe 13 Indium und Gallium umfasst und
das Element der Gruppe 16 Schwefel umfasst.

**12.** Halbleiter-Nanopartikel-Polymer-Verbundstoff, umfassend ein Polymerisationsprodukt der Tintenzusammensetzung nach einem der Ansprüche 1-7.

**13.** Vorrichtung, umfassend:

eine Farbumwandlungsschicht, umfassend einen Farbumwandlungsbereich und optional eine Trennwand, die jeden Farbumwandlungsbereich der Farbumwandlungsschicht definiert,
wobei der Farbumwandlungsbereich einen ersten Bereich umfasst, der einem ersten Pixel entspricht, und wobei der erste Bereich den Halbleiter-Nanopartikel-Polymer-Verbundstoff nach Anspruch 12 umfasst.

**14.** Anzeigevorrichtung, umfassend:

eine Lichtquelle; und
den Halbleiter-Nanopartikel-Polymer-Verbundstoff nach Anspruch 12 oder 13,
wobei die Lichtquelle dazu konfiguriert ist, ein Farbumwandlungspanel mit einem einfallenden Licht zu versorgen.

**15.** Anzeigevorrichtung nach Anspruch 14, wobei die Lichtquelle eine organische Leuchtdiode, eine Mikro-Leuchtdiode, eine Mini-Leuchtdiode, eine Leuchtdiode umfassend ein

Nanostäbchen oder eine Kombination davon umfasst; und/oder
wobei die Anzeigevorrichtung eine tragbare Endvorrichtung, ein Monitor, ein Personalcomputer, ein Fernsehgerät, eine elektronische Anzeigetafel oder ein elektronisches Bauteil für ein Automobil oder ein Fahrzeug ist.

**Revendications**

**1.** Composition d'encre comprenant :

un monomère polymérisable ;
une nanoparticule semi-conductrice, ladite nanoparticule semi-conductrice comprenant
du zinc, et
un composé du Groupe 11-13-16 comprenant de l'argent, un métal du Groupe 13 et un élément du Groupe 16,

ledit métal du Groupe 13 comprenant de l'indium et du gallium,
ledit élément du Groupe 16 comprenant du soufre ;
un premier ligand organique comprenant un composé ou un fragment représenté par $R_1$-COO-A, où $R_1$ est un premier groupe organique, et A est un hydrogène ou une partie liée à une surface de la nanoparticule semi-conductrice ; et
dans laquelle la nanoparticule semi-conductrice ne comprend pas de cuivre.

**2.** Composition d'encre de la revendication 1, dans laquelle

la composition d'encre comprend en outre un second ligand organique comprenant un composé ou un fragment représenté par $R_2$-SA,
dans laquelle $R_2$ est un second groupe organique, et A est un hydrogène ou une partie liée à la surface de la nanoparticule semi-conductrice.

**3.** Composition d'encre de l'une des revendications 1 ou 2,

dans laquelle la nanoparticule semi-conductrice comprend,
un nanocristal semi-conducteur comprenant le composé du Groupe 11-13-16,
dans laquelle le gallium est exposé à une surface du nanocristal semi-conducteur,
la surface du nanocristal semi-conducteur comprend du zinc, et
le premier ligand organique lié à la surface du nanocristal semi-conducteur.

**4.** Composition d'encre de l'une quelconque des revendications 1 à 3, dans laquelle un rapport molaire entre le zinc et le soufre est supérieur ou égal à 0,01: 1 et inférieur ou égal à 0,8:1, dans la nanoparticule semi-conductrice, et

dans laquelle la nanoparticule semi-conductrice présente une valeur d'équilibre de charge représentée par l'Équation 3A qui est supérieure ou égale à 0,8 et inférieure ou égale à 1,5 :

Équation 3A

$$\text{valeur d'équilibre de charge} = \{[Ag] + 3x([In]+[Ga]) + 2x[Zn]\} / (2x[S])$$

dans laquelle, dans l'Équation 3A, [Ag], [In], [Ga], [Zn] et [S] sont des quantités molaires d'argent, d'indium, de gallium, de zinc et de soufre dans la nanoparticule semi-conductrice, respectivement.

**5.** Composition d'encre de l'une quelconque des revendications 1 à 4, dans laquelle

un rapport molaire entre le zinc et l'argent est supérieur ou égal à 0,3:1 et inférieur ou égal à 5:1, dans la nanoparticule semi-conductrice ; ou
un rapport molaire entre le zinc et le gallium est supérieur ou égal à 0,4:1 et inférieur ou égal à 1,5:1, dans la nanoparticule semi-conductrice ; ou
un rapport molaire entre le zinc et une somme du gallium, de l'indium et de l'argent est supérieur ou égal à 0,05:1 et inférieur ou égal à 2:1, dans la nanoparticule semi-conductrice.

**6.** Composition d'encre de l'une quelconque des revendications 1 à 5, dans laquelle le premier groupe organique comprend un groupe hydrocarboné en $C_{3-15}$ substitué ou non substitué, et éventuellement dans laquelle le groupe hydrocarboné en $C_{3-15}$ comprend -CO-, -O-, -COO-, -S-, - SO-, -NHCO-, ou une combinaison de ceux-ci, dans un squelette de celui-ci ; et/ou
dans laquelle le premier groupe organique comprend un fragment (méth)acrylate.

**7.** Composition d'encre de l'une quelconque des revendications 1 à 6, dans laquelle, dans la composition d'encre, une quantité de la nanoparticule semi-conductrice est supérieure ou égale à 15 % en poids et inférieure ou égale à 50 % en poids, sur la base d'un poids total de la composition d'encre ; et/ou

dans laquelle le premier ligand organique comprend un composé acide carboxylique représenté par la Formule chimique 2-1, un fragment carboxylate représenté par la Formule chimique 2-3, ou une combinaison de ceux-ci :

Formule chimique 2-1

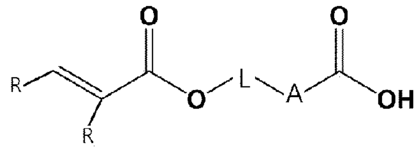

Formule chimique 2-3

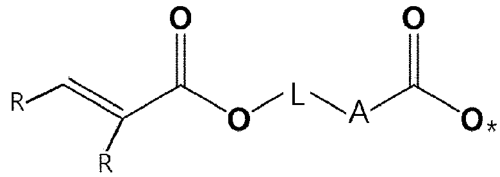

dans laquelle, dans chaque Formule chimique 2-1 et Formule chimique 2-3 indépendamment,
R est identique ou différent et est indépendamment un hydrogène ou un alkyle en C1 à C10,
L est une liaison simple, un groupe hydrocarboné en C1 à C50 substitué ou non substitué, -CO-, -O-, -SO-, -COO-, -S-, -NHCO-, ou une combinaison de ceux-ci,
A est une liaison simple, un groupe hydrocarboné en C1 à C50 substitué ou non substitué, -CO-, -O-, -SO-, -COO-, -S-, -NHCO-, ou une combinaison de ceux-ci, et
* est une partie liée à la nanoparticule semi-conductrice.

**8.** Procédé permettant la production d'une composition d'encre, le procédé comprenant :

le mélange
d'une particule de nanocristal semi-conducteur comprenant un composé du Groupe 11-13-16,
d'un premier ligand organique,
d'un composé de sel de zinc, et
d'un premier solvant organique pour obtenir une nanoparticule semi-conductrice en contact avec le premier ligand organique ; et
le mélange d'un monomère polymérisable et de la nanoparticule semi-conductrice en contact avec le premier ligand organique pour produire la composition d'encre,
dans lequel la composition d'encre comprend
la nanoparticule semi-conductrice et le monomère polymérisable,
dans lequel la nanoparticule semi-conductrice comprend
du zinc, et
le composé du Groupe 11-13-16 ;
le premier ligand organique comprenant un composé ou un fragment représenté par $R_1$-COO-A,
dans lequel $R_1$ est un premier groupe organique, et A est un hydrogène ou une partie liée à une surface de la nanoparticule semi-conductrice ; et
dans lequel la nanoparticule semi-conductrice ne comprend pas de cuivre.

**9.** Procédé de la revendication 8, dans lequel la particule de nanocristal semi-conducteur comprenant le composé du Groupe 11-13-16 comprend une particule de nanocristal traitée avec un sel de zinc,

dans lequel la particule de nanocristal traitée avec un sel de zinc est obtenue en mettant en contact une particule de nanocristal comprenant le composé du Groupe 11-13-16 avec un premier composé de sel de zinc en l'absence du premier ligand organique dans un solvant organique ;
de préférence dans lequel
le premier composé de sel de zinc comprend un composé d'ester d'acide gras de zinc en C8 à C50, et dans lequel la mise en contact de la particule de nanocristal avec le premier composé de sel de zinc comprend
la mise en contact à une première température, ladite première température étant supérieure ou égale à 20 °C et inférieure ou égale à 100 °C.

**10.** Procédé de l'une des revendications 8 ou 9, dans lequel le premier ligand organique comprend un composé acide

carboxylique représenté par la Formule chimique 2-1 ou un fragment représenté par la Formule chimique 2-3 :

Formule chimique 2-1

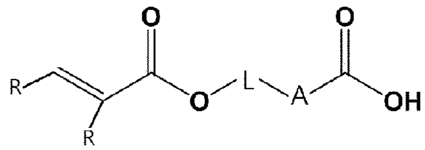

Formule chimique 2-3

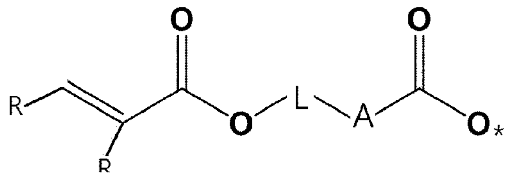

dans lequel, dans la Formule chimique 2-1 et la Formule chimique 2-3,
R est identique ou différent et est indépendamment un hydrogène ou un alkyle en C1 à C10,
L est une liaison simple, un groupe hydrocarboné en C1 à C50 substitué ou non substitué, -CO-, -O-, -SO-, -COO-, -S-, -NHCO-, ou une combinaison de ceux-ci,
A est une liaison simple, un groupe hydrocarboné en C1 à C50 substitué ou non substitué, -CO-, -O-, -SO-, -COO-, -S-, -NHCO-, ou une combinaison de ceux-ci, et
* est une partie liée à la nanoparticule semi-conductrice.

**11.** Procédé de l'une quelconque des revendications 8 à 10, dans lequel le composé de sel de zinc comprend un halogénure de zinc ; et/ou

dans lequel le composé du Groupe 11-13-16 comprend un élément du Groupe 11, un élément du Groupe 13 et un élément du Groupe 16, dans lequel
l'élément du Groupe 11 comprend de l'argent,
l'élément du Groupe 13 comprend de l'indium et du gallium, et
l'élément du Groupe 16 comprend du soufre.

**12.** Composite semi-conducteur nanoparticule-polymère comprenant un produit de polymérisation de la composition d'encre de l'une quelconque des revendications 1 à 7.

**13.** Dispositif, comprenant :

une couche de conversion de couleur comprenant une région de conversion de couleur et éventuellement une paroi de séparation définissant chaque région de conversion de couleur de la couche de conversion de couleur,
dans lequel la région de conversion de couleur comprend une première région correspondant à un premier pixel, et
dans lequel la première région comprend le composite semi-conducteur nanoparticule-polymère de la revendication 12.

**14.** Dispositif d'affichage comprenant :

une source de lumière ; et
le composite semi-conducteur nanoparticule-polymère de l'une des revendications 12 ou 13,
dans lequel la source de lumière est configurée pour fournir un panneau de conversion de couleur avec une lumière incidente.

**15.** Dispositif d'affichage de la revendication 14, dans lequel la source de lumière comprend une diode électroluminescente organique, une microdiode électroluminescente, une mini diode électroluminescente, une diode électroluminescente comprenant un nanobâtonnet, ou une combinaison de ceux-ci ; et/ou
dans lequel le dispositif d'affichage est un dispositif terminal portable, un moniteur, un ordinateur personnel, un téléviseur, un tableau d'affichage électronique ou une pièce électronique pour une automobile ou un véhicule.

FIG. 1A

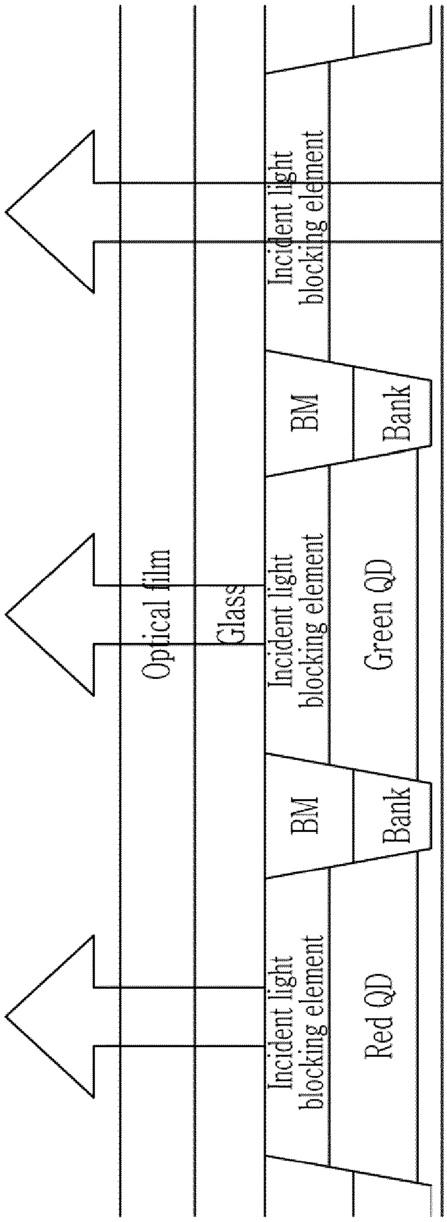
Optical film
Glass
Incident light blocking element
Red QD
BM
Bank
Incident light blocking element
Green QD
BM
Bank
Incident light blocking element

FIG. 1B

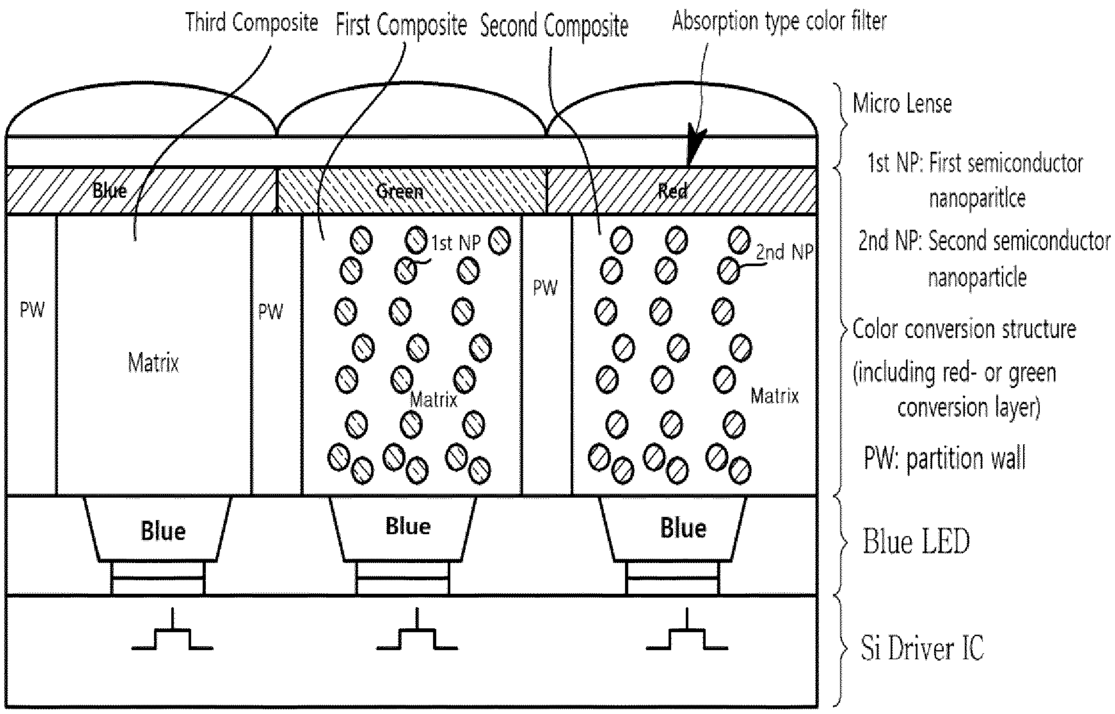
Third Composite
First Composite
Second Composite
Absorption type color filter
Micro Lense
Blue
Green
Red
1st NP
2nd NP
PW
PW
PW
Matrix
Matrix
Matrix
1st NP: First semiconductor nanoparitlce
2nd NP: Second semiconductor nanoparticle
Color conversion structure (including red- or green conversion layer)
PW: partition wall
Blue
Blue
Blue
Blue LED
Si Driver IC

FIG. 2

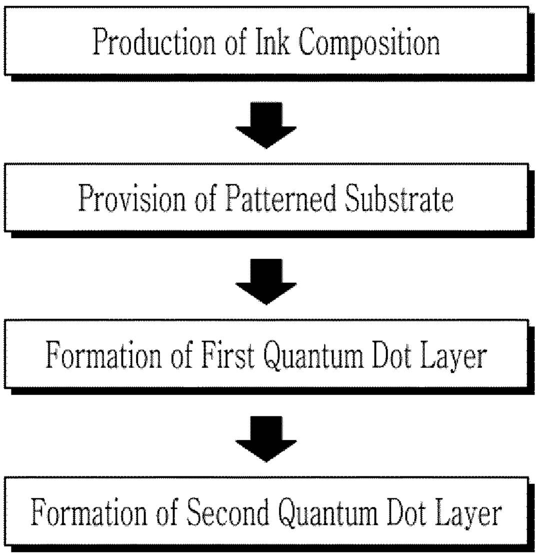
Production of Ink Composition
Provision of Patterned Substrate
Formation of First Quantum Dot Layer
Formation of Second Quantum Dot Layer

FIG. 3A

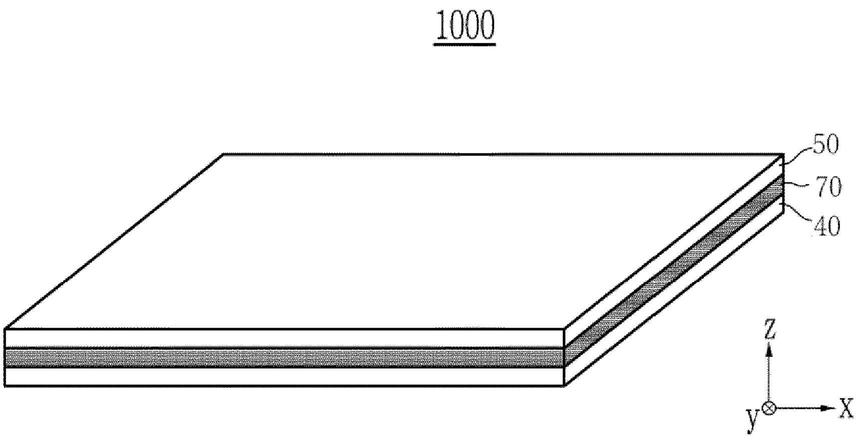

FIG. 3B

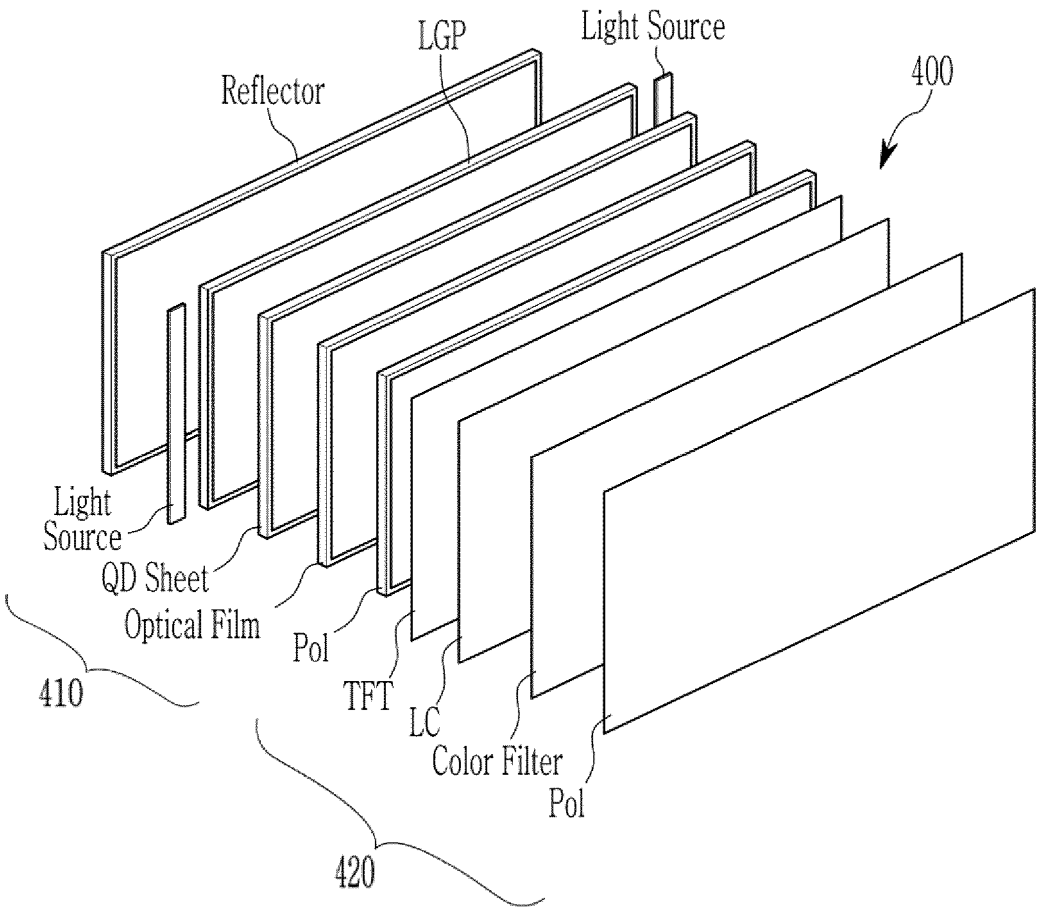
LGP
Light Source
Reflector
400
Light
Source
QD Sheet
Optical Film
Pol
410
TFT
LC
Color Filter
Pol
420

FIG. 4

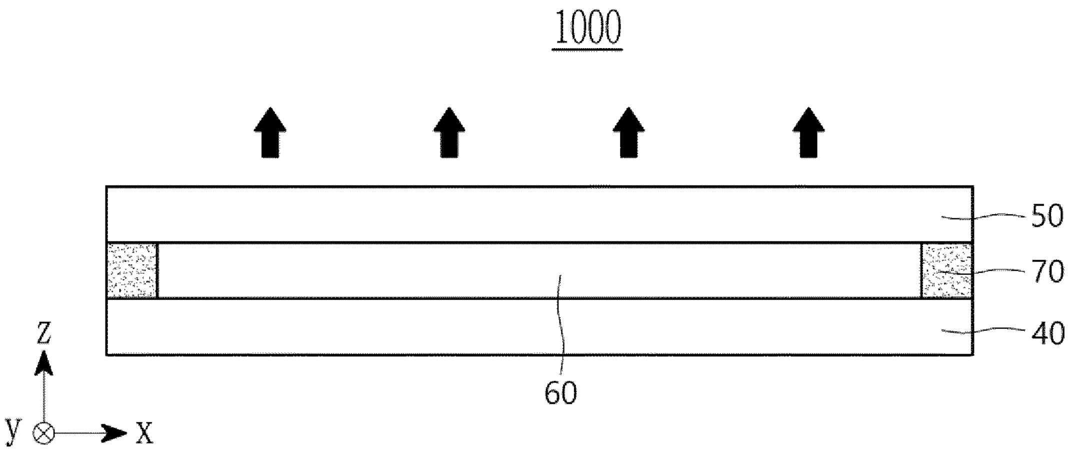


FIG. 5A

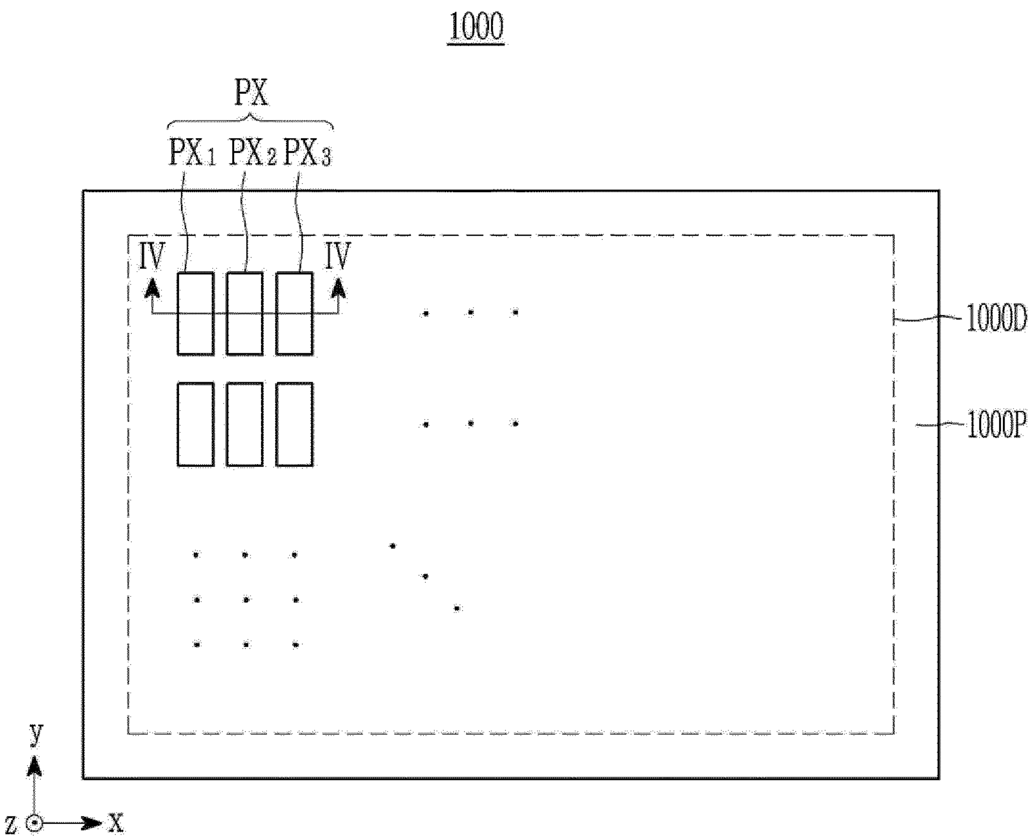

FIG. 5B

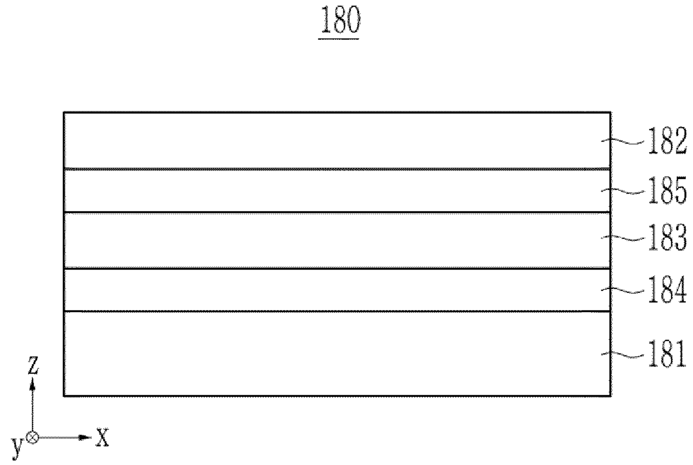
180
182
185
183
184
181
z
y
x

FIG. 5C

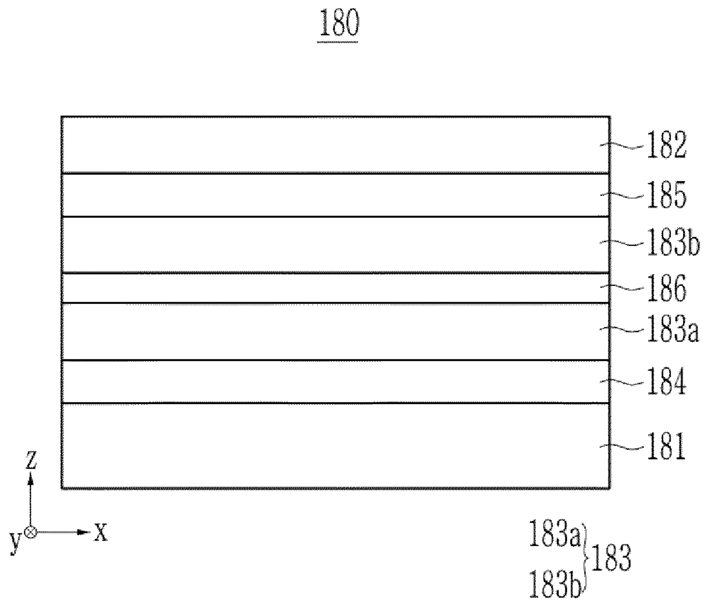
180
182
185
183b
186
183a
184
181
z
y
x
183a
183b
183

FIG. 5D

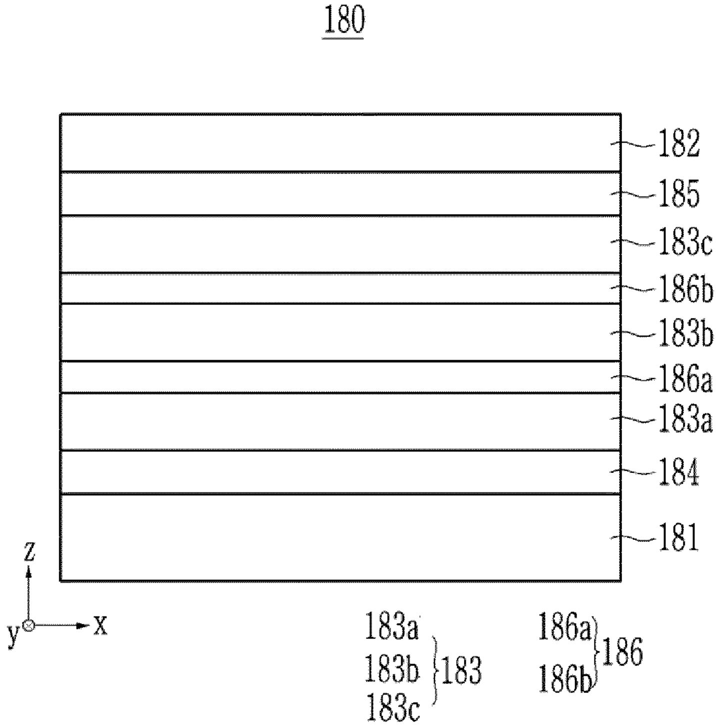
180
182
185
183c
186b
183b
186a
183a
184
181
z
y
x
183a
183b
183c
183
186a
186b
186

FIG. 5E

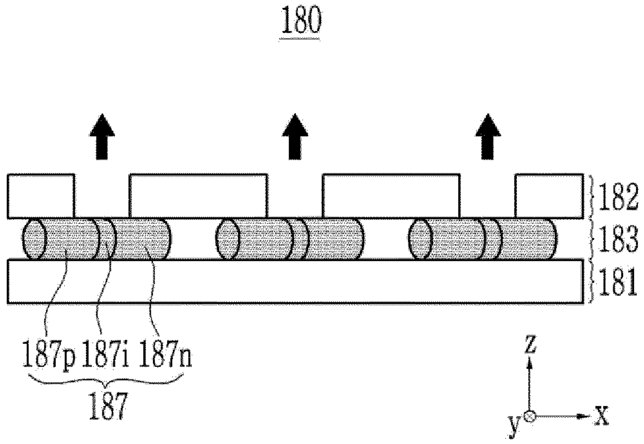
180
182
183
181
187p
187i
187n
187
z
y
x

FIG. 6

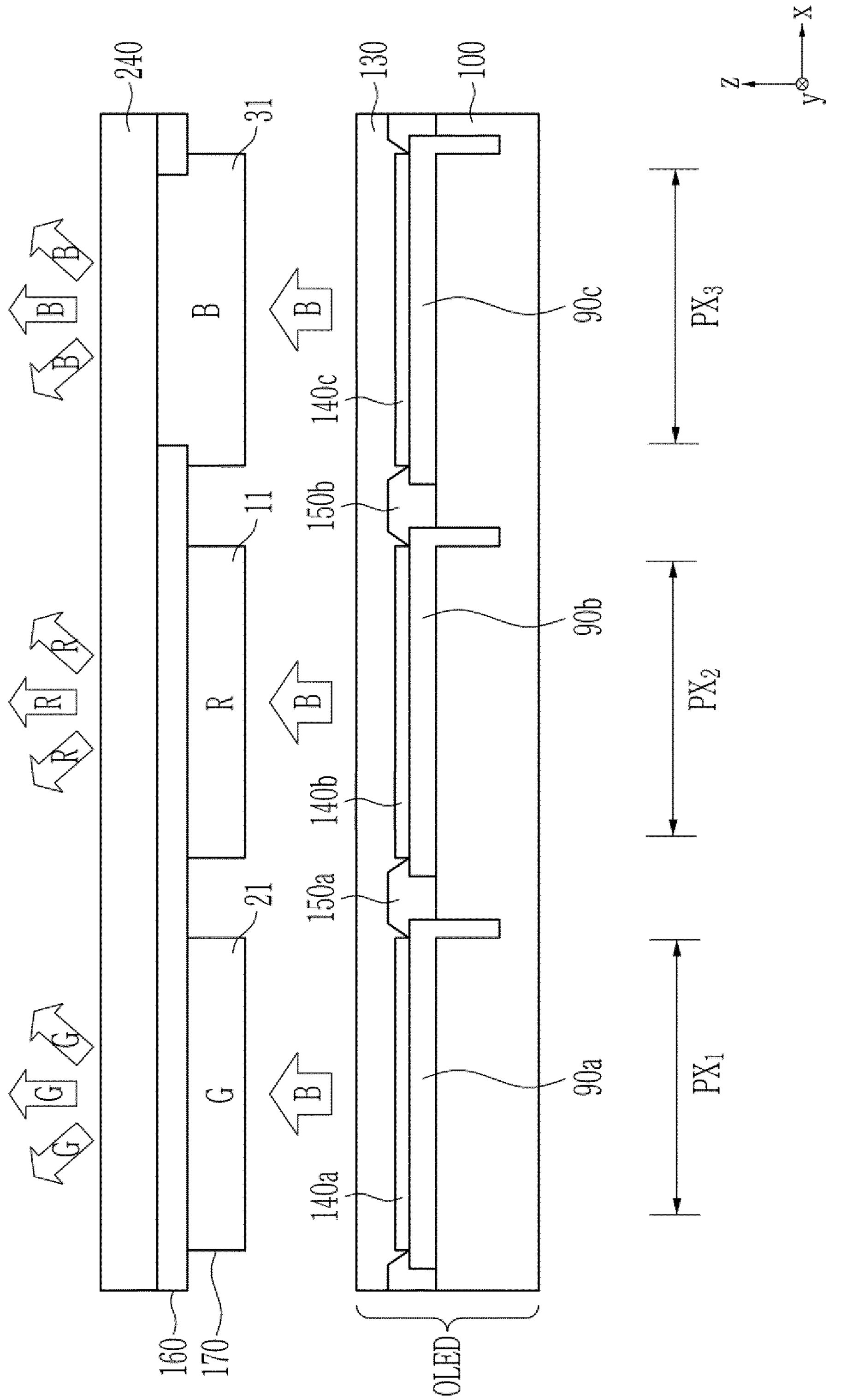
240
31
B
11
R
21
G
160
170
130
100
140a
140b
140c
150a
150b
90a
90b
90c
OLED
PX1
PX2
PX3
z
x
y

FIG. 7

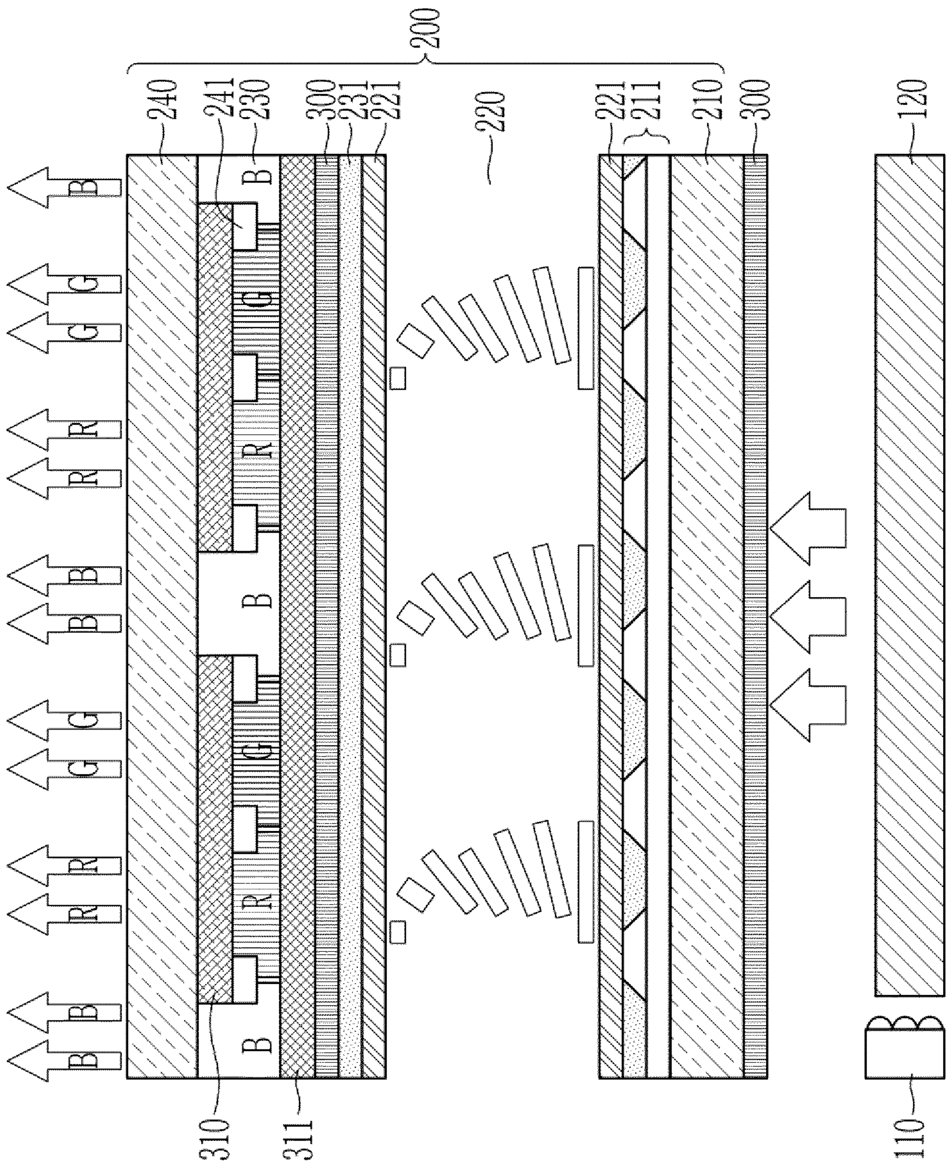
200
240
241
230
300
231
221
220
221
211
210
300
120
310
311
110
B
G
R

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **M. SHIRAISHI et al.** Transparent Nanocomposites Comprising Ligand-Exchanged CuInS2/ZnS Quantum Dots and UV-Cured Resin for Wavelength Converters. *ACS Omega*, 2022, vol. 7, 33039-33045
- *CHEMICAL ABSTRACTS*, 947-19-3
- *CHEMICAL ABSTRACTS*, 75980-60-8
- *CHEMICAL ABSTRACTS*, 24615-84-7
- *CHEMICAL ABSTRACTS*, 2935-90-2